# EUROPEAN PATENT APPLICATION

(11) **EP 3 940 013 A1**
(43) Date of publication of application: **19.01.2022**
(21) Application number: 20771012.0
(22) Date of filing: 11.03.2020
(51) Int. Cl.: C08G 61/10, C01B 32/182, C07F 7/08

(54) **GRAPHENE NANORIBBON AND METHOD FOR PRODUCING SAME**

(30) Priority: 12.03.2019 JP 2019044939; 24.06.2019 JP 2019116663; 19.07.2019 JP 2019134072; 24.09.2019 JP 2019173565
(71) Applicant: Taoka Chemical Co., Ltd., Yodogawa-ku Osaka-shi Osaka 532-0006 (JP)
(72) Inventor: ITAMI, Kenichiro, Nagoya-shi, Aichi 464-8601 (JP); ITO, Hideto, Nagoya-shi, Aichi 464-8601 (JP); YANO, Yuuta, Nagoya-shi, Aichi 464-8601 (JP); MATSUSHIMA, Kaho, Nagoya-shi, Aichi 464-8601 (JP); NAKATSUJI, Hidefumi, Osaka-shi, Osaka 532-0006 (JP)
(74) Representative: Gevers & Orès
(86) International application number: PCT/JP2020/010608
(87) International publication number: WO 2020/184625

(57) **Abstract**

The present invention can provide a graphene nanoribbon by a method containing fewer steps and involving reduced side reactions. The graphene nanoribbon has at least one structural unit represented by the formula: 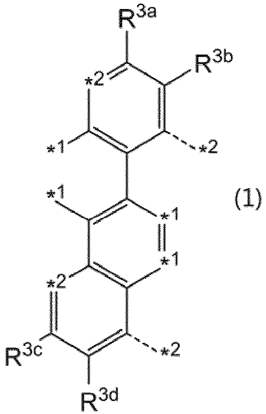 wherein the dotted lines are the same or different and each represents no bond or a single bond; *1 represents a bonding point; *2 represents a bonding point when the dotted line bonded to *2 is a single bond; R^{3a}, R^{3b}, R^{3c}, and R^{3d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and at least one pair of R^{3a} and R^{3b}, and R^{3c} and R^{3d}, are optionally bonded together to form a ring.

## Description

### Technical Field

The present invention relates to a graphene nanoribbon and a method for producing the graphene nanoribbon.

### Background Art

Graphene nanoribbons (GNRs) show promise in application to semiconductors, solar batteries, transparent electrodes, highspeed transistors, organic EL devices, and like devices due to their high hole mobility, semiconducting properties, transparency, mechanical strength, and flexibility.

GNR synthesis methods are broadly divided into two methods: a top-down method and a bottom-up method. In particular, the bottom-up method is attractive in its ability to synthesize a large amount of GNRs with precise control of edge structure and width. However, poor solubility of short GNRs hampers the use of the method of synthesizing short GNRs and then using them as intermediates for further reactions. Thus, there is demand for a method for synthesizing long GNRs by causing a polymerization reaction from a highly soluble substrate compound in fewer steps.

Typically, nanographenes are synthesized by taking advantage of a coupling reaction and Diels-Alder reaction of aromatic ring components, and then finally forming graphene through dehydrogenation cyclization (see, for example, NPL 1). The same method has been used in synthesizing GNRs.

Recently known methods include a method by reacting a polycyclic aromatic compound having a K region and a silole skeleton in the presence of a palladium compound and o-chloranil and a method by reacting a polycyclic aromatic compound having a K region with a polycyclic aromatic compound having a silole skeleton (see, for example, PTL 1).

### Citation List

### Patent Literature

PTL1: WO2017/131190A

### Non-Patent Literature

NPL 1: Nat. Chem. 2014, 6, 126

### Summary of Invention

### Technical Problem

However, the method of NPL 1 is not necessarily a highly versatile method because of the low yield due to its multi-step reaction and the occurrence of side reactions.

Thus, an object of the present invention is to provide GNRs by a method containing fewer steps and involving reduced side reactions.

### Solution to Problem

The present inventors conducted extensive research to achieve the object, and found that GNRs with a specific structure can be synthesized by a method with fewer steps and reduced side reactions in which a specific initiator is reacted with a specific silole compound in the presence of a palladium compound and o-chloranil, optionally with a silver compound. Additionally, GNR block copolymers, which have been conventionally difficult to synthesize, can be synthesized by repeating this reaction multiple times. GNRs with a smaller polydispersity (PDI) can also be synthesized by suitably selecting an initiator while controlling the width and length. The inventors conducted further research based on these findings and completed the present invention. Specifically, the present invention encompasses the following subject matter.

Item 1. A graphene nanoribbon having at least one structural unit represented by formula (1):

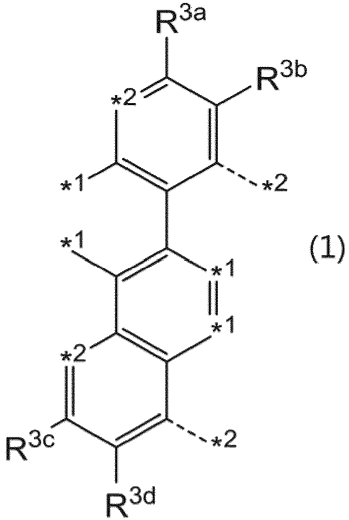

wherein the dotted lines are the same or different and each represents no bond or a single bond; *1 represents a bonding point; *2 represents a bonding point when the dotted line bonded to *2 is a single bond; R^{3a}, R^{3b}, R^{3c}, and R^{3d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{3a} and R^{3b} and/or R^{3c} and R^{3d} are optionally bonded together to form a ring.

Item 2. The graphene nanoribbon according to Item 1, having at least one structural unit represented by formula (3):

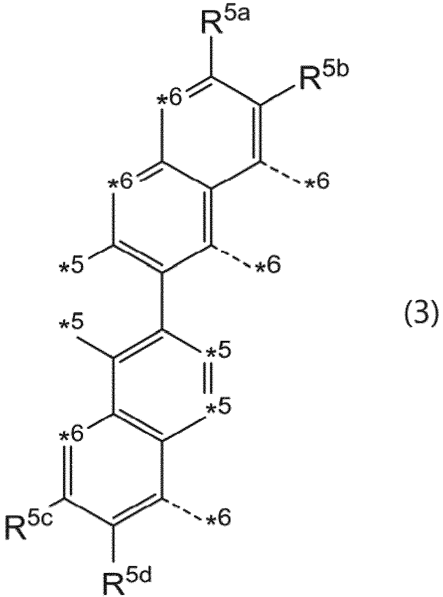

wherein the dotted lines are the same or different and each represents no bond or a single bond; *5 represents a bonding point; *6 represents a bonding point when the dotted line bonded to *6 is a single bond; R^{5a}, R^{5b}, R^{5c}, and R^{5d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{5a} and R^{5b} and/or R^{5c} and R^{5d} are optionally bonded together to form a ring.

Item 3. The graphene nanoribbon according to Item 1 or 2, further having at least one structural unit represented by formula (2):

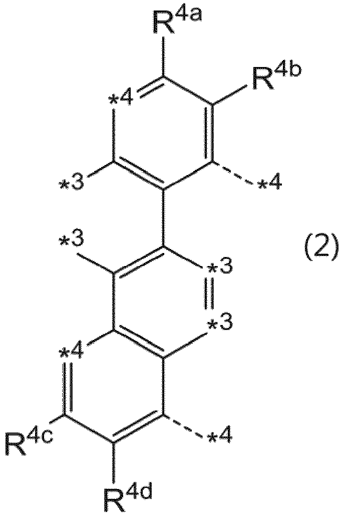

wherein the dotted lines are the same or different and each represents no bond or a single bond; *3 represents a bonding point; *4 represents a bonding point when the dotted line bonded to *4 is a single bond; R^{4a}, R^{4b}, R^{4c}, and R^{4d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{4a} and R^{4b} and/or R^{4c} and R^{4d} are optionally bonded together to form a ring; provided that R^{4a} and R^{3a} are not the same, R^{4b} and R^{3b} are not the same, R^{4c} and R^{3c} are not the same, and R^{4d} and R^{3d} are not the same.

Item 4. The graphene nanoribbon according to any one of Items 1 to 3, further having at least one of the following structural units:
a structural unit represented by formula (11):

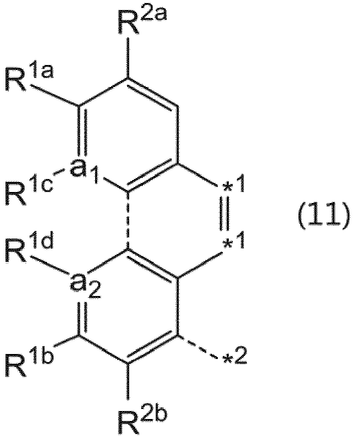

   wherein the dotted lines are as defined above; *1 represents a bonding point; *2 represents a bonding point when the dotted line bonded to *2 is a single bond; R^{1a}, R^{1b}, R^{1c}, R^{1d}, R^{2a}, and R^{2b} are the same or different and each represents a hydrogen atom, a halogen atom, an alkyl group, a cycloalkyl group, a (poly)ether group, an ester group, a boronic acid or an ester group thereof, a monovalent aromatic hydrocarbon group, or a monovalent heterocyclic group; a₁ and a₂ are the same or different and each represents a carbon atom or a nitrogen atom; and R^{1c} and R^{1d} are optionally bonded together to form a ring;
a structural unit represented by formula (12): 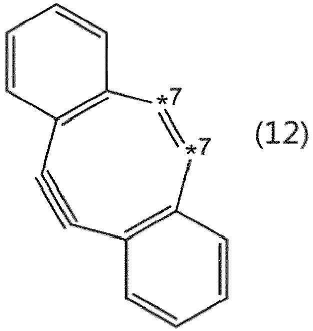 wherein *7 represents a bonding point; and
a structural unit represented by formula (13):

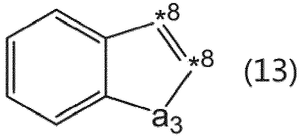

   wherein *8 represents a bonding point, and a₃ represents an oxygen atom or a sulfur atom.

Item 5. The graphene nanoribbon according to Item 4, which is represented by formula (4):

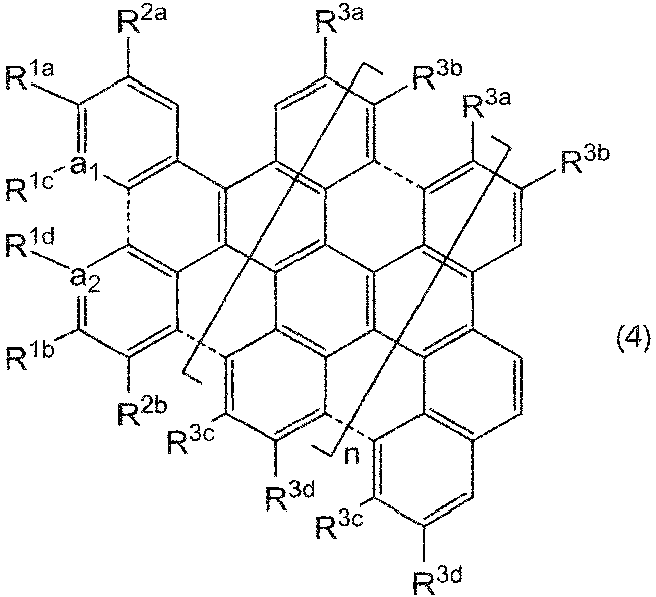

wherein the dotted lines, R^{1a}, R^{1b}, R^{1c}, R^{1d}, R^{2a}, R^{2b}, R^{3a}, R^{3b}, R^{3c}, R^{3d}, a₁, and a₂ are as defined above; R^{3a} and R^{3b} bonded to the same benzene ring are optionally bonded together to form a ring; R^{3c} and R^{3d} bonded to the same benzene ring are optionally bonded together to form a ring; and n represents an integer of 0 or more;
formula (14):

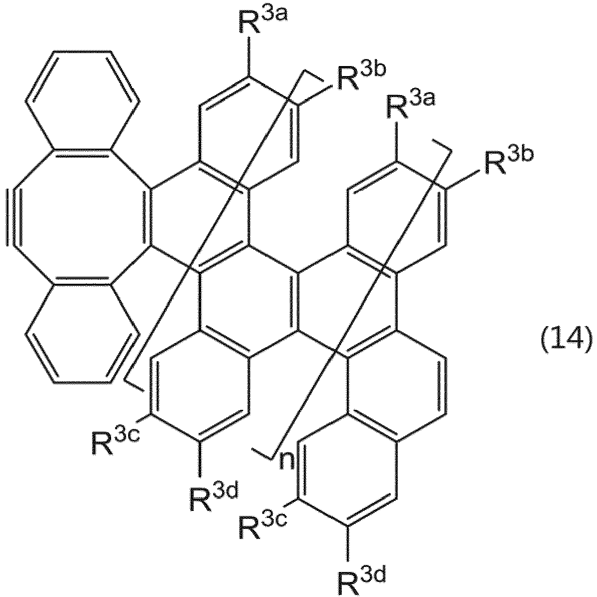

wherein R^{3a}, R^{3b}, R^{3c}, R^{3d}, and n are as defined above; R^{3a} and R^{3b} bonded to the same benzene ring are optionally bonded together to form a ring; and R^{3c} and R^{3d} bonded to the same benzene ring are optionally bonded together to form a ring; or
formula (15):

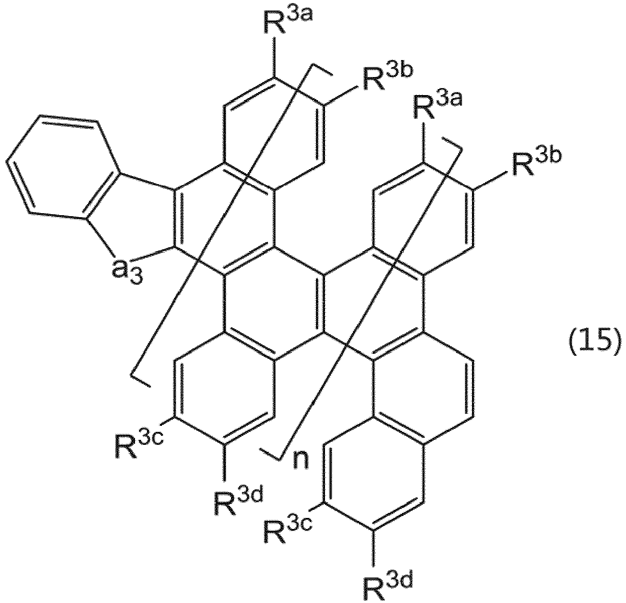

wherein R^{3a}, R^{3b}, R^{3c}, R^{3d}, n, and a₃ are as defined above; R^{3a} and R^{3b} bonded to the same benzene ring are optionally bonded together to form a ring; and R^{3c} and R^{3d} bonded to the same benzene ring are optionally bonded together to form a ring.

Item 6. The graphene nanoribbon according to Item 4 or 5, which is represented by formula (4A):

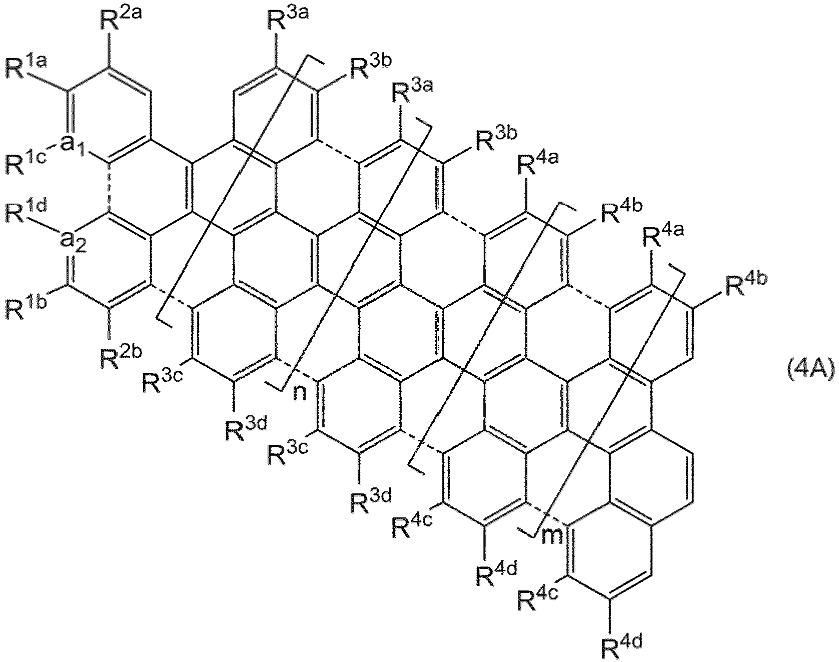

wherein the dotted lines, R^{1a}, R^{1b}, R^{1c}, R^{1d}, R^{2a}, R^{2b}, R^{3a}, R^{3b}, R^{3c}, R^{3d}, a₁ and a₂ are as defined above; R^{4a}, R^{4b}, R^{4c}, and R^{4d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; R^{3a} and R^{3b} bonded to the same benzene ring are optionally bonded together to form a ring; R^{3c} and R^{3d} bonded to the same benzene ring are optionally bonded together to form a ring; R^{4a} and R^{4b} bonded to the same benzene ring are optionally bonded together to form a ring; R^{4c} and R^{4d} bonded to the same benzene ring are optionally bonded together to form a ring; provided that R^{4a} and R^{3a} are not the same, R^{4b} and R^{3b} are not the same, R^{4c} and R^{3c} are not the same, and R^{4d} and R^{3d} are not the same; and n and m are the same or different and each represents an integer of 0 or more;
formula (14A):

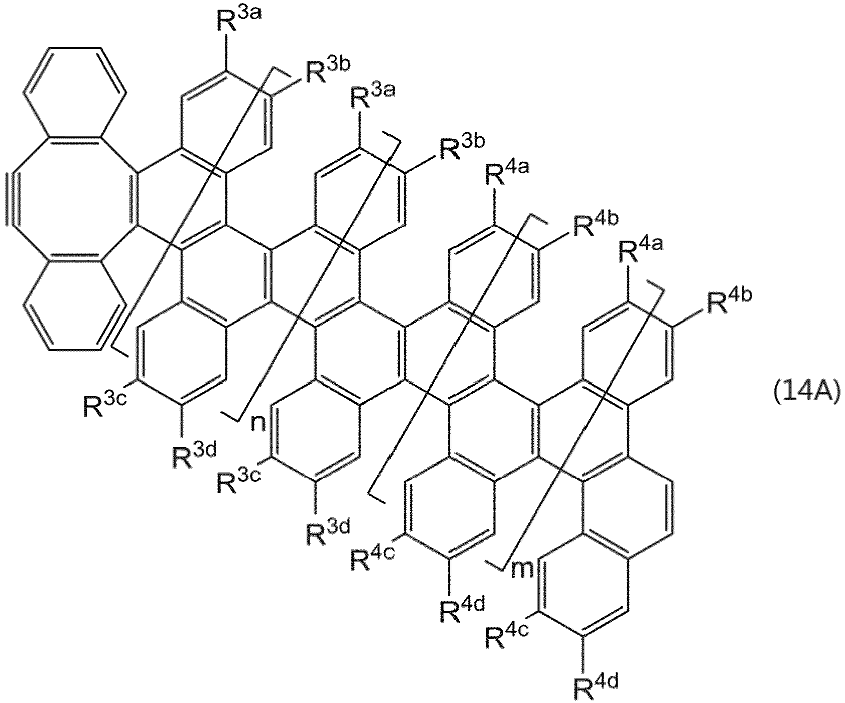

wherein R^{3a}, R^{3b}, R^{3c}, R^{3d}, R^{4a}, R^{4b}, R^{4c}, R^{4d}, n, and m are as defined above; R^{3a} and R^{3b} bonded to the same benzene ring are optionally bonded together to form a ring; R^{3c} and R^{3d} bonded to the same benzene ring are optionally bonded together to form a ring; R^{4a} and R^{4b} bonded to the same benzene ring are optionally bonded together to form a ring; and R^{4c} and R^{4d} bonded to the same benzene ring are optionally bonded together to form a ring; or
formula (15A):

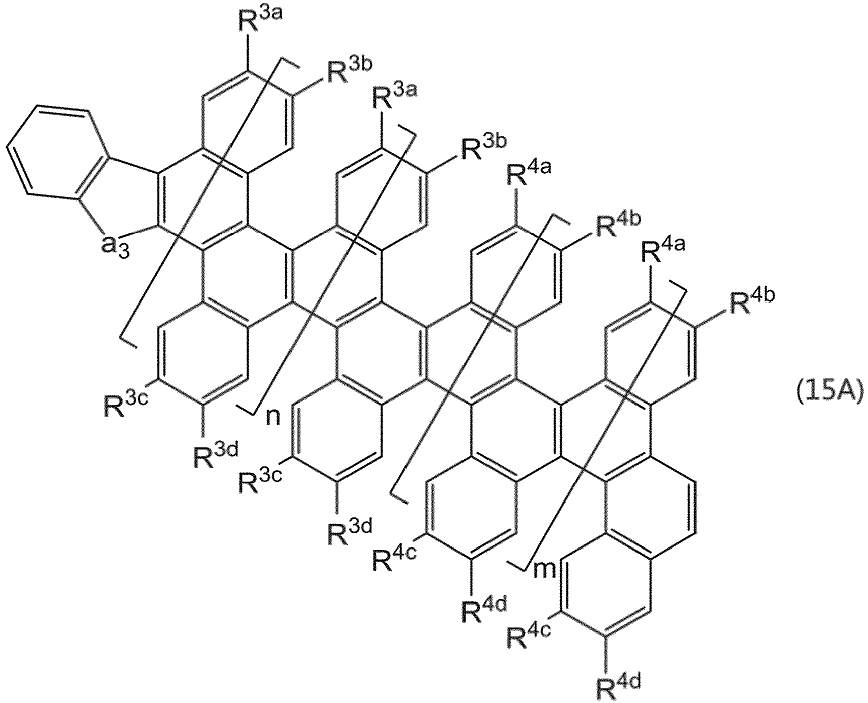

wherein R^{3a}, R^{3b}, R^{3c}, R^{3d}, R^{4a}, R^{4b}, R^{4c}, R^{4d}, n, m, and a₃ are as defined above; R^{3a} and R^{3b} bonded to the same benzene ring are optionally bonded together to form a ring; R^{3c} and R^{3d} bonded to the same benzene ring are optionally bonded together to form a ring; R^{4a} and R^{4b} bonded to the same benzene ring are optionally bonded together to form a ring; and R^{4c} and R^{4d} bonded to the same benzene ring are optionally bonded together to form a ring.

Item 7. The graphene nanoribbon according to any one of Items 4 to 6, which is represented by formula (4A1):

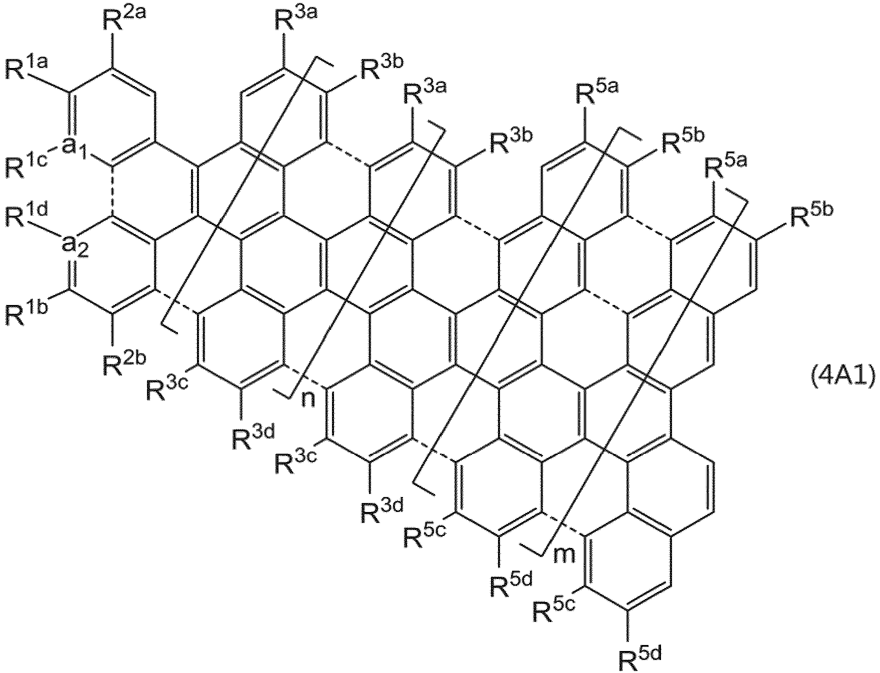

wherein the dotted lines, R^{1a}, R^{1b}, R^{1c}, R^{1d}, R^{2a}, R^{2b}, R^{3a}, R^{3b}, R^{3c}, R^{3d}, a₁ and a₂ are as defined above; R^{5a}, R^{5b}, R^{5c}, and R^{5d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; R^{3a} and R^{3b} bonded to the same benzene ring are optionally bonded together to form a ring; R^{3c} and R^{3d} bonded to the same benzene ring are optionally bonded together to form a ring; R^{5a} and R^{5b} bonded to the same benzene ring are optionally bonded together to form a ring; R^{5c} and R^{5d} bonded to the same benzene ring are optionally bonded together to form a ring; and n and m are the same or different and each represents an integer of 0 or more;
formula (14A1):

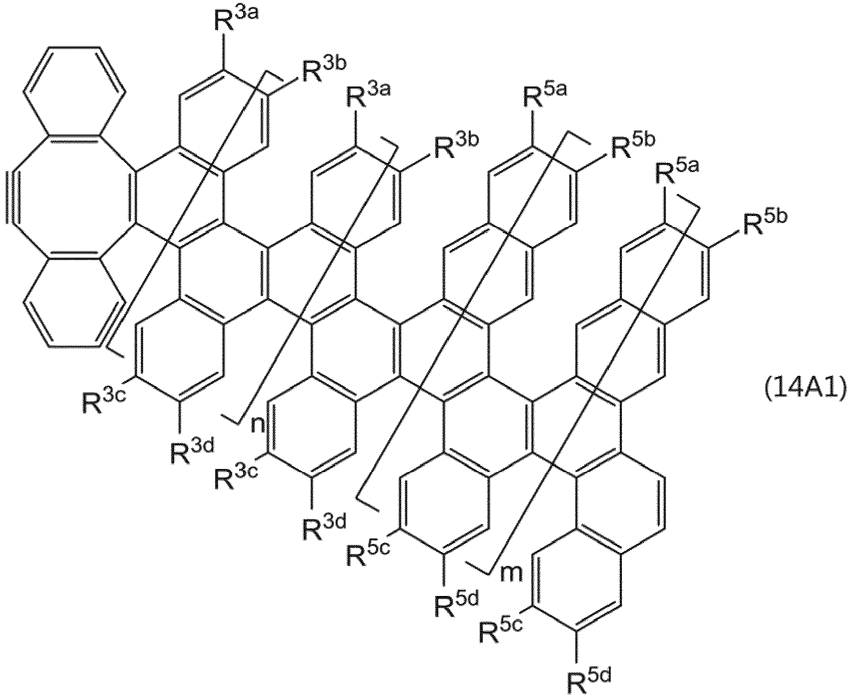

wherein R^{3a}, R^{3b}, R^{3c}, R^{3d}, R^{5a}, R^{5b}, R^{5c}, R^{5d}, n, and m are as defined above; R^{3a} and R^{3b} bonded to the same benzene ring are optionally bonded together to form a ring; R^{3c} and R^{3d} bonded to the same benzene ring are optionally bonded together to form a ring; R^{5a} and R^{5b} bonded to the same benzene ring are optionally bonded together to form a ring; and R^{5c} and R^{5d} bonded to the same benzene ring are optionally bonded together to form a ring; or
formula (15A1):

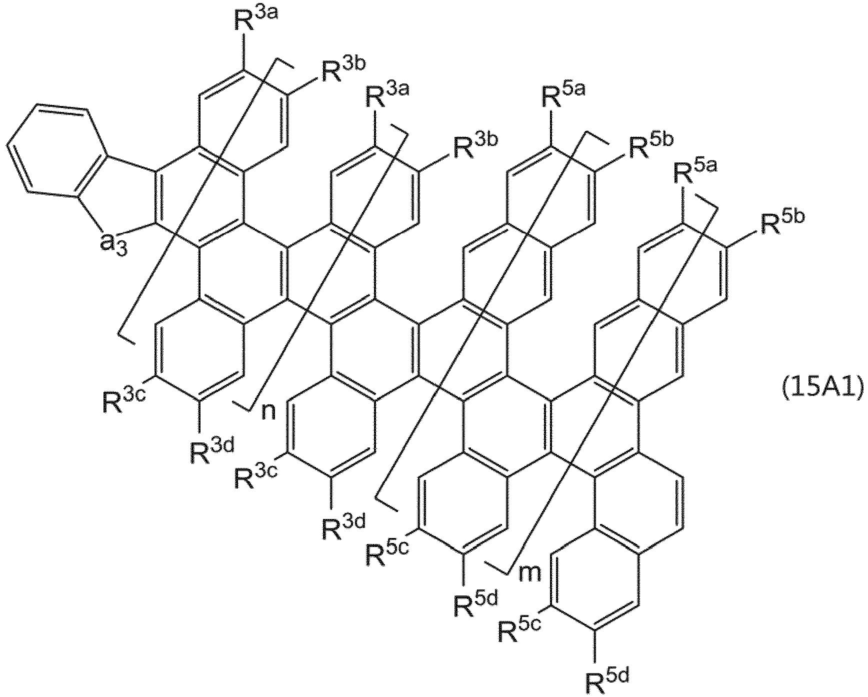

wherein R^{3a}, R^{3b}, R^{3c}, R^{3d}, R^{5a}, R^{5b}, R^{5c}, R^{5d}, n, m, and a₃ are as defined above; R^{3a} and R^{3b} bonded to the same benzene ring are optionally bonded together to form a ring; R^{3c} and R^{3d} bonded to the same benzene ring are optionally bonded together to form a ring; R^{5a} and R^{5b} bonded to the same benzene ring are optionally bonded together to form a ring; and R^{5c} and R^{5d} bonded to the same benzene ring are optionally bonded together to form a ring.

Item 8. The graphene nanoribbon according to any one of Items 1 to 7, which has a number average molecular weight of 10000 or more.

Item 9. The graphene nanoribbon according to any one of Items 1 to 8, which has a polydispersity PDI of 1.00 to 1.40.

Item 10. The graphene nanoribbon according to any one of Items 1 to 9, which has a width of 0.1 to 2.0 nm and a length of 10 nm or more.

Item 11. A method for producing the graphene nanoribbon according to any one of Items 1 to 10, the method comprising:
(1) a first polymerization step of reacting, in the presence of a palladium compound and o-chloranil, an alkyne compound represented by formula (5A):

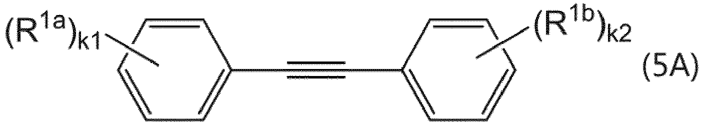

wherein R^{1a} and R^{1b} are the same or different and each represents a hydrogen atom, a halogen atom, an alkyl group, a cycloalkyl group, a (poly)ether group, an ester group, a boronic acid or an ester group thereof, a monovalent aromatic hydrocarbon group, or a monovalent heterocyclic group; k1 and k2 are the same or different and each represents an integer of 1 to 3; when k1 and k2 are an integer of 2 or more, each R^{1a} and/or R^{1b} is optionally the same or different;
a K region-containing aromatic compound represented by formula (5B) :

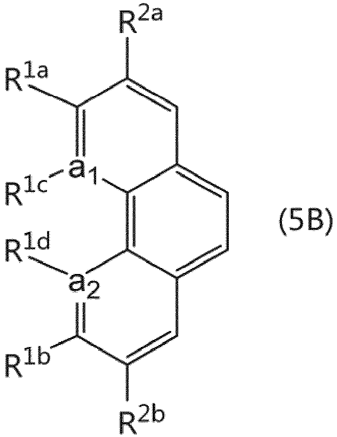

wherein R^{1a}, R^{1b}, R^{1c}, R^{1d}, R^{2a}, and R^{2b} are the same or different and each represents a hydrogen atom, a halogen atom, an alkyl group, a cycloalkyl group, a (poly)ether group, an ester group, a boronic acid or an ester group thereof, a monovalent aromatic hydrocarbon group, or a monovalent heterocyclic group; and a₁ and a₂ are the same or different and each represents a carbon atom or a nitrogen atom;
dibenzocyclooctadiyne, benzothiophene, or benzofuran, and a silole compound represented by formula (6):

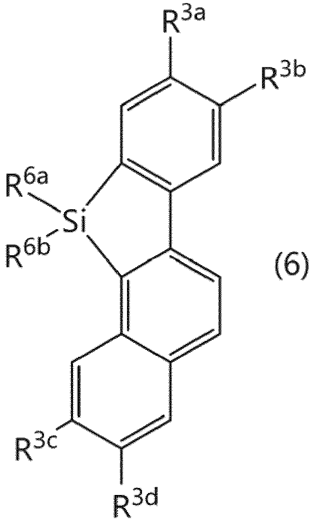

wherein R^{3a}, R^{3b}, R^{3c}, and R^{3d} are as defined above; and R^{6a} and R^{6b} are the same or different and each represents a hydrogen atom or an alkyl group.

Item 12. The production method according to Item 11, further comprising, after the first polymerization step:
(2) a second polymerization step of reacting, in the presence of a palladium compound and o-chloranil, a K region-containing polymer obtained in step (1) and a silole compound represented by formula (7):

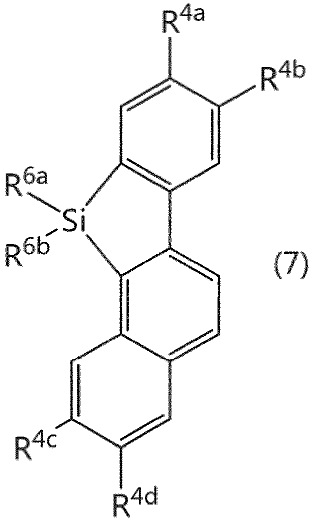

wherein R^{6a} and R^{6b} are as defined above; R^{4a}, R^{4b}, R^{4c}, and R^{4d} are the same or different and each represents a hydrogen atom, a halogen atom, an alkyl group, a cycloalkyl group, a (poly)ether group, an ester group, a monovalent aromatic hydrocarbon group,
or a monovalent heterocyclic group; and R^{4a} and R^{4b} and/or R^{4c} and R^{4d} are optionally bonded together to form a ring; provided that R^{4a} and R^{3a} are not the same, R^{4b} and R^{3b} are not the same, R^{4c} and R^{3c} are not the same, and R^{4d} and R^{3d} are not the same.

Item 13. The production method according to Item 12, wherein the silole compound represented by formula (7) is a silole compound represented by formula (7A):

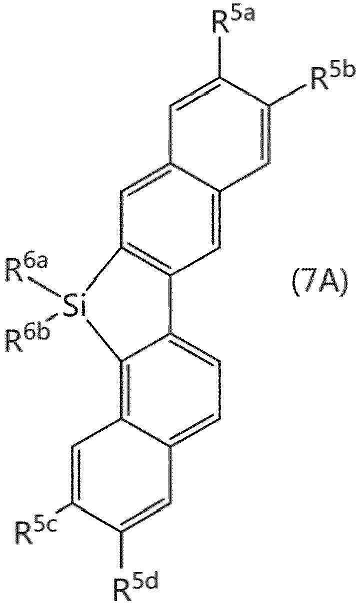

wherein R^{6a} and R^{6b} are as defined above; R^{5a}, R^{5b}, R^{5c}, and R^{5d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{5a} and R^{5b} and/or R^{5c} and R^{5d} are optionally bonded together to form a ring.

Item 14. The production method according to any one of Items 11 to 13, wherein the compound to be reacted with the silole compound is used in an amount of 0.0005 to 0.5 mol per mol of the silole compound.

Item 15. The production method according to any one of Items 11 to 14, wherein the first polymerization step or the second polymerization step is performed in the presence of a silver compound.

Item 16. The production method according to Item 15, wherein the silver compound contains AgSbF₆ or AgBF₄.

Item 17. The production method according to Item 15 or 16, wherein the silver compound is used in an amount of 0.5 to 5.0 mol per mol of the silole compound.

Item 18. The production method according to any one of Items 11 to 17, wherein the palladium compound is used in an amount of 0.1 to 3.0 mol per mol of the silole compound.

Item 19. A silole compound represented by formula (6):

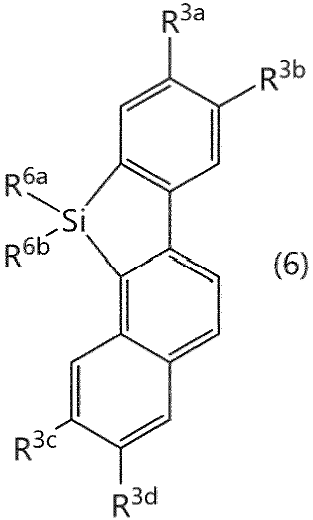

wherein R^{3a}, R^{3b}, R^{3c}, and R^{3d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; provided that not a₁₁ of R^{3a}, R^{3b}, R^{3c}, and R^{3d} are hydrogen atoms; R^{3a} and R^{3b} and/or R^{3c} and R^{3d} are optionally bonded together to form a ring; and R^{6a} and R^{6b} are the same or different and each represents a hydrogen atom or an alkyl group.

Item 20. A method for producing the silole compound according to Item 19, the method comprising reacting a halogen-containing silole compound represented by formula (8):

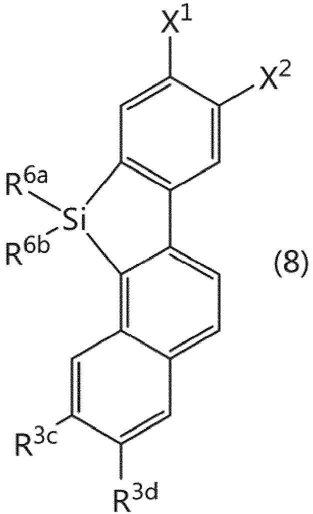

wherein R^{3c}, R^{3d}, R^{6a}, and R^{6b} are as defined above; X¹ and X² are the same or different and each represents a hydrogen atom or a halogen atom; and X¹ and X² are optionally bonded together to form a ring containing a halogen atom; provided that not both of X¹ and X² are hydrogen atoms; and
a Grignard reagent represented by formula (9):

R⁷MgX³ (9)

wherein R⁷ represents an alkyl group, and X³ represents a halogen atom; or
a boronic acid compound represented by formula (10):

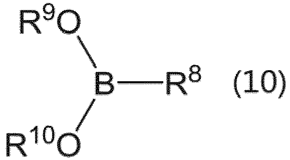

wherein R⁸ represents a monovalent aromatic hydrocarbon group; R⁹ and R¹⁰ are the same or different and each represents a hydrogen atom or an alkyl group; and R⁹ and R¹⁰ are optionally bonded together to form a ring together with the adjacent -O-B-O-.

Item 21. A halogen-containing silole compound represented by formula (8):

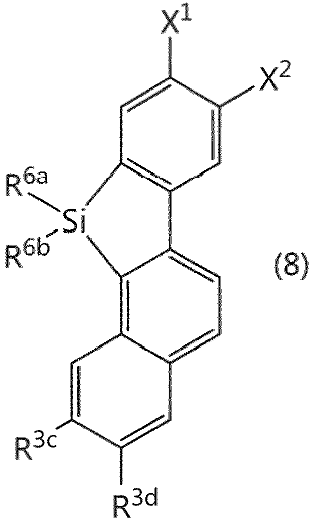

wherein R^{3c} and R^{3d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; R^{3c} and R^{3d} are optionally bonded together to form a ring; R^{6a} and R^{6b} are the same or different and each represents a hydrogen atom or an alkyl group; X¹ and X² are the same or different and each represents a hydrogen atom or a halogen atom; and X¹ and X² are optionally bonded to form a ring containing a halogen atom; provided that not both of X¹ and X² are hydrogen atoms.

Item 22. A method for producing an armchair graphene nanoribbon having at least one structural unit represented by formula (1-1):

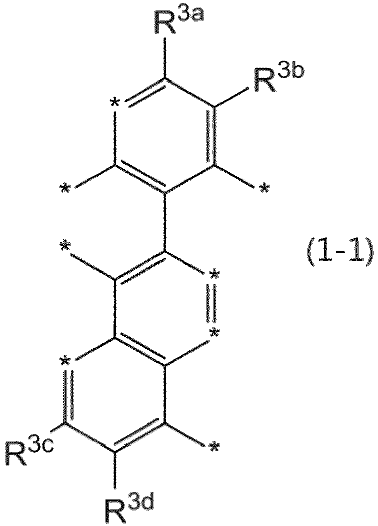

wherein * represents a bonding point; R^{3a}, R^{3b}, R^{3c}, and R^{3d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{3a} and R^{3b} and/or R^{3c} and R^{3d} are optionally bonded together to form a ring;
the method comprising performing a ring condensation reaction, in the presence of an iron compound, on a fjord graphene nanoribbon having at least one structural unit represented by formula (1-2):

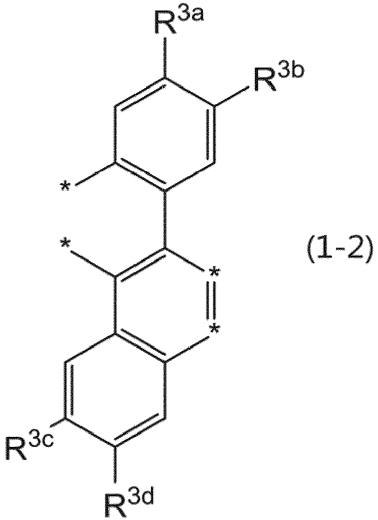

wherein * represents a bonding point, and R^{3a}, R^{3b}, R^{3c}, and R^{3d} are as defined above.

Item 23. A method for producing an armchair graphene nanoribbon represented by formula (4-1):

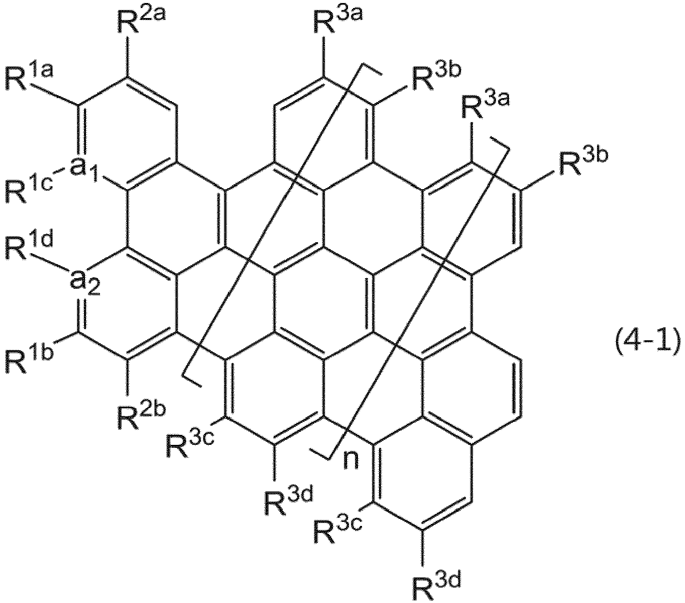

wherein R^{1a}, R^{1b}, R^{1c}, R^{1d}, R^{2a}, and R^{2b} are the same or different and each represents a hydrogen atom, a halogen atom, an alkyl group, a cycloalkyl group, a (poly)ether group, an ester group, a boronic acid or an ester group thereof, a monovalent aromatic hydrocarbon group, or a monovalent heterocyclic group; a₁ and a₂ are the same or different and each represents a carbon atom or a nitrogen atom; R^{1c} and R^{1d} are optionally bonded together to form a ring; R^{3a}, R^{3b}, R^{3c}, and R^{3d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; R^{3a} and R^{3b} bonded to the same benzene ring are optionally bonded together to form a ring; R^{3c} and R^{3d} bonded to the same benzene ring are optionally bonded together to form a ring; and n represents an integer of 0 or more;
the method comprising performing a ring condensation reaction, in the presence of an iron compound, on a fjord graphene nanoribbon represented by formula (4-2):

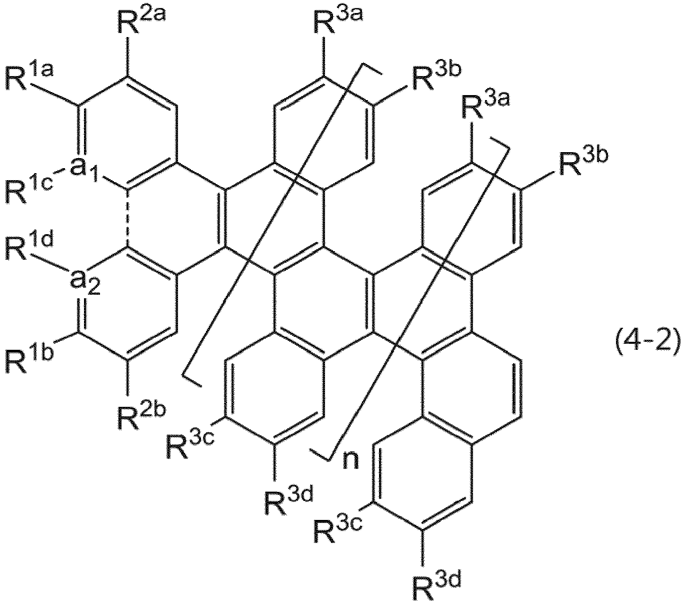

wherein the dotted lines are the same or different and each represents no bond or a single bond; R^{1a}, R^{1b}, R^{1c}, R^{1d}, R^{2a}, R^{2b}, R^{3a}, R^{3b}, R^{3c}, R^{3d}, a₁ a₂, and n are as defined above; R^{3a} and R^{3b} bonded to the same benzene ring are optionally bonded together to form a ring; and R^{3c} and R^{3d} bonded to the same benzene ring are optionally bonded together to form a ring.

### Advantageous Effects of Invention

The present invention provides GNRs by a method with fewer steps and reduced side reactions. The GNRs can be obtained by reacting a specific initiator with a specific silole compound in the presence of a palladium compound and o-chloranil, optionally with a silver compound. GNR block copolymers can also be synthesized by performing this reaction multiple times. Additionally, GNRs with a smaller polydispersity (PDI) can also be synthesized by suitably selecting an initiator while controlling the width and length.

### Brief Description of Drawings

Fig. 1 is an MALDI-TOF mass spectrum of GNR7.
Fig. 2 is an MALDI-TOF mass spectrum of GNR8.

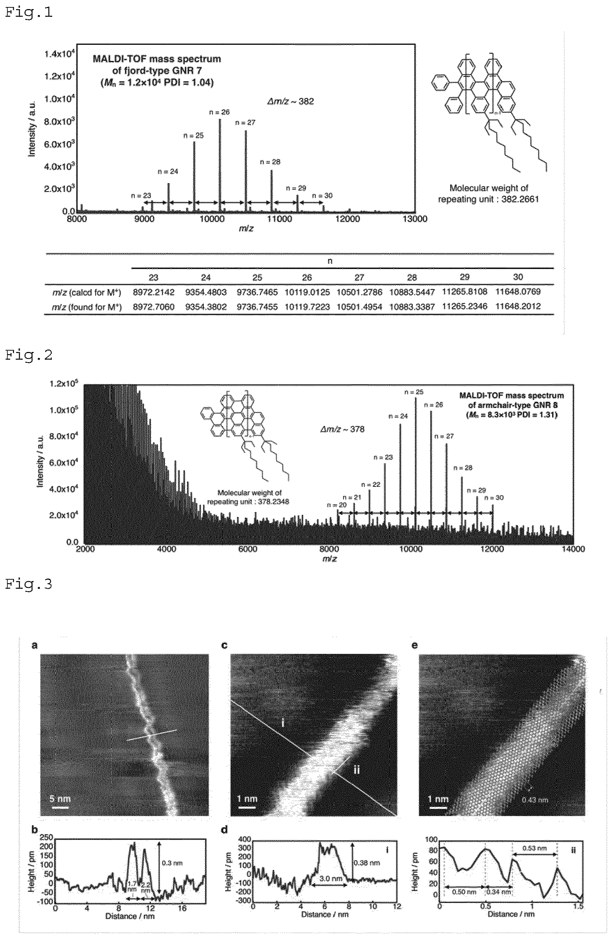

Fig. 3 shows STM images of GNR2 and GNR8. Fig. 3a shows an STM image of fjord GNR2 deposited on HOPG (Mn = 1.5×10⁵, Mw/Mn = 1.22) (voltage U = 1.0 V, current I = 50 pA, temperature T = 78 K). Fig. 3b shows a height profile of the cross section taken perpendicular to the wire observed in Fig. 3a. Fig. 3c shows an STM image of armchair GNR8 deposited on HOPG (Mn = 2.4×⁴, Mw/Mn = 1.32) (voltage U = 1.0 V, current I = 250 pA, temperature T = 78 K). Fig. 3d shows a height profile of the cross section taken (i) perpendicular to and (ii) horizontally with respect to the wire observed in Fig. 3c. Fig. 3e shows a dimeric assembly model of GNR8.

### Description of Embodiments

In the present specification, the terms "comprise" and "contain" include the concepts of "comprise," "contain," "consist essentially of," and "consist of." Further, in the present specification, the numerical range represented by "A to B" means A or more and B or less.

### 1. Graphene Nanoribbon

The graphene nanoribbon of the present invention is a polymer having at least one structural unit represented by formula (1):

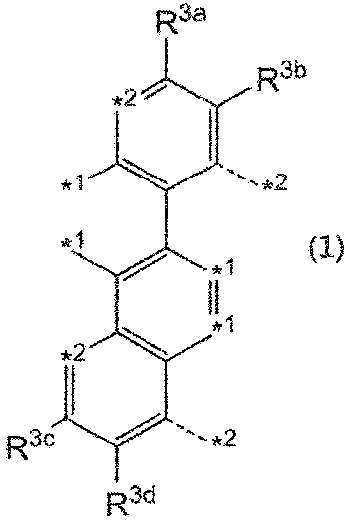

wherein the dotted lines are the same or different and each represents no bond or a single bond; *1 represents a bonding point; *2 represents a bonding point when the dotted line bonded to *2 is a single bond; R^{3a}, R^{3b}, R^{3c}, and R^{3d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{3a} and R^{3b} and/or R^{3c} and R^{3d} are optionally bonded together to form a ring.

In formula (1), examples of the halogen atoms represented by R^{3a}, R^{3b}, R^{3c}, and R^{3d} include fluorine, chlorine, bromine, and iodine atoms.

In formula (1), the alkyl groups represented by R^{3a}, R^{3b}, R^{3c}, and R^{3d} are preferably, for example, linear or branched alkyl groups having 1 to 20 (preferably 1 to 15, and more preferably 1 to 13) carbon atoms. Examples include methyl, ethyl, n-propyl, isopropyl, n-butyl, isobutyl, sec-butyl, tert-butyl, n-pentyl, isopentyl, neopentyl, n-hexyl, isohexyl, 1,1-dimethylbutyl, 2,2-dimethylbutyl, 3,3-dimethylbutyl, n-heptyl, n-octyl, n-nonyl, and n-decyl groups.

When such an alkyl group is substituted, the substituent is not particularly limited, and examples include halogen atoms mentioned above. When the alkyl group is substituted with a substituent, the number of substituents is not particularly limited, and can be, for example, 1 to 3.

In formula (1), the cycloalkyl groups represented by R^{3a}, R^{3b}, R^{3c}, and R^{3d} are preferably, for example, cycloalkyl groups having 3 to 20 (preferably 4 to 15, and more preferably 5 to 13) carbon atoms. Examples include cyclopropyl, cyclobutyl, cyclopentyl, cyclohexyl, cycloheptyl, cyclooctyl, cyclononyl, and cyclodecyl groups.

When such a cycloalkyl group is substituted, the substituent is not particularly limited, and examples include halogen atoms mentioned above and C₁₋₂₀ hydrocarbon groups (e.g., methyl, ethyl, and n-propyl groups). When the cycloalkyl group is substituted with a substituent, the number of substituents is not particularly limited, and can be, for example, 1 to 3.

In formula (1), the (poly)ether groups represented by R^{3a}, R^{3b}, R^{3c}, and R^{3d} refer to ether groups or polyether groups. Examples of ether groups include groups represented by -OR^{11c} (R^{11c} represents an alkyl group mentioned above). R^{11c} is preferably an ether group having a C₁₋₄ alkyl group. Examples of polyether groups include groups represented by - (OR^{11a}) ₖ-OR^{11b} (R^{11a} and R^{11b} are the same or different and each represents an alkyl group, and k represents an integer of 1 to 20). The repeating units OR^{11a} may include the same repeating units, or two or more different repeating units. It is preferable to use a polyether group wherein R^{11a} and R^{11b} are C₁₋₄ alkyl groups.

R^{11a} and R^{11b} are both alkyl groups, and examples include those mentioned above. When they have substituents, the type and number of substituents are also as described above. k is preferably an integer of 1 to 20, more preferably an integer of 1 to 15, and even more preferably an integer of 1 to 5.

Examples of such polyether groups include - (OC₂H₅) ₂OCH₃, - (OC₂H₅) ₃OCH₃, - (OC₂H₅) ₄OCH₃, - (OC₂H₅) ₁₁OCH₃, - (OC₂H₅) ₁₂OCH₃, and - (OC₂H₅) ₁₃OCH₃.

When such a polyether group is used, the water solubility of the resulting graphene nanoribbon can be further improved.

In formula (1), examples of the ester groups represented by R^{3a}, R^{3b}, R^{3c}, and R^{3d} include groups represented by -COOR^{11d} (R^{11d} represents an alkyl group mentioned above). It is preferable to use an ester group wherein R^{11d} is a C₁₋₄ alkyl group.

In formula (1), the monovalent aromatic hydrocarbon groups represented by R^{3a}, R^{3b}, R^{3c}, and R^{3d} are monovalent groups having an aromatic hydrocarbon ring, and are groups formed by desorbing one hydrogen atom bonded to one carbon atom constituting the aromatic hydrocarbon ring. At least one hydrogen atom bonded to the carbon constituting the aromatic hydrocarbon ring may be replaced by a substituent.

Examples of such monovalent aromatic hydrocarbon rings include not only benzene rings, but also a ring obtained by fusing a plurality of benzene rings (fused benzene ring) and a ring obtained by fusing a benzene ring and another aromatic hydrocarbon ring (hereinafter, the ring obtained by fusing a plurality of benzene rings, and the ring obtained by fusing a benzene ring and another ring are also collectively referred to as "fused hydrocarbon rings"). Examples of the fused hydrocarbon rings include pentalene, indene, naphthalene, dihydronaphthalene, anthracene, tetracene, pentacene, pyrene, perylene, triphenylene, azulene, heptarene, biphenylene, indacene, acenaphthylene, fluorene, phenylene, and phenanthrene rings.

When such a monovalent aromatic hydrocarbon group is substituted, the substituent is not particularly limited, and examples include halogen atoms mentioned above and C₁₋₂₀ hydrocarbon groups (e.g., methyl, ethyl, and n-propyl groups). When the monovalent aromatic hydrocarbon group is substituted with a substituent, the number of substituents is not particularly limited, and can be, for example, 1 to 3.

In formula (1), the monovalent heterocyclic groups represented by R^{3a}, R^{3b}, R^{3c}, and R^{3d} are monovalent groups having a heterocyclic ring, and are groups formed by desorbing one hydrogen atom bonded to one carbon atom constituting the heterocyclic ring. At least one hydrogen atom bonded to the carbon constituting the heterocyclic ring may be replaced by a substituent.

Examples of such heterocyclic rings include heterocyclic rings (specifically heteroaromatic or heteroaliphatic rings, and particularly heteroaromatic rings) having at least one atom selected from the group consisting of nitrogen, oxygen, boron, phosphorus, silicon, and sulfur atoms. Specific examples of heterocyclic rings include heteroaromatic rings, such as furan, thiophene, pyrrole, silole, borol, phosphole, oxazole, dioxole, thiazole, pyridine, pyridazine, pyrimidine, and pyrazine rings. Further, heterocyclic fused ring of these rings, or heterocyclic fused rings of these rings and benzene rings, fused hydrocarbon rings, etc. (e.g., thienothiophene, quinoline, and benzodioxole rings) may also be used.

When such a monovalent heterocyclic group is substituted, the substituent is not particularly limited. Examples include halogen atoms mentioned above and C₁₋₂₀ hydrocarbon groups (e.g., methyl, ethyl, and n-propyl groups); however, the substituent is not limited thereto, and any substituents can be used. When the monovalent heterocyclic group is substituted with a substituent, the number of substituents is not particularly limited, and can be, for example, 1 to 3.

In formula (1), at least one pair of R^{3a} and R^{3b}, and R^{3c} and R^{3d}, are optionally bonded together to form a ring. Examples of the ring formed in this case include alicyclic rings (cycloalkyl groups), aromatic hydrocarbon rings, and heterocyclic rings mentioned above.

In formula (1), it is preferable that R^{3a}, R^{3b}, R^{3c}, and R^{3d} are all hydrogen atoms, three of them are hydrogen atoms and one is an alkyl group or a polyether group, or R^{3a} and R^{3b} and/or R^{3c} and R^{3d} are bonded together to form a ring, in terms of the width, length, polydispersity PDI, etc. of GNR to be obtained.

In formula (1), the dotted lines are the same or different and each represents no bond or a single bond; *1 represents a bonding point; and *2 represents a bonding point when the dotted line bonded to *2 is a single bond. The graphene nanoribbon refers to an armchair graphene nanoribbon when the dotted line bonded to the bonding point *2 is a single bond in formula (1), and refers to a fjord graphene nanoribbon when there is no dotted line bonded to *2.

The graphene nanoribbon of the present invention is a polymer having at least one structural unit represented by formula (1); however, due to the compound used as an initiator in the production method described later, at least one end is preferably at least one of the following structural units:
a structural unit represented by formula (11):

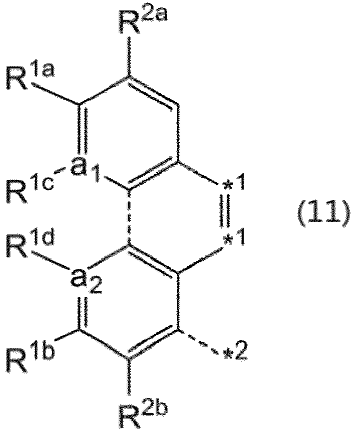

wherein the dotted lines are as defined above; *1 represents a bonding point; *2 represents a bonding point when the dotted line bonded to *2 is a single bond; R^{1a}, R^{1b}, R^{1c}, R^{1d}, R^{2a}, and R^{2b} are the same or different and each represents a hydrogen atom, a halogen atom, an alkyl group, a cycloalkyl group, a (poly)ether group, an ester group, a boronic acid or an ester group thereof, a monovalent aromatic hydrocarbon group, or a monovalent heterocyclic group; a₁ and a₂ are the same or different and each represents a carbon atom or a nitrogen atom; and R^{1c} and R^{1d} are optionally bonded together to form a ring;
a structural unit represented by formula (12):

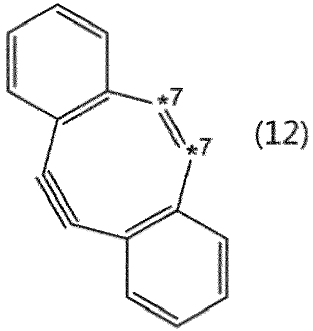

wherein *7 represents a bonding point; and
a structural unit represented by formula (13):

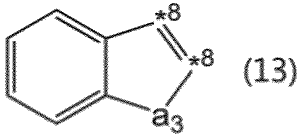

wherein *8 represents a bonding point, and a₃ represents an oxygen atom or a sulfur atom.

That is, the graphene nanoribbon of the present invention is preferably a polymer represented by formula (4):

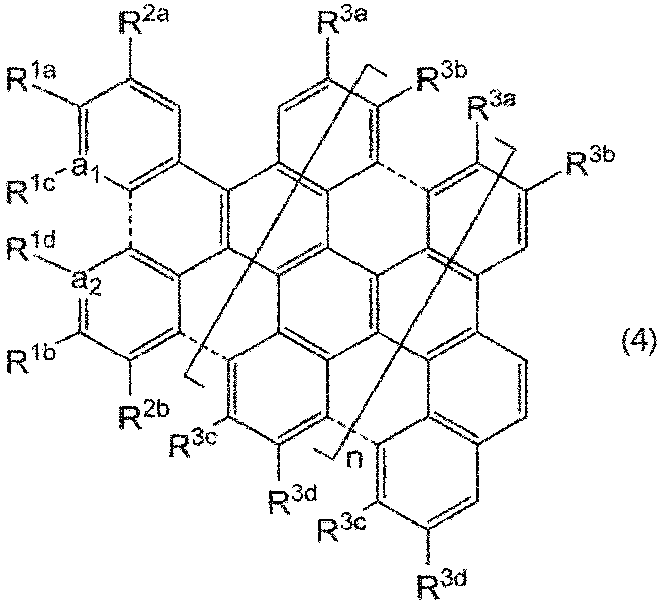

wherein the dotted lines, R^{1a}, R^{1b}, R^{2a}, R^{2b}, R^{3a}, R^{3b}, R^{3c}, R^{3d}, a₁, and a₂ are as defined above; R^{3a} and R^{3b} bonded to the same benzene ring are optionally bonded together to form a ring; R^{3c} and R^{3d} bonded to the same benzene ring are optionally bonded together to form a ring; and n represents an integer of 0 or more;
formula (14):

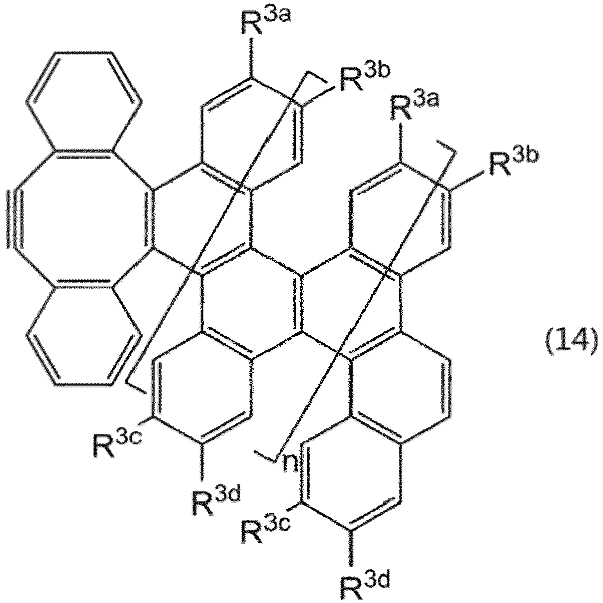

wherein R^{3a}, R^{3b}, R^{3c}, R^{3d}, and n are as defined above; R^{3a} and R^{3b} bonded to the same benzene ring are optionally bonded together to form a ring; and R^{3c} and R^{3d} bonded to the same benzene ring are optionally bonded together to form a ring; or
formula (15):

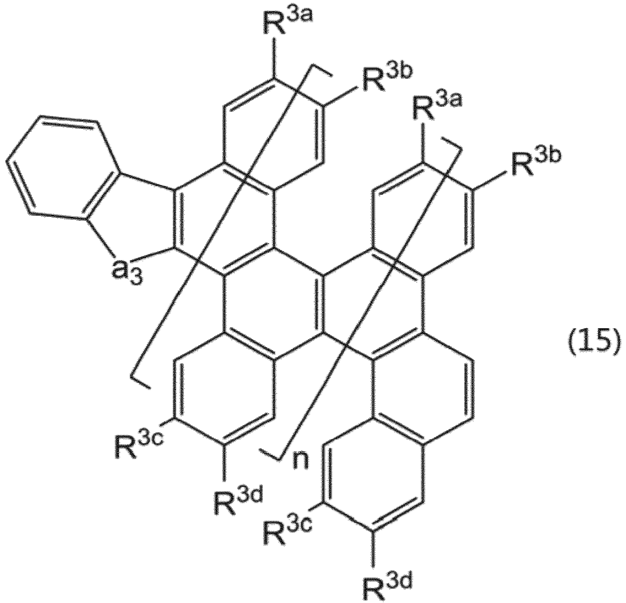

wherein R^{3a}, R^{3b}, R^{3c}, R^{3d}, n, and a₃ are as defined above; R^{3a} and R^{3b} bonded to the same benzene ring are optionally bonded together to form a ring; and R^{3c} and R^{3d} bonded to the same benzene ring are optionally bonded together to form a ring.

In formulas (4) and (11), as the halogen atom, alkyl group, (poly)ether group, ester group, monovalent aromatic hydrocarbon group, and monovalent heterocyclic group represented by R^{1a}, R^{1b}, R^{1c}, R^{1d}, R^{2a}, and R^{2b}, those mentioned above can be used. The same applies to the type and number of substituents.

In formulas (4) and (11), examples of the boronic acids or ester groups thereof represented by R^{1a}, R^{1b}, R^{1c}, R^{1d}, R^{2a}, and R^{2b} include boryl groups, pinacolatoboryl groups, and the like.

In formulas (4) and (11), R^{1a}, R^{1b}, R^{1c}, R^{1d}, R^{2a}, and R^{2b} are preferably hydrogen atoms, alkyl groups, polyether groups, or the like, in terms of the width, length, and polydispersity PDI of GNR to be obtained, availability of raw materials, water solubility, etc. In the case of alkyl groups, more preferred are branched alkyl groups; even more preferred are isopropyl, isobutyl, sec-butyl, tert-butyl, isopentyl, neopentyl, isohexyl, 1,1-dimethylbutyl, 2,2-dimethylbutyl, and 3,3-dimethylbutyl groups; and particularly preferred are tert-butyl groups.

In formulas (4) and (11), R^{1c} and R^{1d} can be bonded together to form a ring. Examples of the ring formed in this case include alicyclic rings (cycloalkyl groups), aromatic hydrocarbon rings, and heterocyclic rings mentioned above.

In formulas (4) and (11), a₁ and a₂ are preferably, among carbon and nitrogen atoms, carbon atoms, in terms of availability etc.

In the graphene nanoribbon of the present invention, the number of repeating units (i.e., n) is an integer of 0 or more, but is not particularly limited, and can be appropriately selected according to the required characteristics. For example, the number of repeating units is preferably 10 to 1000, and more preferably 10 to 500. It is also possible to obtain, for example, an oligomer in which the number of repeating units (i.e., n) is 1 to 99, preferably 2 to 49, more preferably 2 to 19, and even more preferably 3 to 9. The number of repeating units in the graphene nanoribbon of the present invention is calculated from the number average molecular weight measured in terms of polystyrene by gel permeation chromatography.

In formulas (4) and (11), the dotted lines are the same or different and each represents no bond or a single bond, *1 represents a bonding point, and *2 represents a bonding point when the dotted line bonded to *2 is a single bond. The graphene nanoribbon refers to an armchair graphene nanoribbon when the dotted line bonded to the bonding point *2 is a single bond in formula (11), and refers to a fjord graphene nanoribbon when there is no dotted line.

As another specific embodiment of the graphene nanoribbon of the present invention, in formula (1), R^{3a} and R^{3b} are bonded together to form a ring, and the graphene nanoribbon can have at least one structural unit represented by formula (3):

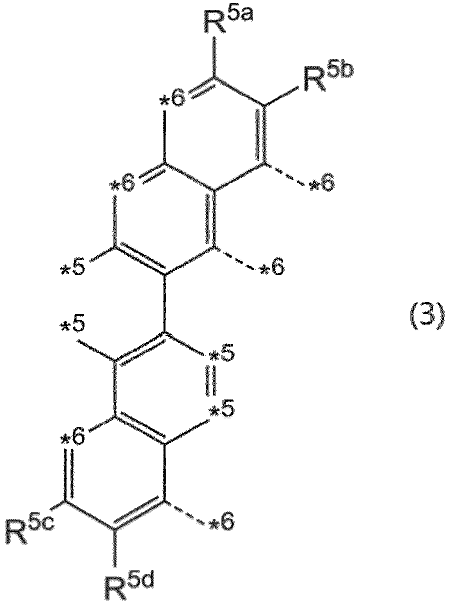

wherein the dotted lines are the same or different and each represents no bond or a single bond; *5 represents a bonding point; *6 represents a bonding point when the dotted line bonded to *6 is a single bond; R^{5a}, R^{5b}, R^{5c}, and R^{5d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{5a} and R^{5b} and/or R^{5c} and R^{5d} are optionally bonded together to form a ring.

In formula (3), as the halogen atom, alkyl group, cycloalkyl group, (poly)ether group, ester group, aromatic hydrocarbon group, and heterocyclic group represented by R^{5a}, R^{5b}, R^{5c}, and R^{5d}, those mentioned above can be used. The same applies to the type and number of substituents, preferred examples thereof, and the like.

In formula (3), R^{5a} and R^{5b} and/or R^{5c} and R^{5d} are optionally bonded together to form a ring. Examples of the ring formed in this case include alicyclic rings (cycloalkyl groups), aromatic hydrocarbon rings, and heterocyclic rings mentioned above.

Further, in formula (3), the dotted lines are the same or different and each represents no bond or a single bond; *5 represents a bonding point; and *6 represents a bonding point when the dotted line bonded to *6 is a single bond. The graphene nanoribbon refers to an armchair graphene nanoribbon when the dotted line bonded to bonding point *6 is a single bond in formula (3), and refers to a fjord graphene nanoribbon when there is no dotted line.

The graphene nanoribbon of the present invention that satisfies the above conditions may include not only homopolymers, but also block copolymers. Such a block copolymer preferably has, in addition to at least one structural unit represented by formula (1), at least one structural unit represented by formula (2) :

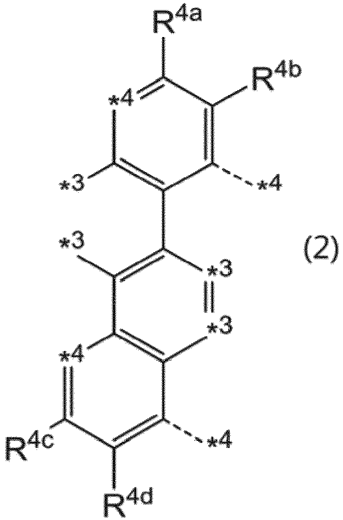

wherein the dotted lines are the same or different and each represents no bond or a single bond; *3 represents a bonding point; *4 represents a bonding point when the dotted line bonded to *4 is a single bond; R^{4a}, R^{4b}, R^{4c}, and R^{4d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{4a} and R^{4b} and/or R^{4c} and R^{4d} are optionally bonded together to form a ring; provided that R^{4a} and R^{3a} are not the same, R^{4b} and R^{3b} are not the same, R^{4c} and R^{3c} are not the same, and R^{4d} and R^{3d} are not the same.

In formula (2), as the halogen atom, alkyl group, cycloalkyl group, (poly)ether group, ester group, aromatic hydrocarbon group, and heterocyclic group represented by R^{4a}, R^{4b}, R^{4c}, and R^{4d}, those mentioned above can be used. The same applies to the type and number of substituents, preferred examples thereof, and the like.

In formula (2), R^{4a} and R^{4b} and/or R^{4c} and R^{4d} are optionally bonded together to form a ring. Examples of the ring formed in this case include alicyclic rings (cycloalkyl groups), aromatic hydrocarbon rings, and heterocyclic rings mentioned above.

Further, in formula (2), the dotted lines are the same or different and each represents no bond or a single bond, *3 represents a bonding point, and *4 represents a bonding point when the dotted line bonded to *4 is a single bond. The graphene nanoribbon refers to an armchair graphene nanoribbon when the dotted line bonded to bonding point *4 is a single bond in formula (2), and refers to a fjord graphene nanoribbon when there is no dotted line bonded to *4.

Among the graphene nanoribbons of the present invention, the graphene nanoribbon as a block copolymer is a polymer having at least one structural unit represented by formula (1) and at least one structural unit represented by formula (2); however, due to the compound used as an initiator in the production method described later, at least one end preferably has at least one of the structural units represented by formulas (11), (12), and (13).

That is, among the graphene nanoribbons of the present invention, the graphene nanoribbon as a block copolymer is preferably a graphene nanoribbon represented by formula (4A):

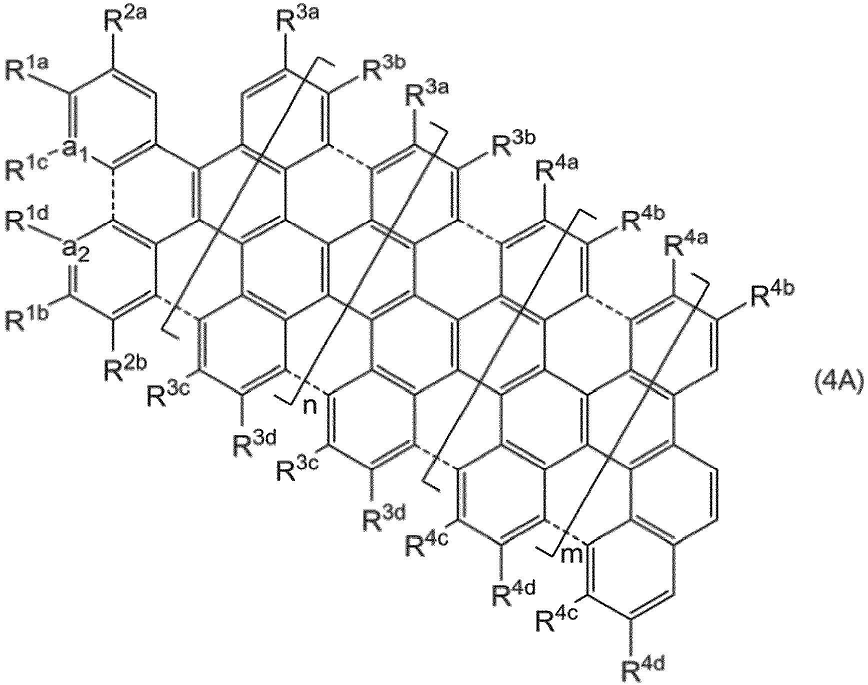

wherein the dotted lines, R^{1a}, R^{1b}, R^{1c}, R^{1d}, R^{2a}, R^{2b}, R^{3a}, R^{3b}, R^{3c}, R^{3d}, R^{4a}, R^{4b}, R^{4c}, R^{4d}, a₁, a₂, and n are as defined above; R^{3a} and R^{3b} bonded to the same benzene ring are optionally bonded together to form a ring; R^{3c} and R^{3d} bonded to the same benzene ring are optionally bonded together to form a ring; R^{4a} and R^{4b} bonded to the same benzene ring are optionally bonded together to form a ring; R^{4c} and R^{4d} bonded to the same benzene ring are optionally bonded together to form a ring; and m represents an integer of 0 or more;
formula (14A) :

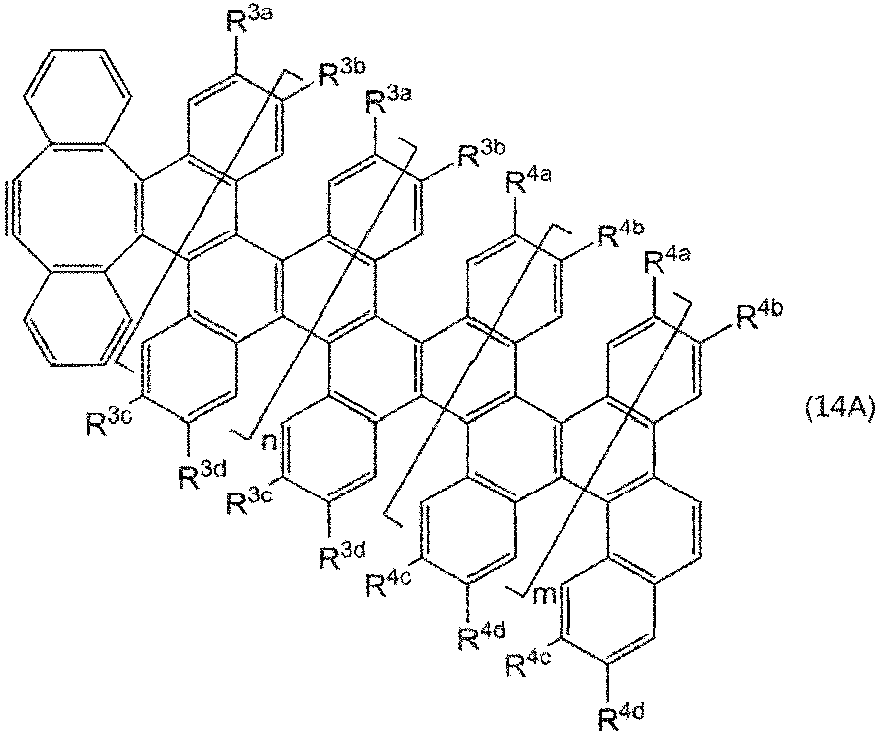

wherein R^{3a}, R^{3b}, R^{3c}, R^{3d}, R^{4a}, R^{4b}, R^{4c}, R^{4d}, n, and m are as defined above; R^{3a} and R^{3b} bonded to the same benzene ring are optionally bonded together to form a ring; R^{3c} and R^{3d} bonded to the same benzene ring are optionally bonded together to form a ring; R^{4a} and R^{4b} bonded to the same benzene ring are optionally bonded together to form a ring; and R^{4c} and R^{4d} bonded to the same benzene ring are optionally bonded together to form a ring; or
formula (15A):

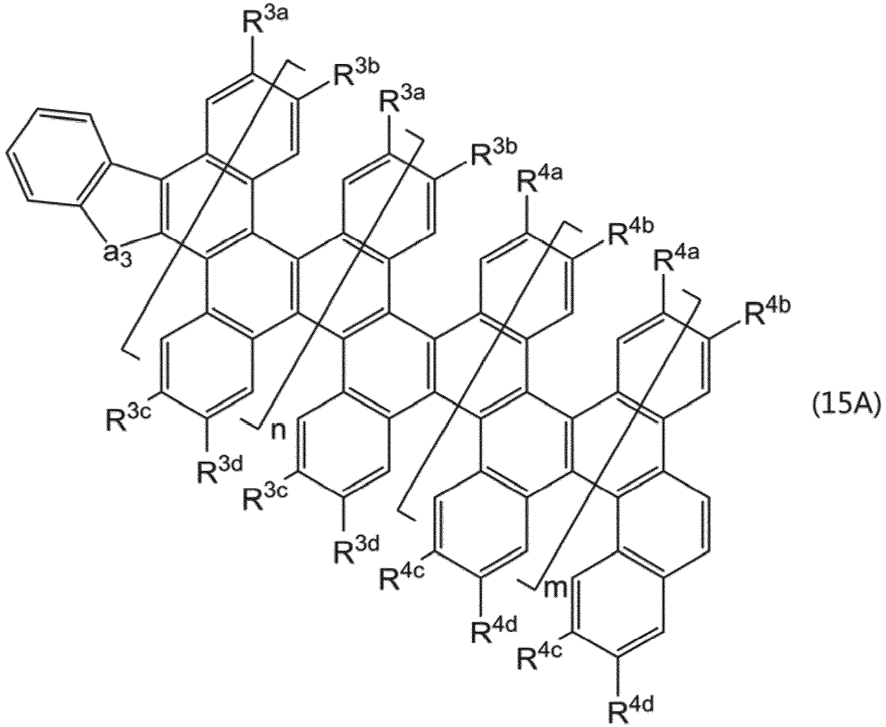

wherein R^{3a}, R^{3b}, R^{3c}, R^{3d}, R^{4a}, R^{4b}, R^{4e}, R^{4d}, a₃, n, and m are as defined above; R^{3a} and R^{3b} bonded to the same benzene ring are optionally bonded together to form a ring; R^{3e} and R^{3d} bonded to the same benzene ring are optionally bonded together to form a ring; R^{4a} and R^{4b} bonded to the same benzene ring are optionally bonded together to form a ring; and R^{4c} and R^{4d} bonded to the same benzene ring are optionally bonded together to form a ring.

In formulas (4A), (14A), and (15A), the number of repeating units (i.e., n and m) is an integer of 0 or more, but is not particularly limited, and can be appropriately selected according to the required characteristics. For example, the number of repeating units is preferably 10 to 1000, and more preferably 10 to 500. It is also possible to obtain, for example, an oligomer in which the number of repeating units (i.e., n and m) is 1 to 99, preferably 2 to 49, more preferably 2 to 19, and even more preferably 3 to 9. The number of repeating units (n and m) in the graphene nanoribbon of the present invention is calculated from the number average molecular weight measured in terms of polystyrene by gel permeation chromatography.

A specific embodiment of the graphene nanoribbon of the present invention can also be a polymer obtained by copolymerizing a graphene nanoribbon having different groups as R^{4d} and R^{3d} and having different substituents. The same applies when R^{4a} and R^{3a} are different groups, R^{4b} and R^{3b} are different groups, and R^{4c} and R^{3c} are different groups. Such graphene nanoribbons simultaneously exhibit, for example, fat solubility and water solubility, and thus form vesicles and micelles, which can be used for water-soluble carbon materials.

Further, the graphene nanoribbon of the present invention having at least one structural unit represented by formula (3) can also be a polymer having at least one structural unit represented by formula (1) and at least one structural unit represented by formula (3) (however, in this case, the structural unit represented by formula (3) and the structural unit represented by formula (1) are not the same). In this case, due to the compound used as an initiator in the production method described later, at least one end preferably has at least one of the structural units represented by formulas (11), (12), and (13) .

That is, the graphene nanoribbon of the present invention can also be a graphene nanoribbon represented by formula (4A1):

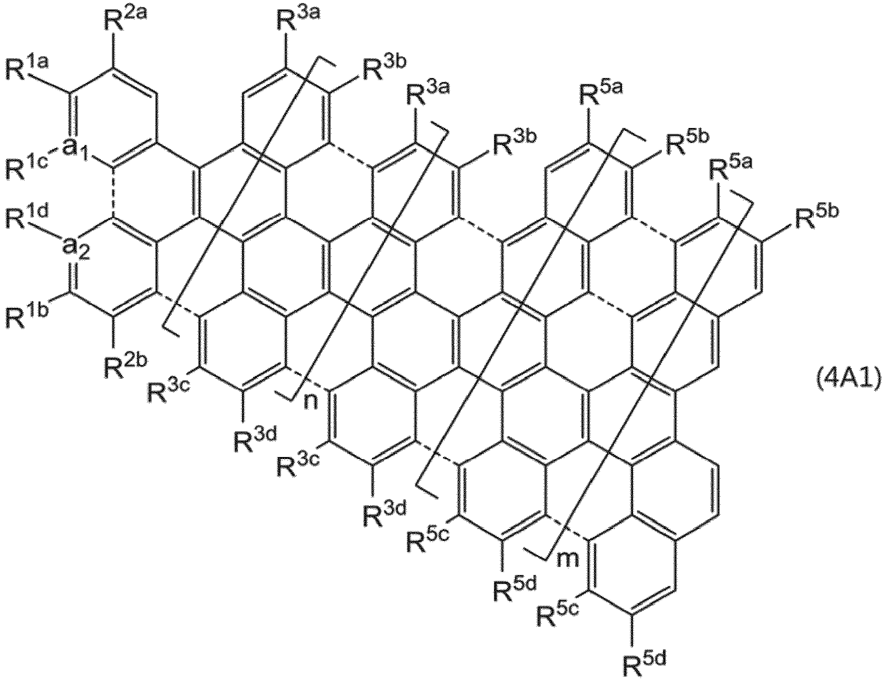

wherein the dotted lines, R^{1a}, R^{1b}, R^{1c}, R^{1d}, R^{2a}, R^{2b}, R^{3a}, R^{3b}, R^{3c}, R^{3d}, R^{5a}, R^{5b}, R^{5c}, R^{5d}, a₁ a₂, n, and m are as defined above; R^{3a} and R^{3b} bonded to the same benzene ring are optionally bonded together to form a ring; R^{3c} and R^{3d} bonded to the same benzene ring are optionally bonded together to form a ring; R^{5a} and R^{5b} bonded to the same benzene ring are optionally bonded together to form a ring; and R^{5c} and R^{5d} bonded to the same benzene ring are optionally bonded together to form a ring;
formula (14A1):

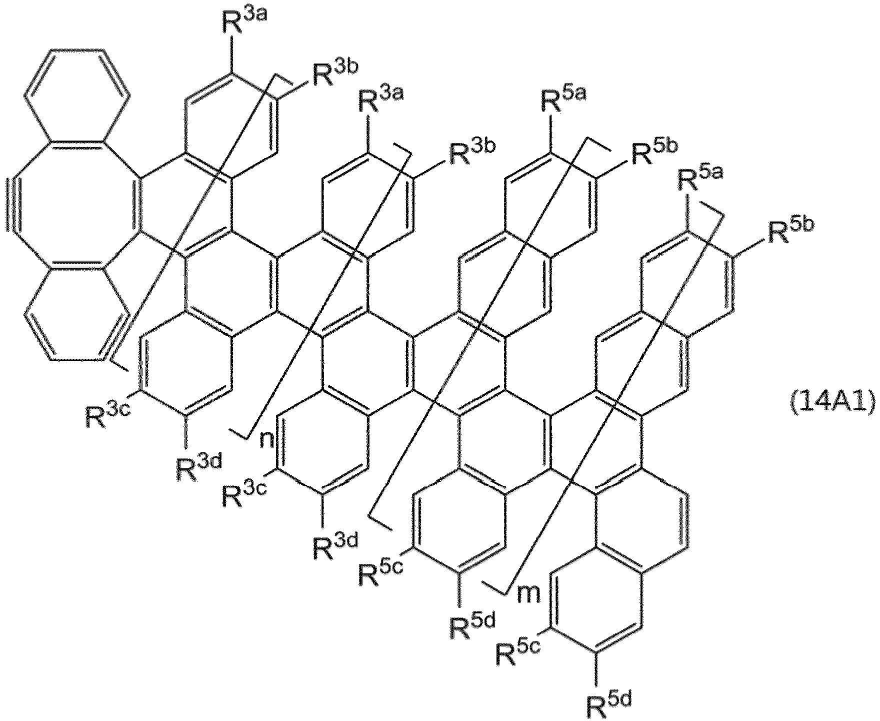

wherein R^{3a}, R^{3b}, R^{3c}, R^{3d}, R^{5a}, R^{5b}, R^{5c}, R^{5d}, n, and m are as defined above; R^{3a} and R^{3b} bonded to the same benzene ring are optionally bonded together to form a ring; R^{3c} and R^{3d} bonded to the same benzene ring are optionally bonded together to form a ring; R^{5a} and R^{5b} bonded to the same benzene ring are optionally bonded together to form a ring; and R^{5c} and R^{5d} bonded to the same benzene ring are optionally bonded together to form a ring; or
formula (15A1):

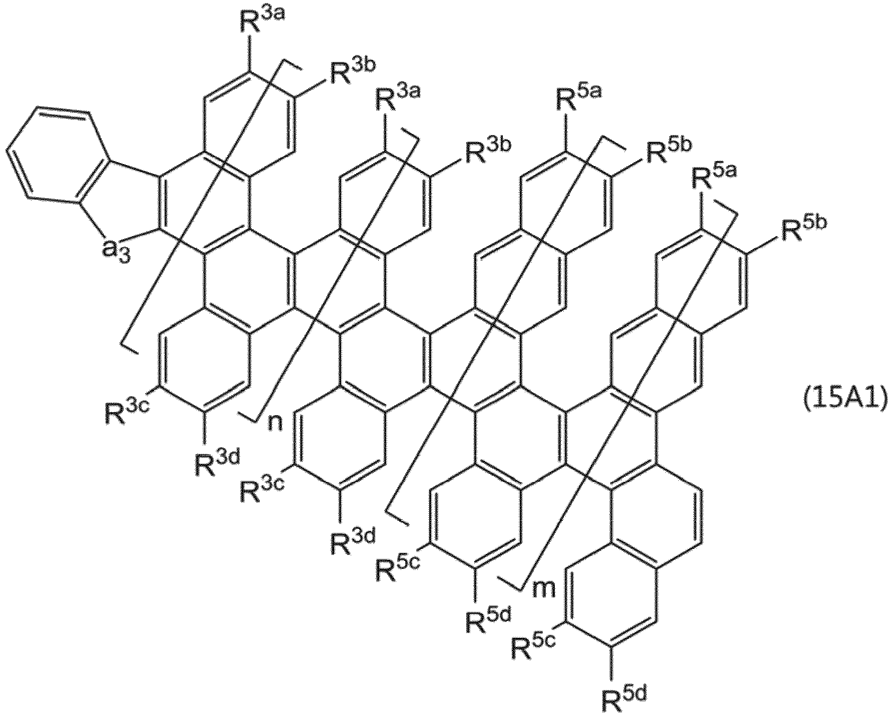

wherein R^{3a}, R^{3b}, R^{3c}, R^{3d}, R^{5a}, R^{5b}, R^{5c}, R^{5d}, a₃, n, and m are as defined above; R^{3a} and R^{3b} bonded to the same benzene ring are optionally bonded together to form a ring; R^{3e} and R^{3d} bonded to the same benzene ring are optionally bonded together to form a ring; R^{5a} and R^{5b} bonded to the same benzene ring are optionally bonded together to form a ring; and R^{5c} and R^{5d} bonded to the same benzene ring are optionally bonded together to form a ring.

The graphene nanoribbon having at least one structural unit represented by formula (1) and at least one structural unit represented by formula (3) is, in short, a graphene nanoribbon with a width change in the middle of the molecule. Since the properties (metallic or semiconducting) of graphene nanoribbons can vary depending on their width and the surrounding structure, it is also possible to obtain a graphene nanoribbon that exhibits both semiconducting and metallic properties. In this block copolymer, when a graphene nanoribbon block having semiconducting properties is used as a transistor substitution, and a graphene nanoribbon block having metallic properties is used as a metal nanowire substitution, a transistor made of the graphene nanoribbon is expected.

In the graphene nanoribbon of the present invention, the number average molecular weight is not particularly limited, and can be appropriately selected according to the required characteristics. In terms of solubility etc., for example, the number average molecular weight is preferably 10000 or more, more preferably 15000 to 300000, even more preferably 20000 to 200000, and particularly preferably 30000 to 150000. Further, for example, in the case of a low-molecular-weight oligomer, the number average molecular weight of the graphene nanoribbon of the present invention can be, for example, 500 to 5000. The number average molecular weight of the graphene nanoribbon of the present invention is determined by gel permeation chromatography in terms of polystyrene.

In the graphene nanoribbon of the present invention, the polydispersity PDI is not particularly limited, and can be appropriately selected according to the required characteristics. For example, the polydispersity PDI is preferably 1.00 to 1.40, more preferably 1.01 to 1.30, and even more preferably 1.02 to 1.20. The polydispersity PDI of the graphene nanoribbon of the present invention is calculated by eluting a tetrahydrofuran (THF) eluate containing 0.1% tetra-n-butylammonium bromide (TBAB) at a delivery speed of 1.0 mL/min at 40°C by size exclusion chromatography (SEC) in which two polystyrene gel columns (TOSOH TSKgel Multipore H_{XL}-M SEC columns, 7.8 mm × 300 mm) are connected in series. In that case, PDI is determined by calculating the ratio of number average molecular weight to weight average molecular weight measured in terms of standard polystyrene.

The graphene nanoribbon of the present invention has the structure described above, and its width depends on the length of a substrate used in the production method described later. Further, the length of the graphene nanoribbon of the present invention depends on the degree of polymerization (the number of repeating units) of the graphene nanoribbon of the present invention. The length of the substrate refers to the length of compounds represented by formulas (5A), (5B), (6), (7), and (7A) described later, dibenzocyclooctadiyne, benzothiophene, benzofuran, etc. Therefore, the width of the graphene nanoribbon can be controlled by changing the type of substrate, and the length of the graphene nanoribbon can be controlled by changing the reaction conditions. The width and length of the graphene nanoribbon of the present invention can be made uniformly by appropriately controlling the initiator in the production method described later, and mass synthesis is possible. Thus, according to the present invention, it is possible to precisely control the width and length of the graphene nanoribbon by appropriately controlling the initiator in the production method, described later, and it is therefore also possible to finely adjust the electronic characteristics.

The width of the graphene nanoribbon of the present invention is preferably 0.1 to 2.0 nm, and more preferably 0.5 to 1.5 nm.

Further, the length of the graphene nanoribbon of the present invention is preferably 10 nm or more, more preferably 20 to 500 nm, even more preferably 50 to 400 nm, and particularly preferably 100 to 300 nm. In addition, for example, when the graphene nanoribbon of the present invention is obtained as a low-molecular-weight oligomer, the length of the graphene nanoribbon of the present invention can be appropriately selected according to the required characteristics. For example, when a silver compound is used, in addition to a palladium compound and o-chloranil, in the production method described later, longer graphene nanoribbons tend to be generated. When a silver compound is not used, in addition to a palladium compound and o-chloranil, shorter graphene nanoribbons tend to be generated. Longer graphene nanoribbons are expected to be applied to semiconductors, solar cells, etc., and short graphene nanoribbons are expected to be applied to organic EL diodes etc.

The graphene nanoribbon of the present invention has high solubility in organic solvents, such as chloroform, dichloromethane, tetrahydrofuran (THF), and ethyl acetate, and thus also has excellent film-forming properties. In addition, the graphene nanoribbon of the present invention is expected, for example, as various charge transport materials for OLEDs, OFETs, and organic thin film solar cells. In particular, the graphene nanoribbon of the present invention is expected to lead to the creation of highly efficient electron donor molecules and highly efficient electron acceptor molecules for organic thin-film solar cells.

### 2. Method for Producing Graphene Nanoribbon

The graphene nanoribbon of the present invention can be synthesized by a production method comprising, for example,
(1) a first polymerization step of reacting, in the presence of a palladium compound and o-chloranil, an alkyne compound represented by formula (5A):

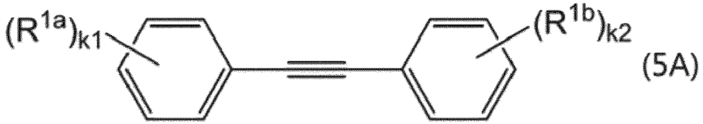

wherein R^{1a} and R^{1b} are as defined above; k1 and k2 are the same or different and each represents an integer of 1 to 3; when k1 and k2 are integer of 2 or more, each R^{1a} and/or R^{1b} is optionally the same or different;
a K region-containing aromatic compound represented by formula (5B) :

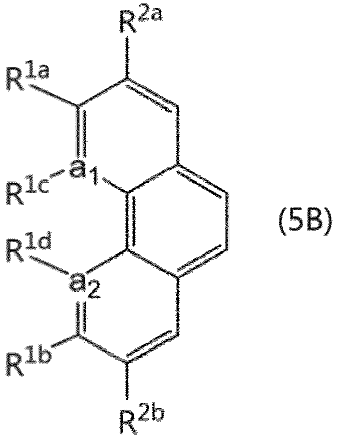

wherein R^{1a}, R^{1b}, R^{1c}, R^{1d}, R^{2a}, R^{2b}, a₁ and a₂ are as defined above; dibenzocyclooctadiyne, benzothiophene, or benzofuran, and a silole compound represented by formula (6):

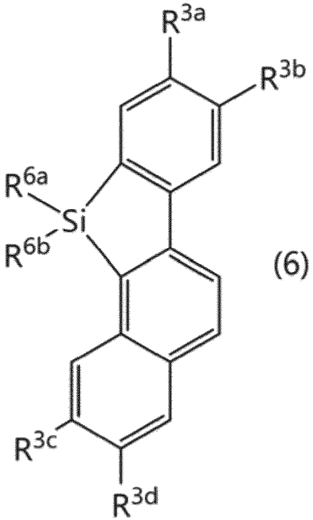

wherein R^{3a}, R^{3b}, R^{3c}, and R^{3d} are as defined above; and R^{6a} and R^{6b} are the same or different and each represents a hydrogen atom or an alkyl group.

Further, when the graphene nanoribbon of the present invention is obtained as a block copolymer, the production method may comprise, after the first polymerization step,
(2) a second polymerization step of reacting, in the presence of a palladium compound and o-chloranil, a K region-containing polymer obtained in step (1) and a silole compound represented by formula (7):

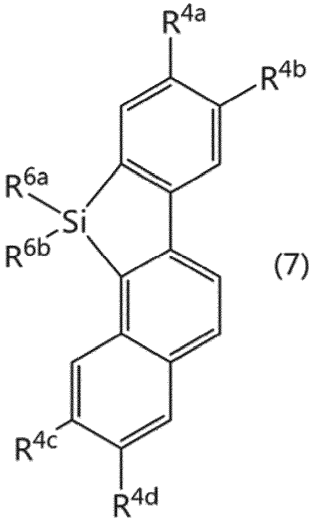

wherein R^{4a}, R^{4b}, R^{4c}, R^{4d}, R^{6a}, and R^{6b} are as defined above.

By adopting such a method, in the first polymerization step, a regioselective and continuous APEX polymerization proceeds between the triple bond of the alkyne compound represented by formula (5A) or dibenzocyclooctadiyne, the K region in the K region-containing aromatic compound represented by formula (5B), or the double bond of benzothiophene or benzofuran, and the silole skeleton in the silole compound represented by formula (6). When using a compound having multiple triple bonds or K regions, the multiple triple bonds or K regions may react simultaneously with the silole skeleton in the silole compound represented by formula (6); however, typically, one of the multiple triple bonds or K regions reacts selectively. Further, in the second polymerization step, a regioselective and continuous APEX polymerization proceeds between the K region in the K region-containing polymer obtained in the first polymerization step and the silole skeleton in the silole compound represented by formula (7). The polymerization reaction proceeds because the silole skeleton acts as a π-extension reactant. Accordingly, the graphene nanoribbon of the present invention can be synthesized more precisely in just one or two reaction steps, and the number of steps can be significantly reduced.

### (2-1) Substrate

### Alkyne Compound

The alkyne compound that can be used as a substrate in the production method of the present invention is, for example, an alkyne compound represented by formula (5A):

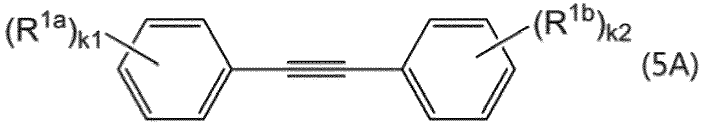

wherein R^{1a}, R^{1b}, k1, and k2 are as defined above.

In formula (5A), R^{1a} and R^{1b} are both hydrogen atoms, in terms of availability etc.

In formula (5A), k1 and k2 are an integer of 1 to 3, and in terms of availability etc., k1 and k2 are both preferably 1. Further, when R^{1a} and/or R^{1b} is a group other than a hydrogen atom, the position of the substitution is not particularly limited, and is preferably the para- or meta-position, and more preferably the para-position.

### Examples of such alkyne compounds include

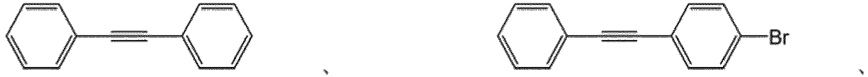

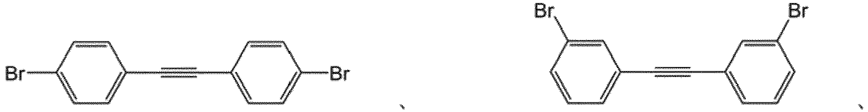

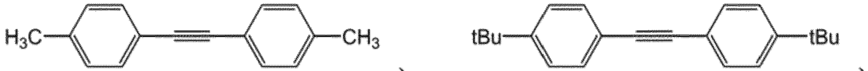

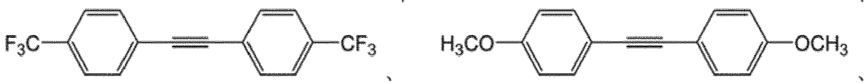

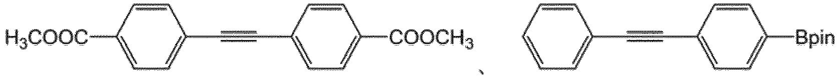

wherein tBu represents a tert-butyl group, and Bpin represents a pinacolatoboryl group.

### K Region-Containing Aromatic Compound

The K region-containing aromatic compound that can be used as a substrate in the production method of the present invention is, for example, a K region-containing aromatic compound represented by formula (5B): 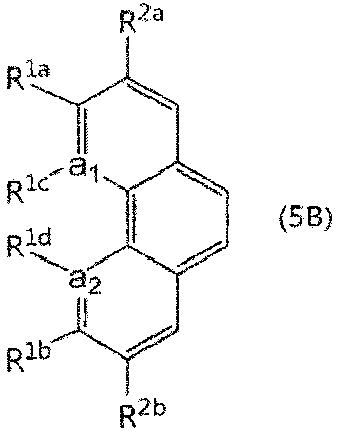 wherein R^{1a}, R^{1b}, R^{1c}, R^{1d}, R^{2a}, R^{2b}, a₁ and a₂ are as defined above.

In formula (5B), R^{1a}, R^{1b}, R^{1c}, R^{1d}, R^{2a}, and R^{2b} are preferably hydrogen atoms, alkyl groups, or the like, in terms of availability etc.

In formula (5B), a₁ and a₂ are preferably carbon atoms, in terms of availability etc.

### Examples of such K region-containing aromatic compounds include

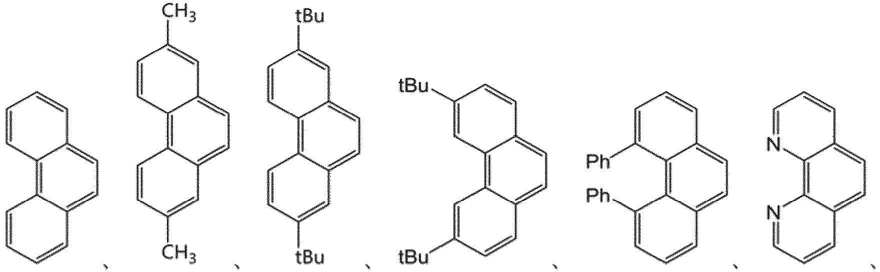

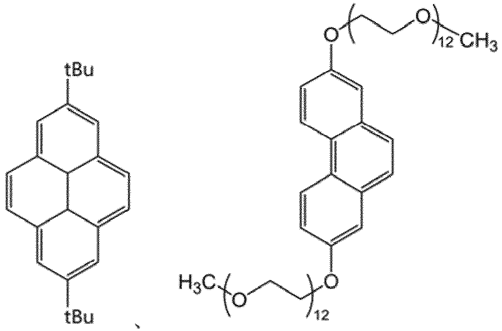

wherein tBu represents a tert-butyl group, and Ph represents a phenyl group.

### Other Substrates

Further, as the substrate (initiator), dibenzocyclooctadiyne, benzothiophene, and benzofuran can also be used in addition to the compounds represented by formula (5A) and (5B) .

### Silole Compound

The silole compound that can be used as a substrate in the production method of the present invention is, for example, in the first polymerization step, a silole compound represented by formula (6):

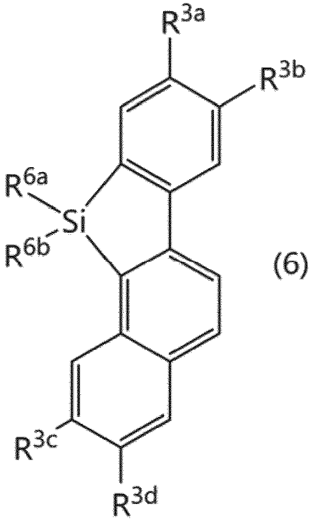

wherein R^{3a}, R^{3b}, R^{3c}, and R^{3d} are as defined above; and R^{6a} and R^{6b} are the same or different and each represents a hydrogen atom or an alkyl group.

Further, the silole compound that can be used as a substrate in the production method of the present invention is, for example, in the second polymerization step, a silole compound represented by formula (7):

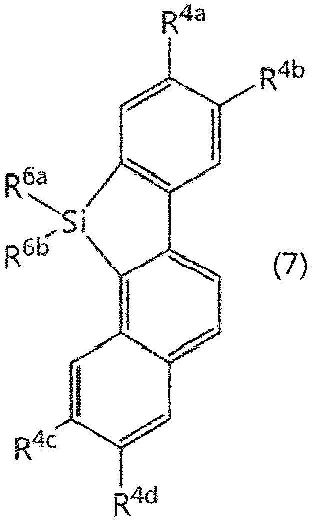

wherein R^{4a}, R^{4b}, R^{4c}, R^{4d}, R^{6a}, and R^{6b} are as defined above.

As such a silole compound, R^{3a} and R^{3b} in formula (6) may be bonded together to form a ring, or R^{4a} and R^{4b} in formula (7) may be bonded together to form a ring, thereby obtaining a silole represented by formula (7A):

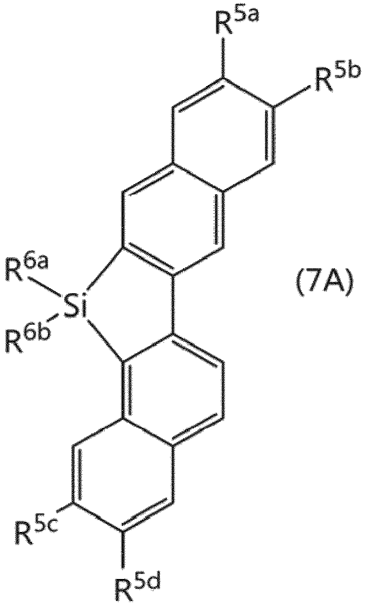

wherein R^{5a}, R^{5b}, R^{5c}, R^{5d}, R^{6a}, and R^{6b} are as defined above.

In formula (6), as R^{3a}, R^{3b}, R^{3c}, and R^{3d}, those mentioned above can be used. When all of R^{3a}, R^{3b}, R^{3c}, and R^{3d} are hydrogen atoms, the thermal durability of the graphene nanoribbon derived from the silole compound can be particularly improved. Further, due to stronger intermolecular interactions, self-assembly properties can be improved. This is the same when all of R^{4a}, R^{4b}, R^{4c}, and R^{4d} in formula (7) are hydrogen atoms, and when all of R^{5a}, R^{5b}, R^{5c}, and R^{5d} in formula (7A) are hydrogen atoms.

In formulas (6), (7), and (7A), as the alkyl groups represented by R^{6a} and R^{6b}, those mentioned above can be used. The same applies to the type and number of substituents.

Examples of the silole compound that satisfies the above conditions and can be used in the first polymerization step and second polymerization step include

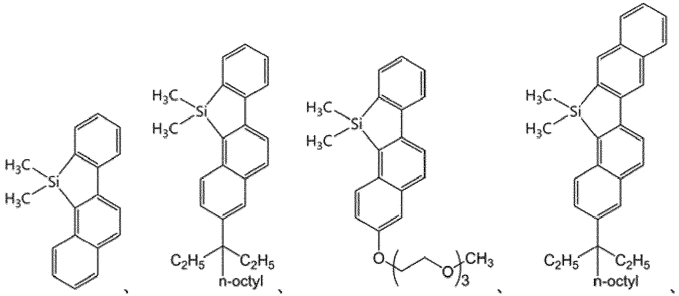

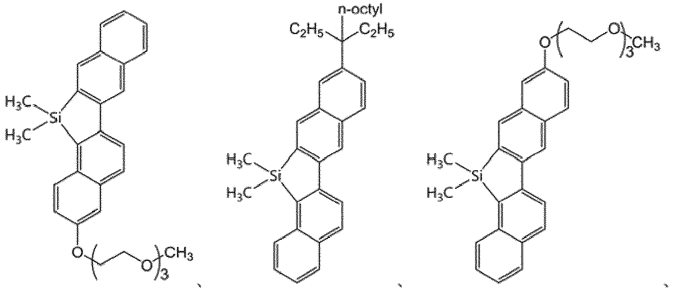

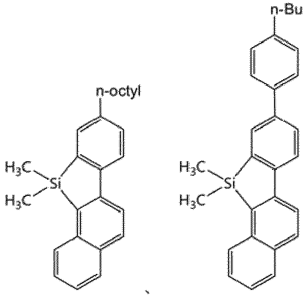

wherein n-Bu represents an n-butyl group, and n-octyl represents an n-octyl group.

Of these,

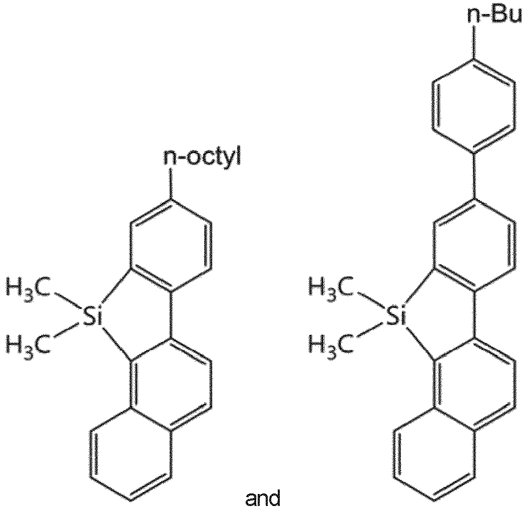

are easily obtained as solids (crystals) at room temperature (e.g., 25°C), and are thus preferable in terms of easily improving the purity by industrial methods, such as crystallization.

In addition,

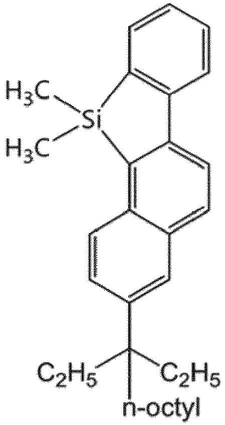

is preferable in terms of easily improving the solvent solubility of the graphene nanoribbon to be obtained.

The compound of formula (6) into which an alkyl group is introduced as R^{3a} and/or R^{3b} can be produced, for example, by a production method comprising reacting a halogen-containing silole compound represented by formula (8):

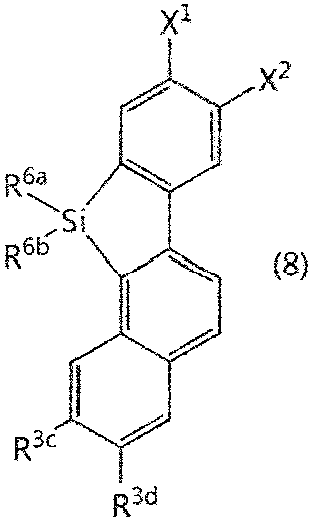

wherein R^{3c}, R^{3d}, R^{6a}, and R^{6b} are as defined above; X¹ and X² are the same or different and each represents a hydrogen atom or a halogen atom; and X¹ and X² are optionally bonded to form a ring containing a halogen atom; provided that not both of X¹ and X² are hydrogen atoms; and
a Grignard reagent represented by formula (9):

R⁷MgX³ (9)

wherein R⁷ represents an alkyl group or a monovalent aromatic hydrocarbon group, and X³ represents a halogen atom; or
a boronic acid compound represented by formula (10):

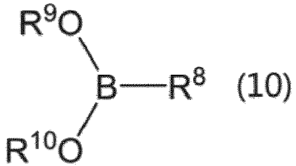

wherein R⁸ represents an alkyl group or a monovalent aromatic hydrocarbon group; R⁹ and R¹⁰ are the same or different and each represents a hydrogen atom or an alkyl group; and R⁹ and R¹⁰ are optionally bonded to form a ring together with the adjacent -O-B-O-.

In formula (8), examples of the halogen atoms represented by X¹ and X² include fluorine, chlorine, and bromine atoms.

In formula (8), X¹ and X² are optionally bonded together to form a ring containing a halogen atom. Examples of the ring formed in this case include rings in which at least one of the above halogen atoms is substituted on the above aromatic hydrocarbon ring and heterocyclic ring.

Such a halogen-containing silole compound represented by formula (8) can be produced, for example, according to the method described in the Examples, provided later. Further, the halogen atom in the halogen-containing silole compound represented by formula (8) is preferably a chlorine atom in terms of industrial availability. Specific examples include

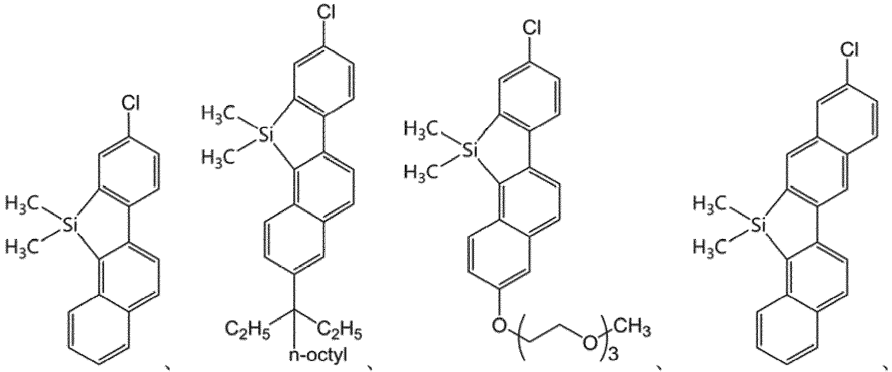

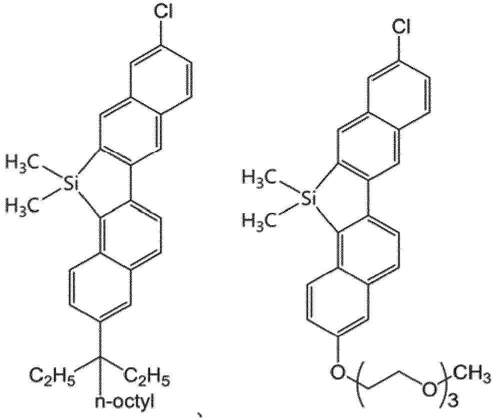

wherein n-octyl represents an n-octyl group.

In formula (9), as the alkyl group and monovalent aromatic hydrocarbon group represented by R⁷, those mentioned above can be used. The same applies to the type and number of substituents.

In formula (9), as the halogen atom represented by X³, those mentioned above can be used.

Examples of the Grignard reagent that satisfies such conditions include alkylmagnesium halides, such as methylmagnesium chloride, methylmagnesium bromide, n-butylmagnesium chloride, n-butylmagnesium bromide, n-hexylmagnesium chloride, n-hexylmagnesium bromide, n-octylmagnesium chloride, n-octylmagnesium bromide, 2-ethylhexylmagnesium chloride, and 2-ethylhexylmagnesium bromide; and phenylmagnesium chloride, phenylmagnesium bromide, 4-n-butylphenylmagnesium chloride, 4-n-butylphenylmagnesium bromide, 4-n-octylphenylmagnesium chloride, 4-n-octylphenylmagnesium bromide, and the like.

When the halogen-containing silole compound represented by formula (8) is reacted with the Grignard reagent represented by formula (9), the reaction can be performed with reference to, for example, the conditions described in J.A.C.S. 2002, 124, 13856.

In formula (10), as the alkyl group and monovalent aromatic hydrocarbon group represented by R⁸, those mentioned above can be used. The same applies to the type and number of substituents.

In formula (10), as the alkyl group represented by R⁹ and R¹⁰, those mentioned above can be used. The same applies to the type and number of substituents.

Further, in formula (10), when R⁹ and R¹⁰ are both alkyl groups, they are optionally bonded together to form a ring together with the adjacent -O-B-O-. In this case, examples of the boronic acid compound include 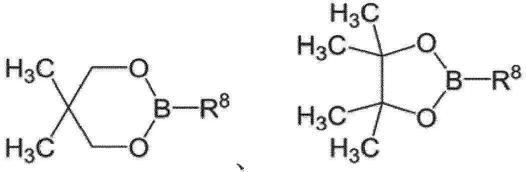 wherein R⁸ is as defined above.

Of these, it is preferable that R⁹ and R¹⁰ are both hydrogen atoms, in terms of yield.

### Examples of the boronic acid compound that satisfies such conditions include

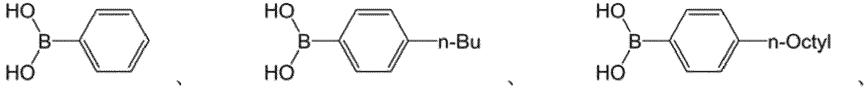

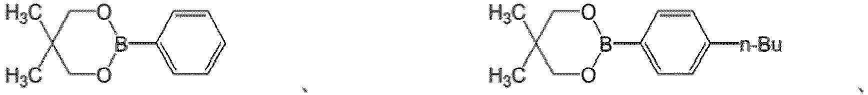

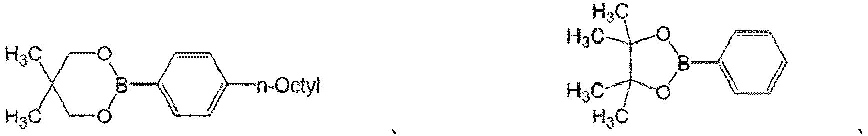

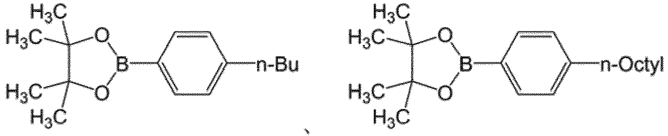

wherein n-Bu represents an n-butyl group, and n-Octyl represents an n-octyl group.

When the halogen-containing silole compound represented by formula (8) is reacted with the boronic acid compound represented by formula (10), the reaction can be performed with reference to, for example, the conditions described in J.A.C.S. 2005, 127, 4685.

The above shows an example of the method for producing the compound of formula (6) in which an alkyl group is introduced as R^{3a} and/or R^{3b}. A compound of formula (7) in which an alkyl group is introduced as R^{4a} and/or R^{4b}, and a compound of formula (7A) in which an alkyl group is introduced as R^{5a} and/or R^{5b} can also be similarly synthesized.

In the production method of the present invention, in both the first polymerization step and the second polymerization step, the amount of the compound (alkyne compound, K region-containing aromatic compound, dibenzocyclooctadiyne, benzothiophene, benzofuran, or K region-containing polymer) to be reacted with the silole compound is preferably 0.0005 to 0.5 mol, more preferably 0.0005 to 0.1 mol, even more preferably 0.001 to 0.05 mol, and particularly preferably 0.002 to 0.03 mol, per mol of the silole compound, in terms of easily obtaining a higher-molecular-weight graphene nanoribbon. Further, when the amount of the compound (alkyne compound, K region-containing aromatic compound, dibenzocyclooctadiyne, benzothiophene, benzofuran, or K region-containing polymer) to be reacted with the silole compound is 0.01 to 0.5 mol, preferably 0.02 to 0.5 mol, more preferably 0.05 to 0.5 mol, and even more preferably 0.1 to 0.5 mol, per mol of the silole compound, it is also possible to easily obtain relatively low-molecular-weight graphene nanoribbons, i.e. oligomers. That is, it is possible to design a graphene nanoribbon with a desired molecular weight according to the required performance and application.

### (2-2) Palladium Compound

In the production method of the present invention, a palladium compound is used as a catalyst. When a palladium compound is not used, the polymerization reaction hardly proceeds, and the graphene nanoribbon of the present invention is less likely to be obtained.

Examples of palladium compounds include palladium compounds known as synthetic catalysts for macromolecule compounds etc. In terms of easily obtaining a higher-molecular-weight graphene nanoribbon, divalent palladium compounds are preferred. Examples of usable palladium compounds include Pd(OH)₂, Pd(OCOCH₃)₂, Pd(OCOCF₃)₂, Pd(acac)₂, PdCl₂, PdBr₂, PdI₂, Pd(NO₃)₂, Pd(CH₃CN)₄(SbF₆)₂, and the like. "acac" means acetylacetonate. In the present invention, the use of a weakly cationic palladium compound makes it less likely to disintegrate the silole skeleton of the substrate. In terms of easily obtaining a higher-molecular-weight graphene nanoribbon, Pd(OH)₂, Pd(OCOCH₃)₂, Pd(OCOCF₃)₂, PdBr₂, PdI₂, Pd (CH₃CN)₄ (SbF₆)₂, etc., are preferred; Pd(OCOCH₃)₂, Pd(OCOCF₃)₂, PdBr₂, PdI₂, Pd (CH₃CN)₄(SbF₆)₂, etc., are more preferred; and Pd(OCOCF₃)₂ is even more preferred.

The amount of the palladium compound used can be appropriately selected depending on the type of substrate. In terms of easily obtaining a higher-molecular-weight graphene nanoribbon, for example, the amount of the palladium compound used is preferably 0.1 to 3.0 mol, more preferably 0.2 to 2.0 mol, and even more preferably 0.5 to 1.5 mol, per mol of the silole compound as a substrate.

### (2-3) o-Chloranil

In the production method of the present invention, o-chloranil is used as an oxidant. When o-chloranil is not used, the polymerization reaction hardly proceeds, and the graphene nanoribbon of the present invention cannot be obtained. Further, when other oxidants (p-chloranil, 2,3-dichloro-5,6-dicyano-l,4-benzoquinone, 3,5-di-t-butyl-1,2-benzoquinone, CuCl₂, etc.) are used in place of o-chloranil, the polymerization reaction also hardly proceeds, and the graphene nanoribbon of the present invention cannot be obtained.

The amount of o-chloranil used can be appropriately selected depending on the type of substrate. In terms of easily obtaining a higher-molecular-weight graphene nanoribbon, for example, the amount of o-chloranil used is preferably 0.5 to 5.0 mol, more preferably 1.0 to 3.0 mol, and even more preferably 1.5 to 2.5 mol, per mol of the silole compound as a substrate.

### (2-4) Silver Compound

The production method of the present invention is preferably performed in the presence of a silver compound. Due to the use of a silver compound, higher-molecular-weight graphene nanoribbons can be easily obtained.

The silver compound is not particularly limited, and examples include organic silver compounds, such as silver acetate, silver pivalate (AgOPiv), silver trifluoromethanesulfonate (AgOTf), and silver benzoate (AgOCOPh); inorganic silver compounds, such as silver nitrate, silver fluoride, silver chloride, silver bromide, silver iodide, silver sulfate, silver oxide, silver sulfide, silver tetrafluoroborate (AgBF₄), silver hexafluorophosphate (AgPF₆), and silver hexafluoroantimonate (AgSbF₆); and the like. In terms of easily obtaining a higher-molecular-weight graphene nanoribbon, inorganic silver compounds are preferred; silver tetrafluoroborate (AgBF₄), silver hexafluorophosphate (AgPF₆), silver hexafluoroantimonate (AgSbF₆), etc. are more preferred; silver tetrafluoroborate (AgBF₄), silver hexafluoroantimonate (AgSbF₆) etc. are even more preferred; and silver hexafluoroantimonate (AgSbF₆) is particularly preferred. These silver compounds can be used singly or in combination of two or more.

The amount of the silver compound used can be appropriately selected depending on the type of substrate. In terms of easily obtaining a higher-molecular-weight graphene nanoribbon, for example, the amount of the silver compound used is preferably 0.5 to 5.0 mol, more preferably 1.0 to 3.0 mol, and even more preferably 1.5 to 2.5 mol, per mol of the silole compound as a substrate. When a plurality of silver compounds are used, it is preferable to adjust the total amount thereof within the above range.

### (2-5) Others

The production method of the present invention is preferably performed in a solvent. Examples of solvents include aliphatic hydrocarbons, such as pentane, hexane, heptane, and cyclohexane; aliphatic halogenated hydrocarbons, such as dichloromethane, dichloroethane (DCE), chloroform (CHCl₃), carbon tetrachloride, and trichloroethylene (TCE); aromatic halogenated hydrocarbons, such as bromobenzene (PhBr) and 1,3,5-tribromobenzene (PhBr₃); and the like. These can be used singly or in combination of two or more. Of these, in the present invention, in terms of easily obtaining a higher-molecular-weight graphene nanoribbon, preferred are aliphatic halogenated hydrocarbons, aromatic halogenated hydrocarbons, etc.; more preferred are dichloroethane (DCE), chloroform (CHCl₃), trichloroethylene (TCE), bromobenzene (PhBr), 1,3,5-tribromobenzene (PhBr₃), etc.; even more preferred are dichloroethane (DCE), trichloroethylene (TCE), 1,3,5-tribromobenzene (PhBr₃), etc.; and particularly preferred is dichloroethane (DCE).

In the production method of the present invention, in addition to the above components, additives can be suitably used within the range in which the effects of the present invention are not impaired.

The production method of the present invention is preferably performed under anhydrous conditions and in an inert gas atmosphere (e.g., nitrogen gas or argon gas). The reaction temperature is generally preferably about 40 to 110°C, more preferably about 50 to 100°C, and even more preferably 60 to 90°C. The reaction time can be set so that the polymerization reaction sufficiently proceeds, and is generally preferably 10 minutes to 72 hours, and more preferably 1 to 48 hours.

After the reaction is stopped, the desired graphene nanoribbon can be obtained through usual isolation and purification steps (removal of metal by silica gel column chromatography, separation or fractionation of the polymer by gel permeation chromatography (GPC), etc.).

### 3. Method for Producing Armchair Graphene Nanoribbon

The above production method can generally produce a fjord graphene nanoribbon having at least one structural unit represented by formula (1-2):

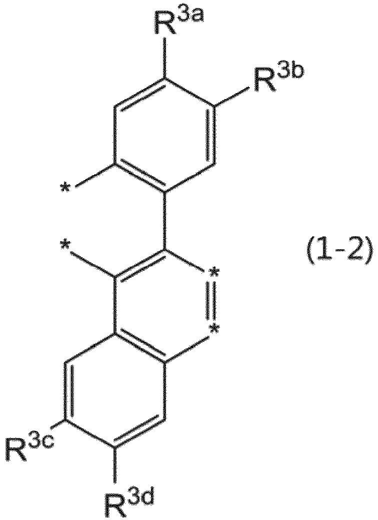

wherein * represents a bonding point, and R^{3a}, R^{3b}, R^{3c}, and R^{3d} are as defined above. This fjord graphene nanoribbon can be subjected to a ring condensation reaction, thereby obtaining an armchair graphene nanoribbon having at least one structural unit represented by formula (1-1):

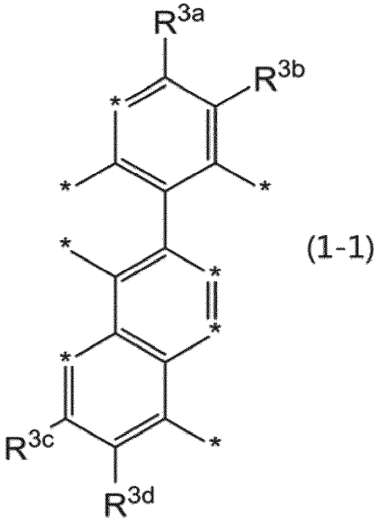

wherein * represents a bonding point, and R^{3a}, R^{3b}, R^{3c}, and R^{3d} are as defined above.

More specifically, a fjord graphene nanoribbon represented by formula (4-2) obtained by the production method of the present invention:

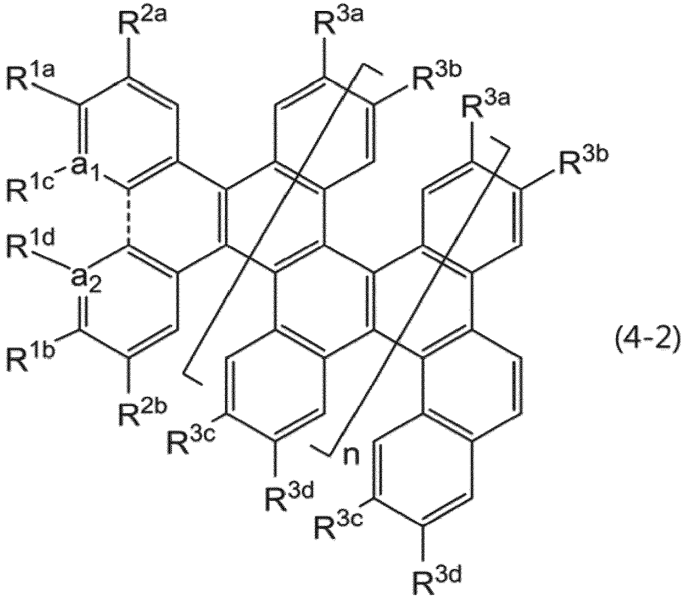

wherein the dotted lines are the same or different and each represents no bond or a single bond; R^{1a}, R^{1b}, R^{1c}, R^{1d}, R^{2a}, R^{2b}, R^{3a}, R^{3b}, R^{3c}, R^{3d}, a₁ a₂, and n are as defined above; R^{3a} and R^{3b} bonded to the same benzene ring are optionally bonded together to form a ring; and R^{3c} and R^{3d} bonded to the same benzene ring are optionally bonded together to form a ring; can be subjected to a ring condensation reaction, thereby obtaining an armchair graphene nanoribbon represented by formula (4-1):

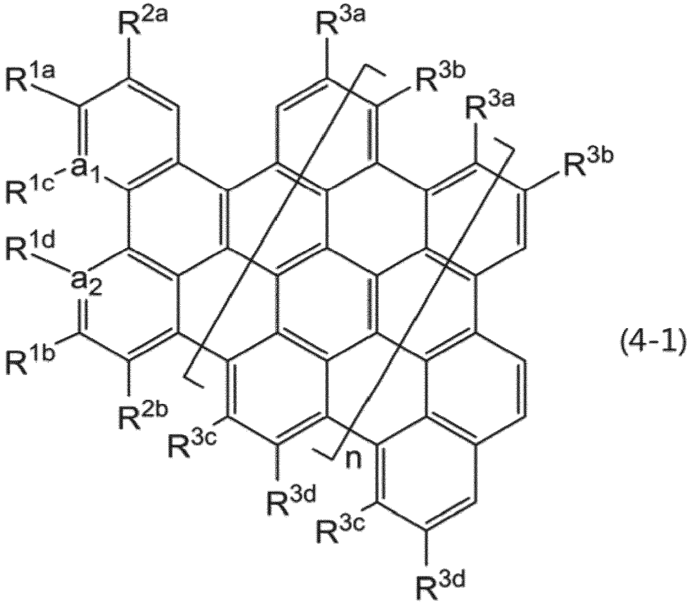

wherein R^{1a}, R^{1b}, R^{1c}, R^{1d}, R^{2a}, R^{2b}, R^{3a}, R^{3b}, R^{3c}, R^{3d}, a₁ a₂, and n are as defined above; R^{3a} and R^{3b} bonded to the same benzene ring are optionally bonded together to form a ring; and R^{3c} and R^{3d} bonded to the same benzene ring are optionally bonded together to form a ring.

Among the armchair graphene nanoribbons obtained in the above manner, the armchair graphene nanoribbon as a block copolymer is a polymer having at least one structural unit represented by formula (1-1) and at least one structural unit represented by formula (2-1):

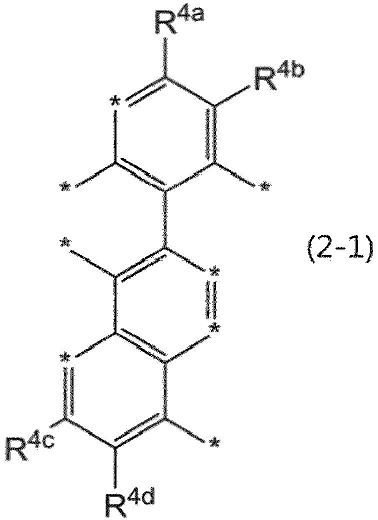

wherein * represents a bonding point, and R^{4a}, R^{4b}, R^{4c}, and R^{4d} are as defined above. However, due to the compound used as an initiator in the above production method, at least one end preferably has the structural unit represented by formula (11).

That is, among the armchair graphene nanoribbons of the present invention, the armchair graphene nanoribbon as a block copolymer is preferably an armchair graphene nanoribbon represented by formula (4-1A):

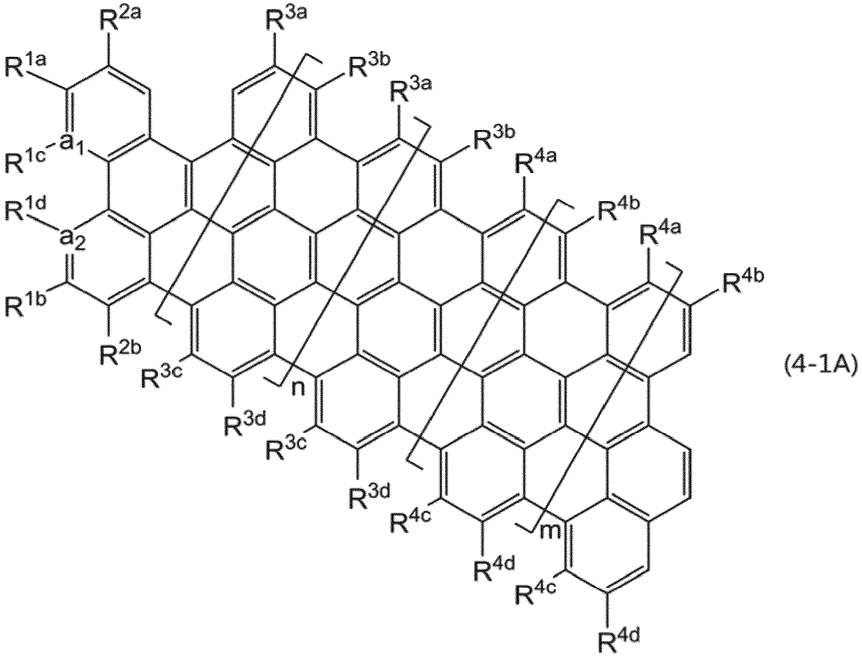

wherein R^{1a}, R^{1b}, R^{1c}, R^{1d}, R^{2a}, R^{2b}, R^{3a}, R^{3b}, R^{3c}, R^{3d}, R^{4a}, R^{4b}, R^{4c}, R^{4d}, a₁, a₂, n, and m are as defined above; R^{3a} and R^{3b} bonded to the same benzene ring are optionally bonded together to form a ring; R^{3c} and R^{3d} bonded to the same benzene ring are optionally bonded together to form a ring; R^{4a} and R^{4b} bonded to the same benzene ring are optionally bonded together to form a ring; and R^{4c} and R^{4d} bonded to the same benzene ring are optionally bonded together to form a ring.

A specific embodiment of the armchair graphene nanoribbon of the present invention can be a polymer obtained by copolymerizing a graphene nanoribbon having different groups as R^{4d} and R^{3d} and having different substituents. The same applies when R^{4a} and R^{3a} are different groups, R^{4b} and R^{3b} are different groups, and R^{4c} and R^{3c} are different groups. Such armchair graphene nanoribbons simultaneously exhibit, for example, fat solubility and water solubility, and thus form vesicles and micelles, which can be used for water-soluble carbon materials.

Further, the graphene nanoribbon of the present invention having at least one structural unit represented by formula (3-1):

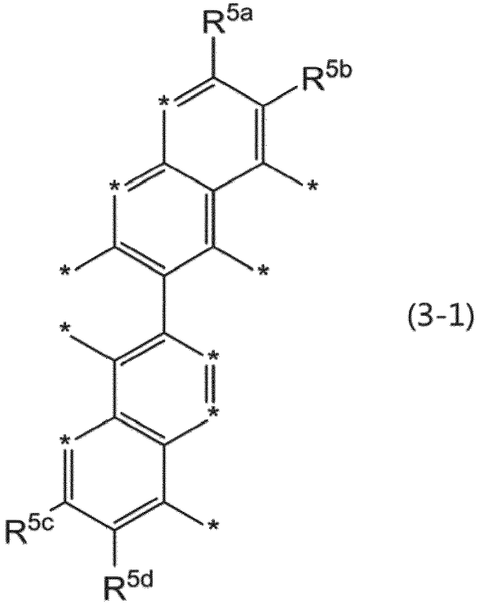

wherein * represents a bonding point, and R^{5a}, R^{5b}, R^{5c}, and R^{5d} are as defined above; can also be a polymer having at least one structural unit represented by formula (1-1) and at least one structural unit represented by formula (3-1) (however, in this case, the structural unit represented by formula (3-1) and the structural unit represented by formula (1-1) are not the same). In this case, due to the compound used as an initiator in the above production method, at least one end preferably has the structural unit represented by formula (11).

That is, the armchair graphene nanoribbon of the present invention can also be an armchair graphene nanoribbon represented by formula (4-1B):

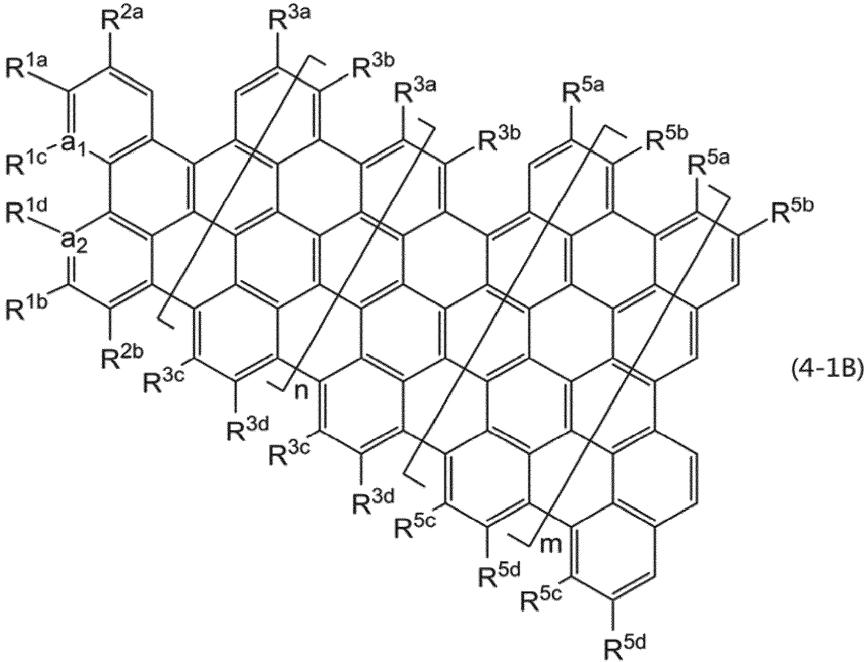

wherein the dotted lines, R^{1a}, R^{1b}, R^{1c}, R^{1d}, R^{2a}, R^{2b}, R^{3a}, R^{3b}, R^{3c}, R^{3d}, R^{5a}, R^{5b}, R^{5c}, R^{5d}, a₁, a₂, n, and m are as defined above; R^{3a} and R^{3b} bonded to the same benzene ring are optionally bonded together to form a ring; R^{3c} and R^{3d} bonded to the same benzene ring are optionally bonded together to form a ring; R^{5a} and R^{5b} bonded to the same benzene ring are optionally bonded together to form a ring; and R^{5c} and R^{5d} bonded to the same benzene ring are optionally bonded together to form a ring.

The armchair graphene nanoribbon having at least one structural unit represented by formula (1-1) and at least one structural unit represented by formula (3-1) is, in short, an armchair graphene nanoribbon with a width change in the middle of the molecule. Since the properties (metallic or semiconducting) of graphene nanoribbons can vary depending on their width and the surrounding structure, it is also possible to obtain an armchair graphene nanoribbon that exhibits both semiconducting and metallic properties. In this block copolymer, when a graphene nanoribbon block having semiconducting properties is used as a transistor substitution, and a graphene nanoribbon block having metallic properties is used as a metal nanowire substitution, a transistor made of the graphene nanoribbon is expected.

The ring condensation reaction is not particularly limited. The ring condensation reaction may be a general oxidation reaction or a Scholl reaction (dehydrogenation cyclization). The reaction is not limited to an oxidation reaction, and may be a reductive reaction. In this case, an oxidation reaction may be performed using antimony pentachloride, aluminum chloride, aluminum bromide, titanium tetrachloride, tin tetrachloride, zinc chloride, copper chloride, iron chloride (FeCl₃), boron trifluoride, diphosphorus pentaoxide, manganese dioxide, selenium oxide, iodine, or the like; or a reductive reaction using potassium may be allowed to occur. In the present invention, a Scholl reaction using FeCl₃ or a reductive reaction using potassium is preferred.

The solvent used in this step may be a non-polar solvent or a polar solvent. Examples include alkanes, such as hexane, heptane, and octane; haloalkanes, such as dichloromethane, chloroform, carbon tetrachloride, and ethylene chloride; aromatic hydrocarbons, such as benzene, toluene, xylene, mesitylene, and pentamethylbenzene; halobenzenes, such as chlorobenzene and bromobenzene; ethers, such as diethyl ether and anisole; methyl nitrate; dimethyl sulfoxide; nitromethane; and the like. These solvents can be used singly or in combination of two or more.

The reaction temperature in the ring condensation reaction is generally selected from the range of 0°C to the boiling point of the solvent. The reaction pressure in the ring condensation reaction is generally selected from the normal pressure range. The reaction time in the ring condensation reaction is generally selected from the range of 1 to 96 hours.

Further, the reaction atmosphere is not particularly limited, but is preferably an inert gas atmosphere, an argon gas atmosphere, a nitrogen gas atmosphere, or the like. An air atmosphere can also be used.

After the reaction is stopped, the desired graphene nanoribbon can be obtained through usual isolation and purification steps (removal of metal by silica gel column chromatography, separation or fractionation of the polymer by gel permeation chromatography (GPC), etc.).

### Examples

The present invention is described below in detail with reference to Examples. However, the present invention is not limited to these Examples.

Unless otherwise indicated, all materials, including dry solvents, were purchased and used without purifying them. Chlorodimethylsilane was distilled immediately before use. Unless otherwise stated, all reactions were performed with a dry solvent in a nitrogen atmosphere in oven-dried glassware by using a standard vacuum-line technique. All post-treatments and purification procedures were performed by using a reagent-grade solvent in air.

Analytical thin-layer chromatography (TLC) was performed using a plate pre-coated with E. Merck silica gel 60 F₂₅₄ (0.25 mm), and the developed chromatograms were analyzed with a UV lamp (254 nm). Open-column chromatography was performed using Kanto silica gel 60N (spherical, neutral, 40 to 100 µm) . Biotage Metal Scavenger Si-TMT was used for a metal scavenger. Preparative thin-layer chromatography (PTLC) was performed on a TLC plate prepared from a Wako-gel (registered trademark) B5-F silica-coated plate (0.75 mm), and the developed chromatograms were analyzed with a UV lamp (254 nm and 365 nm). Preparative recycle gel permeation chromatography (GPC) was performed using an LC-9210II NEXT instrument (Japan Analytical Industry Co., Ltd.) with JAIGEL-3H and 5H columns, which use CHCl₃ as an eluent at a flow rate of 3.5 ml/min, and UV and RI detectors connected in series. The molecular weight of synthetic polymers (GNRs) and their distribution were measured at 40 °C by size-exclusion chromatography (SEC) on a Shimadzu Prominence 2000 instrument with two polystyrene gel columns (TOSOH TSKgel Multipore H_{XL}-M SEC columns, 7.8 mm × 300 mm) connected in series. Tetrahydrofuran (THF) containing 0.1 mass% tetra-n-butylammonium bromide (TBAB) was used for the eluent at a flow rate of 1.0 mL/minute. Molecular weight calibration curves were obtained by using a standard polystyrene (TOSOH TSKgel polystyrene standard). Absorption and fluorescence spectra were obtained in a 1-cm quartz cell at 25 °C by using a JASCO V570 spectrophotometer and a JASCO FP-6600. Fourier transform infrared (FT-IR) spectra were recorded by using a JASCO FT/IR-6100 spectrometer in attenuated total reflection (ATR) mode. Low-temperature scanning tunneling microscopy (STM) measurements were performed by using a Unisok USS-10092LSC. High-resolution mass spectra (HRMS) were measured with a JEOL JMS-700 (fast-atom bombardment mass spectrometry, FAB-MS) by using 3-nitrobenzyl alcohol (NBA) as a matrix. MALDI-TOF mass spectra were measured with a JEOL JMS-S3000 SpiralTOF by using a polyethylene glycol mixture (PEG10000) as an external standard and trans-2-[3-(4-tert-butylphenyl)-2-methyl-2-propenylidene]malononitrile (DCTB) or 7,7,8,8-tetracyanoquinodimethane (TCNQ) as a matrix with or without the addition of AgCOCF₃ as an ionization additive. Nuclear magnetic resonance (NMR) spectra were recorded with a JEOL ECS-600 (¹H 600 MHz, ¹³C 150 MHz) spectrometer. ¹H NMR chemical shifts are expressed in parts per million (ppm) relative to tetramethylsilane (δ 0.00 ppm) or CD₂Cl₂ (δ 5.32 ppm). ¹³C NMR chemical shifts are expressed in parts per million (ppm) relative to CDCl₃ (δ 77.0 ppm) or C₂D₂Cl₄ (δ 73.78 ppm). Data were reported as follows: chemical shift, multiplicity (s = singlet, d = doublet, dd = doublet of doublets, ddd = doublet of doublet of doublets, t = triplet, td = triplet of doublets, q = quartet, m = multiplet), coupling constant (Hz), and integration.

### Measurement of Raman Spectra

Raman spectra were measured on a silicon substrate (SUMTEC) at room temperature by using a 532-nm laser. A silicon substrate was washed in ethanol using ultrasonic cleaning. A sample solution for Raman measurement was cast on the prepared silicon substrate, and the solvent was dried on the silicon substrate.

### Measurement of Fluorescence Spectra

Fluorescence spectra were measured by using a degassed sample solution in chloroform (spectral grade) in a capped 1-cm quartz cell. Unless otherwise stated, all experiments were performed at 25 °C. Before measurement, the sample solution was filtered through a 0.45-µm membrane filter.

### Measurement of MALDI-TOF Mass Spectra of Fjord and Armchair Graphene Nanoribbons

All measurements of MALDI-TOF mass spectra were performed in spiral reflection mode by using PEG 10000 as an external standard. Fjord GNR2 (Mn = 1.3×10⁴, PDI = 1.23) and GNR7 (1.2×10⁴, PDI = 1.04) were measured by using a mixture solution of 1 mg/mL graphene nanoribbon (100 µL) and 1 mg/mL DCTB (100 µL) in THF. Armchair GNR8 (Mn = 8.3×10³, PDI = 1.31) was measured by using a mixture solution of 1 mg/mL GNR8 (100 µL), 1 mg/mL TCNQ (400 µL) , and 0.1 mg/mL AgCOCF₃ (100 µL) in THF.

### Synthesis Example 1: Synthesis of 3-chloro-3-ethylundecane

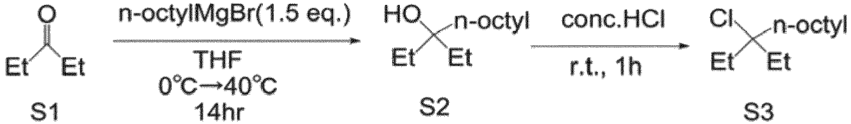

In the formula, Et represents an ethyl group, and THF represents tetrahydrofuran.

Magnesium turnings (5.8 g, 240 mmol) was added to a 200-mL two-necked round-bottom flask containing a magnetic stirrer, and the reaction vessel was heated under reduced pressure with stirring with a heat gun for 10 minutes. After the flask was cooled to room temperature, n-octyl bromide (37.1 mL, 225 mmol) and THF (100 mL) were added. To this reaction mixture, 1,2-dibromoethane (2 drops, for activation of magnesium turnings) was added, and the reaction mixture was stirred at 40 °C for 1 hour to prepare a Grignard reagent for this synthesis. 3-pentanone (compound S1; 16.0 mL, 150 mmol) and THF (100 mL) were then added to another 300-mL two-necked round-bottom flask containing a magnetic stirrer. The prepared Grignard's reagent solution was added dropwise to the ketone solution at 0 °C. The reaction mixture was then stirred at 40 °C for 14 hours. After the progress of the reaction was checked by TLC, the resulting reaction mixture was quenched with water. The organic layer was washed with a saturated aqueous NH₄Cl solution and water, dried over Na₂SO₄, filtered, and concentrated under reduced pressure, thereby obtaining 3-ethyl-3-hydroxylundecane (compound S2) as a crude product. Concentrated hydrochloric acid (35 mL) was added to a 200-mL round-bottom flask containing a magnetic stirrer and compound S2 (crude product). The reaction mixture was stirred at room temperature for 1 hour and then extracted three times with diethyl ether (100 mL). The combined organic layers were washed with brine and then dried over Na₂SO₄. After filtration, the solvent was removed under reduced pressure. Purification was performed by flash-column chromatography (eluent: hexane) on silica gel, thereby obtaining 3-chloro-3-ethylundecane (compound S3: 17.0 g).

### Synthesis Example 2: Synthesis of APEX Monomer M

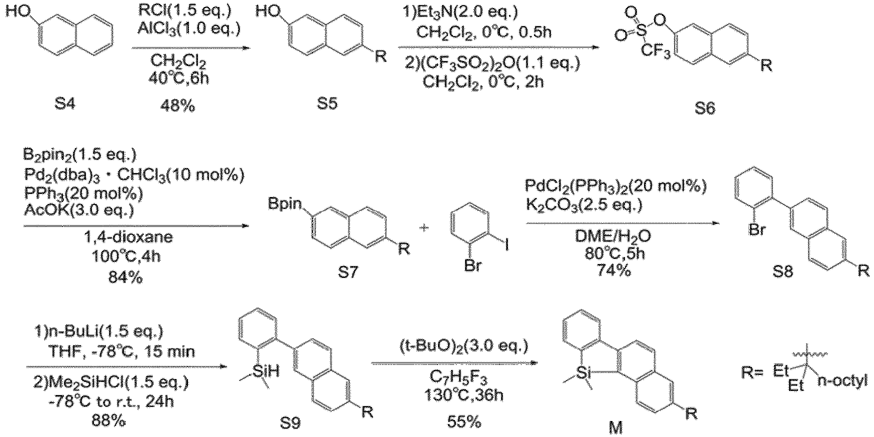

In the formula, Et represents an ethyl group, and B₂pin₂ represents bis(pinacolato)diboron. dba represents dibenzylideneacetone. Ph represents a phenyl group. AcOK represents potassium acetate. Bpin represents a pinacolatoboryl group. DME represents 1,2-dimethoxyethane. N-BuLi represents n-butyllithium. THF represents tetrahydrofuran. Me represents a methyl group. t-Bu represents a tert-butyl group. C₇H₅F₃ represents trifluoromethylbenzene.

In a nitrogen atmosphere, 2-naphthol (compound S4: 12.0 g, 83.2 mmol), 3-chloro-3-ethylundecane (compound S3: 27.3 g, 124.9 mmol), and CH₂Cl₂ (120 mL) were added to a 200-mL two-necked round-bottom flask containing a magnetic stirrer. AlCl₃ (11.0 g, 83.2 mmol) was then added at room temperature. After the mixture was stirred at 40 °C for 6 hours, the reaction was quenched with methanol (30 mL). The organic layer was washed with water, dried over Na₂SO₄, filtered, and concentrated under reduced pressure, thereby obtaining a crude product. Purification was performed by open-column chromatography (eluent: CH₂Cl₂/hexane = 4:1) on silica gel, thereby obtaining 6-(3-ethyl-3-undecyl)-2-naphthol (compound S5) as a colorless oil (13.0 g, 48%).

In a nitrogen atmosphere, compound S5 (8.00 g, 24.5 mmol) and CH₂Cl₂ (120 mL) were added to a 200-mL two-necked round-bottom flask containing a magnetic stirrer. Triethylamine (6.83 mL, 49.0 mmol) was then added to the solution at 0 °C. After the mixture was stirred at this temperature for 0.5 hours, (CF₃SO₂)₂O (4.53 mL, 26.9 mmol) was added. After further stirring at 0 °C for 2 hours, the reaction was quenched with water. The reaction mixture was extracted three times with CH₂Cl₂ (50 mL). The combined organic layers were washed with brine and then dried over Na₂SO₄. After filtration, the solvent was removed under reduced pressure, thereby obtaining a crude product. Purification was performed by open-column chromatography (eluent: CH₂Cl₂/hexane = 4:1) on silica gel, thereby obtaining 6-(3-ethyl-3-undecyl)-2-naphthyl trifluoromethanesulfonate (compound S6) as a colorless oil (6.12 g).

In a nitrogen atmosphere, compound S6 (5.00 g, 10.9 mmol), bis(pinacolato)diboron (B₂pin₂, 4.15 g, 16.4 mmol), tris(dibenzylideneacetone)dipalladium(0)·chloroform adduct (Pd₂(dba)3·CHCl₃, 1.13 g, 1.09 mmol, 10 mol%), triphenylphosphine (PPh₃, 3.63 mL, 2.18 mmol, 20 mol%), and potassium acetate (KOAc, 3.21 g, 32.7 mmol) were added to a 200-mL two-necked round-bottom flask containing 1,4-dioxane (125 mL) and a magnetic stirrer. The reaction mixture was stirred at 100 °C for 4 hours and then quenched with water. The reaction mixture was extracted three times with CH₂Cl₂ (40 mL). The combined organic layers were washed with brine and then dried over Na₂SO₄. After filtration, the solvent was removed under reduced pressure, thereby obtaining a crude product. Purification was performed by flash-column chromatography (eluent: hexane/CH₂Cl₂ = 4:1) on silica gel, thereby obtaining 2-(6-(3-ethyl-3-undecyl)-2-naphthyl)-4,4,5,5-tetramethyl-1,3,2-dioxaborolane (compound S7) as a colorless oil (4.11 g, 84%).

In a nitrogen atmosphere, compound S7 (3.15 g, 7.21 mmol), 1-bromo-2-iodobenzene (1.70 g, 6.01 mmol), dichlorobis (triphenylphosphine)palladium(2) (PdCl₂(PPh₃)₂, 84 mg, 0.12 mmol, 20 mol%) , and K₂CO₃ (2.08 g, 15.0 mmol) were added to a 200-mL two-necked round-bottom flask containing 1,2-dimethoxyethane (30 mL), water (15 mL) and a magnetic stirrer. The reaction mixture was stirred at 80 °C for 5 hours, and then 1,2-dimethoxyethane was evaporated. Water (40.0 mL) and diethyl ether (20.0 mL) were added to the mixture, and the organic layer was separated. The aqueous layer was extracted three times with diethyl ether (20 mL). The combined organic layers were washed with brine and then dried over Na₂SO₄. After filtration, the solvent was removed under reduced pressure, thereby obtaining a crude product. Purification was performed by flash-column chromatography (eluent: hexane) on silica gel, thereby obtaining 2-(2-bromophenyl)-6-(3-ethyl-3-undecyl)naphthalene (compound S8) as a colorless oil (2.50 g, 74%) .

In a nitrogen atmosphere, compound S8 (2.50 g, 5.37 mmol) and tetrahydrofuran (THF, 100 mL) were added to a 200-mL two-necked round-bottom flask containing a magnetic stirrer. Subsequently, n-butyllithium (n-BuLi, 1.6 M in n-hexane, 5.03 mL, 8.06 mmol) was added dropwise at -78 °C. After the mixture was stirred at the same temperature for 15 minutes, distilled chlorodimethylsilane (0.97 mL, 8.06 mmol) was added at -78 °C. The reaction mixture was stirred at room temperature for 24 hours and then quenched with water. The reaction mixture was extracted with diethyl ether. The combined organic layers were washed with brine and then dried over Na₂SO₄. After filtration, the solvent was removed under reduced pressure, thereby obtaining a crude product. Purification was performed by flash-column chromatography (eluent: hexane) on silica gel, thereby obtaining (2-(6-(3-ethyl-3-undecyl)-2-naphthyl)phenyl)dimethylsilane (compound S9) as a colorless oil (2.12 g, 88%).

In a nitrogen atmosphere, compound S9 (1.3 g, 2.90 mmol) and (trifluoromethyl)benzene (50 mL) were added to a 200-mL two-necked round-bottom flask containing a magnetic stirrer. Subsequently, 2-(tert-butylperoxy)-2-methylpropane (1.61 mL, 8.77 mmol) was added at room temperature. The reaction mixture was stirred at 130 °C for 36 hours. After cooling to room temperature, the reaction mixture was concentrated and then purified by silica gel column chromatography (eluent: hexane/CH₂Cl₂ = 19:1), thereby obtaining 3-(3-ethyl-3-undecyl)-11,11-dimethyl-11H-benzo[b]naphtho[2,1-d] silole (compound M) as a colorless oil (0.72 g, 55%). 3-(3-ethyl-3-undecyl)-11,11-dimethyl-11H-benzo[b]naphtho[2,1-d] silole (compound M) :
¹H-NMR (600 MHz, CDCl₃) δ 7.95 (d, J = 8.4 Hz, 1H), 7.87-7.90 (m, 2H), 7.78-7.80 (m, 1H), 7.68-7.72 (m, 2H), 7.51-7.55 (m, 1H), 7.44-7.47 (m, 1H), 7.28-7.30 (m, 1H), 1.76-1.78 (m, 2H), 1.35-1.37 (m, 2H), 1.08-1.23 (m, 12H), 0.79-0.85 (m, 9H), 0.65-0.70 (m, 3H), 0.55 (s, 6H).

¹³C NMR (150 MHz, CDCl₃) δ 148.1, 146.7, 139.2, 137.1, 136.8, 133.0, 132.6, 130.9, 130.2, 128.9, 128.4, 127.4, 126.6, 125.4, 121.0, 119.8, 31.9, 31.6, 29.72 (2C), 29.68, 29.4, 22.7, 22.2 (2C), 14.1, 11.8, -2.81.

HRMS (FAB+) m/z calcd for C₃₂H₄₃Si [M+H]⁺: 443.3129, found 443.3126.

### Synthesis Example 3: Synthesis of APEX Monomer M"

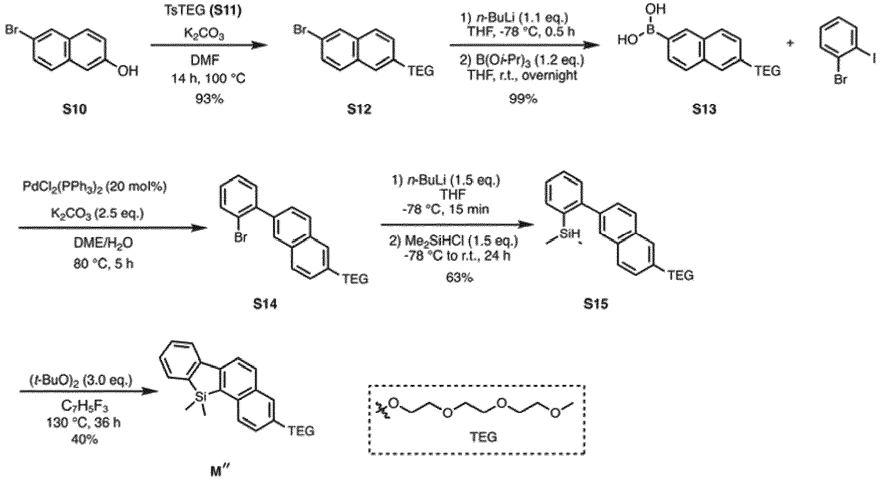

In the formula, Ts represents a tosyl group, DMF represents dimethylformamide, n-BuLi represents n-butyllithium, THF represents tetrahydrofuran, i-Pr represents an isopropyl group, Ph represents a phenyl group, DME represents 1,2-dimethoxyethane, Me represents a methyl group, t-Bu represents a tert-butyl group, and C₇H₅F₃ represents trifluoromethylbenzene.

In a nitrogen atmosphere, 2-(2-(2-methoxyethoxy)ethoxy)ethyl 4-methylbenzenesulfonate (compound S11; 13.9 g, 101 mmol), 6-bromonaphthalen-2-ol (compound S10; 7.50 g, 33.6 mmol), K₂CO₃ (13.9 g, 101 mmol), and dimethylformamide (DMF; 150 mL) were added to a 200-mL two-necked round-bottom flask containing a magnetic stirrer. After the mixture was stirred at 100 °C for 14 hours, the reaction was quenched with water (30 mL). The reaction mixture was extracted three times with ethyl acetate (EtOAc; 100 mL). The combined organic layers were washed with brine and then dried over Na₂SO₄. After filtration, the solvent was removed under reduced pressure, thereby obtaining a crude product. Purification was performed by open-column chromatography (eluent: ethyl acetate/hexane = 2:1) on silica gel, thereby obtaining 2-bromo-6-(2-(2-(2-methoxyethoxy)ethoxy)ethoxy)naphthalene (compound S12) as a colorless oil (11.5 g, 93%).

In a nitrogen atmosphere, compound S12 (5.00 g, 13.5 mmol) and tetrahydrofuran (THF, 135 mL) were added to a 200-mL two-necked round-bottom flask containing a magnetic stirrer. Subsequently, n-butyllithium (n-BuLi, 1.6 M in n-hexane, 9.34 mL, 14.9 mmol) was added dropwise at -78 °C. The mixture was stirred at the same temperature for 10 minutes, and then triisopropoxyborane (B(Oi-Pr)₃, 1.94 mL, 16.3 mmol) was added at - 78 °C. The reaction mixture was stirred at room temperature overnight and then quenched with 1 N HC1. The reaction mixture was extracted with ethyl acetate. The combined organic layers were washed with brine and then dried over Na₂SO₄. After filtration, the solvent was removed under reduced pressure, thereby obtaining a crude product. Purification was performed by flash-column chromatography (eluent: ethyl acetate/hexane = 2:1) on silica gel, thereby obtaining (6-(2-(2-(2-methoxyethoxy)ethoxy)ethoxy)naphthalen-2-yl)boronic acid (compound S13) as a colorless oil (4.5 g, 99%).

In a nitrogen atmosphere, compound S13 (4.50 g, 13.5 mmol), 1-bromo-2-iodobenzene (2.31 mL, 16.4 mmol), dichlorobis(triphenylphosphine) palladium(2) (PdCl₂(PPh₃)₂, 210 mg, 0.29 mmol, 20 mol%), and K₂CO₃ (4.14 g, 29.9 mmol) were added to a 200-mL two-necked round-bottom flask containing 1,2-dimethoxyethane (150 mL), water (20 mL), and a magnetic stirrer. The reaction mixture was stirred at 80 °C for 5 hours, and then 1,2-dimethoxyethane was evaporated. Water (40 mL) and ethyl acetate (50 mL) were added, and the organic layer was separated. The aqueous layer was extracted with ethyl acetate (50 mL) three times. The combined organic layers were washed with brine and then dried over Na₂SO₄. After filtration, the solvent was removed under reduced pressure, thereby obtaining a crude product. Purification was performed by flash-column chromatography (eluent: ethyl acetate) on silica gel, thereby obtaining 2-(2-bromophenyl)-6-(2-(2-(2-methoxyethoxy)ethoxy)ethoxy)naphthalene (compound S14) as a colorless oil (4.6 g).

In a nitrogen atmosphere, compound S14 (5.0 g, 11.2 mmol) and tetrahydrofuran (THF, 100 mL) were added to a 200-mL two-necked round-bottom flask containing a magnetic stirrer. Subsequently, n-butyllithium (n-BuLi, 1.6 M in n-hexane, 10.1 mL, 10.7 mmol) was added dropwise at -78 °C. The mixture was stirred at this temperature for 15 minutes, and then distilled chlorodimethylsilane (1.79 mL, 16.1 mmol) was added at -78 °C. The reaction mixture was stirred at room temperature for 24 hours and quenched with water. The reaction mixture was extracted with diethyl ether. The combined organic layers were washed with brine and then dried over Na₂SO₄. After filtration, the solvent was removed under reduced pressure, thereby obtaining a crude product. Purification was performed by flash-column chromatography (eluent: hexane) on silica gel, thereby obtaining (2-(6-(2-(2-(2-methoxyethoxy)ethoxy)ethoxy)naphthalen-2-yl)phenyl)dimethylsilane (compound S15) as a colorless oil (3.00 g, 63%).

In a nitrogen atmosphere, compound S15 (0.1 g, 0.22 mmol) and (trifluoromethyl)benzene (5.0 mL) were added to a 200-mL two-necked round-bottom flask containing a magnetic stirrer. Subsequently, 2-(tert-butylperoxy)-2-methylpropane (0.12 mL, 0.67 mmol) was added at room temperature. The reaction mixture was stirred at 130 °C for 36 hours. After cooling to room temperature, the reaction mixture was concentrated and then purified by column chromatography on silica gel (eluent: hexane), thereby obtaining 3-(2-(2-(2-methoxyethoxy)ethoxy)ethoxy)-11,11-dimethyl-11H-benzo[b]naphtho[2,1-d]silole (compound M") as a colorless oil (40 mg, 40%).

3-(2-(2-(2-methoxyethoxy)ethoxy)ethoxy)-11,11-dimethyl-11H-benzo[b]naphtho[2,1-d]silole (compound M"):
¹H-NMR (600 MHz, CD₂Cl₂) δ 7.91 (d, J = 9.0 Hz, 1H), 7.80-7.84 (m, 4H), 7.75 (d, J = 9.0 Hz, 1H), 7.65 (d, J = 7.8 Hz, 1H), 7.42 (t, 1H), 7.26 (t, 1H), 7.21-7.19 (m, 2H), 4.23 (t, J = 4.8 Hz, 2H), 3.87 (m, 2H), 3.69 (m, 2H), 3.62 (m, 2H), 3.58 (m, 2H), 3.49 (m, 2H), 3.37 (s, 3H), 0.56 (s, 6H).

¹³C NMR (150 MHz, CD₂Cl₂) δ 157.0, 148.6, 139.1, 137.5, 134.6, 133.0, 132.7, 130.6, 130.3, 130.1, 127.4, 120.9, 120.5, 119.9, 108.3, 72.3, 71.2, 71.0, 70.8, 70.0, 68.0, 59.0, -2.67.

HRMS (FAB+) m/z calcd for C₂₅H₃₀O₄Si [M]⁺: 422.1913, found 422.1915.

### Synthesis Example 4: Synthesis of APEX Monomer M‴

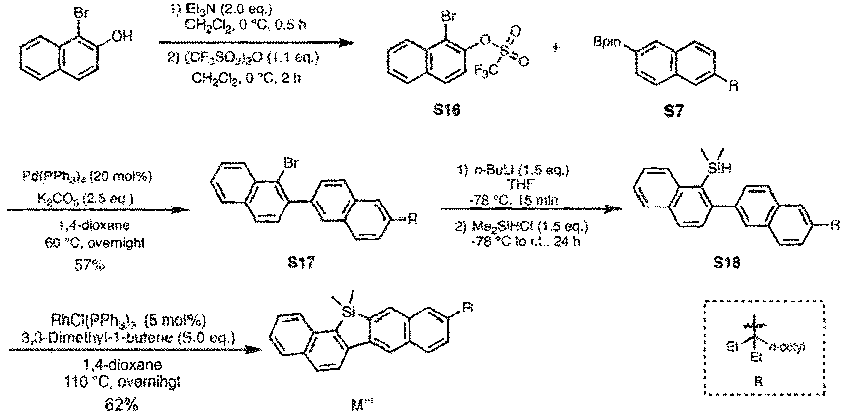

In the formula, Et represents an ethyl group, Bpin represents a pinacolatoboryl group, Ph represents a phenyl group, N-BuLi represents n-butyllithium, THF represents tetrahydrofuran, Me represents a methyl group, and i-Pr represents an isopropyl group.

In a nitrogen atmosphere, 1-bromonaphthalen-1-ol (4.00 g, 17.9 mmol) and dichloromethane (170 mL) were added to a 300-mL two-necked round-bottom flask containing a magnetic stirrer. Subsequently, triethylamine (5,0 mL, 36 mmol) was added dropwise at 0 °C. Thereafter, triethylamine (6.83 mL, 49.0 mmol) was added at 0 °C. After the mixture was stirred at this temperature for 0.5 hours, (CF₃SO₂)₂O (3.32 mL, 19.7 mmol) was added. After the mixture was further stirred at 0 °C for 2 hours, the reaction was quenched with water. The reaction mixture was extracted with CH₂Cl₂ (50 mL) three times. The combined organic layers were washed with brine and then dried over Na₂SO₄. After filtration, the solvent was removed under reduced pressure, thereby obtaining a crude product. Purification was performed by open-column chromatography (eluent: CH₂Cl₂/hexane = 4:1) on silica gel, thereby obtaining 1-bromo-2-naphthyltrifluoromethanesulfonate (compound S16) as a white solid (6.0 g).

In a nitrogen atmosphere, compound S16 (2.50 g, 7.04 mmol), compound S7 (3.00 g, 67.04 mmol), triphenylphosphine (PPh₃, 1.65 mg, 1.41 mmol, 20 mol%), K₂CO₃ (0.97 g, 7.04 mmol), and 1,4-dioxane (70 mL) were added to a 200-mL two-necked round-bottom flask containing a magnetic stirrer. The reaction mixture was stirred at 80 °C for 12 hours, and then 1,4-dioxane was evaporated. Water (40.0 mL) and diethyl ether (20.0 mL) were added, and the organic layer was separated. The aqueous layer was extracted with diethyl ether (20 mL) three times. The combined organic layers were washed with brine and then dried over Na₂SO₄. After filtration, the solvent was removed under reduced pressure, thereby obtaining a crude product. Purification was performed by flash-column chromatography (eluent: hexane) on silica gel, thereby obtaining 1-bromo-6'-(3-ethyl-3-undecyl)2,2'-binaphthalene (compound S17) as a colorless oil (2.10 g, 57%).

In a nitrogen atmosphere, compound S17 (2.00 g, 3.88 mmol) and tetrahydrofuran (THF, 40 mL) were added to a 200-mL two-necked round-bottom flask containing a magnetic stirrer. Subsequently, n-butyllithium (n-BuLi, 1.6 M in n-hexane, 3.64 mL, 5.82 mmol) was added dropwise at -78 °C. The mixture was stirred at this temperature for 15 minutes, and distilled chlorodimethylsilane (0.65 mL, 5.82 mmol) was added at -78 °C. The reaction mixture was stirred at room temperature for 24 hours and then quenched with water. The reaction mixture was extracted with diethyl ether. The combined organic layers were washed with brine and then dried over Na₂SO₄. After filtration, the solvent was removed under reduced pressure, thereby obtaining a crude product. Purification was performed by flash-column chromatography (eluent: hexane) on silica gel, thereby obtaining (6'-(3-(3-ethyl-3-undecyl)-(2,2'-binaphthyl)dimethylsilane (compound S18) as a colorless oil (1.5 g).

In a nitrogen atmosphere, compound S18 (0.50 g, 1.01 mmol), chlorotristriphenylphosphine rhodium (RhCl(PPh₃), 46 mg, 5 mol%), 3,3-dimethyl-1-butene (0.65 mL, 75.05 mmol), and 1,4-dioxane (2 mL) were added to a 30-mL two-necked round-bottom flask containing a magnetic stirrer. The reaction mixture was stirred at 110 °C for 12 hours, and then 1,2-dioxane was evaporated. Water (40.0 mL) and diethyl ether (20.0 mL) were added, and the organic layer was separated. The aqueous layer was extracted with diethyl ether (20 mL) three times. The combined organic layers were washed with brine and then dried over Na₂SO₄. After filtration, the solvent was removed under reduced pressure, thereby obtaining a crude product. Purification was performed by flash-column chromatography (eluent: hexane) on silica gel, thereby obtaining 3-(3-ethyl-3-undecyl)-13,13-dimethyl-13H-dinaphtho[1,2,-b:2',3',-d]silole (compound M‴) as a colorless oil (0.31 g, 62%).

¹H-NMR (600 MHz, CDCl₃) δ 10.58 (s, 1H), 10.48-10.46 (m, 2H), 10.30 (d, J = 8.4 Hz, 1H), 10.23-10.21 (m, 2H), 10.16 (d, J = 9 Hz, 1H), 10.02 (s, 1H), 9.88-9.87 (m, 3H), 4.13-3.90 (m, 4H), 3.58-3.52 (m, 2H), 3.28-2.98 (m, 9H), 2.33 (s, 6H).

¹³C NMR (150 MHz, CD₂Cl₂) δ 147.0, 146.2, 144.2, 137.9, 137.2, 137.0, 133.6, 133.2, 133.0, 131.2, 119.0, 128.7, 128.1, 126.8, 126.2, 125.7, 125.5, 120.3, 118.8, 43.6, 43.0, 35.9, 32.0, 30.6, 29.7, 29.4, 24.3, 22.8, 17.8, 15.0, 14.2, 8.8, -2.07.

HRMS (FAB+) m/z calcd for C₃₅H₄₄Si [M]⁺: 492.3212, found 492.3209.

### Synthesis Example 5: Synthesis of Halogen-containing Silole

### Compound S23

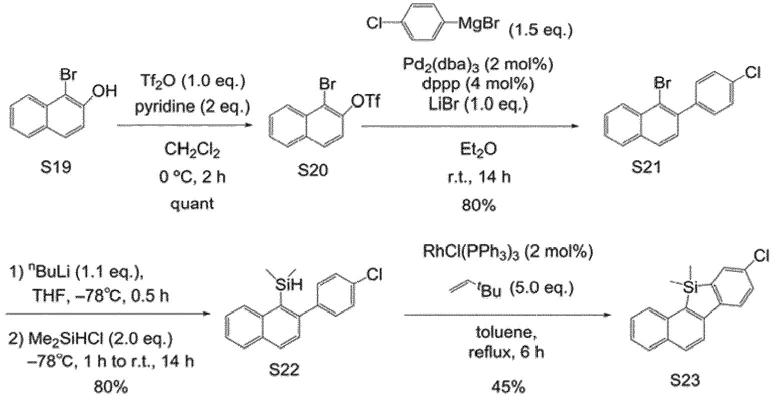

In the formula, Tf represents a trifluoromethanesulfonyl group, Me represents a methyl group, ⁿBu represents a n-butyl group, ^{t}Bu represents a tert-butyl group, Ph represents a phenyl group, dppp represents 1,3-bis(diphenylphosphino)propane, dba represents dibenzylideneacetone, and THF represents tetrahydrofuran.

In a nitrogen atmosphere, 1-bromo-2-naphthol (compound S19, 13.4 g, 60 mmol) and CH₂Cl₂ (120 mL) were added to a 300-mL two-necked round-bottom flask containing a magnetic stirrer. Pyridine (9.7 mL, 120 mmmol) was then added at 0 °C. The mixture was stirred at this temperature for 10 minutes, and then trifluoromethanesulfonic anhydride (Tf₂O, 10.0 mL, 60 mmol) was added. After further stirring at 0 °C for 2 hours, the reaction was quenched with water. The reaction mixture was extracted with ethyl acetate (50 mL) three times. The combined organic layers were washed with brine and then dried over Na₂SO₄. After filtration, the solvent was removed under reduced pressure, thereby obtaining a crude product. The crude product was purified by chromatography on silica gel (eluent: hexane), thereby obtaining 1-bromo-2-naphthyltrifluoromethanesulfonate (compound S20) as a brown oil (21.2 g, >99%).

In a nitrogen atmosphere, magnesium turnings (2.7 g, 109 mmol) was added to a 100-mL two-necked round-bottom flask containing a magnetic stirrer, and the reaction vessel was heated under reduced pressure with stirring by using a heat gun for 10 minutes. After the flask was cooled to room temperature, 1-bromo-4-chlorobenzene (15.7 g, 82 mmol) and diethyl ether (Et₂O, 54 mL) were added. A Grignard reagent for this synthesis was prepared by stirring this reaction mixture at room temperature for 30 minutes. Compound S20 (19.4 g, 55 mmol), tris(dibenzylideneacetone)dipalladium (Pd₂(dba)₃, 1.0 g, 1 mmol), 1,3-bis(diphenylphosphino)propane (dppp, 0.84 g, 2 mmol), LiBr (4.7 g, 55 mmol), and Et₂O (27 mL) were added to another 100-mL two-necked round-bottom flask containing a magnetic stirrer. To this reaction mixture, the separately prepared Grignard reagent was added dropwise at 0 °C with stirring. After completion of the dropwise addition, the reaction mixture was heated to room temperature, stirred at room temperature for 14 hours, and quenched with 1M HC1, followed by extraction with ethyl acetate (50 mL) three times. The combined organic layers were washed with brine and then dried over Na₂SO₄. After filtration, the solvent was removed under reduced pressure, thereby obtaining a crude product. The crude product was recrystallized with ethyl acetate, thereby obtaining 1-bromo-2-(4-chlorophenyl)naphthalene (compound S21) as pale yellow crystals (13.79 g, 80%).

In a nitrogen atmosphere, compound S21 (3.2 g, 10 mmol) and tetrahydrofuran (THF, 50 mL) were added to a 100-mL two-necked round-bottom flask containing a magnetic stirrer. After the reaction mixture was cooled to -78 °C, n-butyllithium (n-BuLi, 1.6 M in n-hexane, 7.0 mL, 11 mmol) was added dropwise to the reaction mixture with stirring at -78 °C. The reaction mixture was stirred at the same temperature for 30 minutes, then chlorodimethylsilane (1.4 mL, 20 mmol) was added at -78 °C, and the mixture was stirred at the same temperature for 1 hour. After stirring, the mixture was heated to room temperature, stirred at room temperature for 14 hours, and then quenched with cold water, followed by extraction with diethyl ether (Et₂O, 50 mL) three times. The combined organic layers were washed with brine and then dried over Na₂SO₄. After filtration, the solvent was removed under reduced pressure, thereby obtaining a crude product. The crude product was recrystallized with hexane, thereby obtaining (2-(4-chlorophenyl)-1-dimethylsilylnaphthalene (compound S22) as pale yellow crystals (2.38 g, 80%).

In a nitrogen atmosphere, compound S22 (1.0 g, 3.4 mmol), tris(triphenylphosphine)rhodium(I) chloride (RhCl(PPh₃)₃, 62 mg, 0.07 mmol), 3,3-dimethyl-1-butene (2.2 mL, 16.8 mmol), and toluene (3.4 mL) were added to a 20-mL round-bottom flask containing a magnetic stirrer. The reaction mixture was heated and stirred under reflux (bath temperature: 130 °C) for 4 hours. After cooling to room temperature, the solvent was removed under reduced pressure, thereby obtaining a crude product. The obtained crude product was purified by chromatography on silica gel (eluent: hexane), thereby obtaining 9-chloro-11,11-dimethyl-11H-benzo[b]naphtho[2,1-d]silole (compound S23) as colorless crystals (450 mg, 45%).

¹H-NMR (400 MHz, CDCl₃) δ 7.92 (d, J = 5.4 Hz, 2H), 7.89-7.84 (m, 1H), 7.84-7.81 (m, 1H), 7.79 (d, J = 8.4 Hz, 1H), 7.61 (d, J = 2.0 Hz, 1H), 7.55-7.49 (m, 1H), 7.49-7.44 (m, 1H), 7.42 (dd, J 8.4, 2.0 Hz, 1H), 0.59 (s, 6H).

¹³C-NMR (100 MHz, CDCl₃) δ 146.3, 145.7, 141.6, 136.8, 136.6, 133.5, 133.0, 132.5, -2.8, -3.0.

HRMS (FAB+) m/z calcd for C₁₈H₁₅ClSi [M+]⁺: 294.0632, found 294.0659.

### Synthesis Example 6: Synthesis of APEX Monomer M3

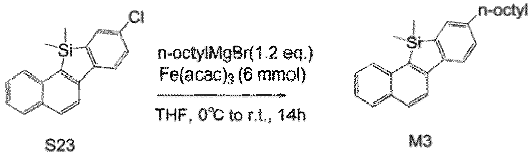

In the formula, n-octyl represents an n-octyl group, acac represents an acetylacetonate group, and THF represents tetrahydrofuran.

In a nitrogen atmosphere, compound S23 (147 mg, 0.5 mmol), tris(acetylacetonato)iron(III) (Fe(acac)₃, 9 mg, 0.03 mmol), tetrahydrofuran (THF, 3.0 mL), and N-methyl-2-pyrrolidone (NMP, 0.2 mL) were added to a 20-mL round-bottom flask containing a magnetic stirrer. n-Octylmagnesium bromide (1.0 M in THF, 0.6 mL, 0.6 mmol) was added to the reaction mixture at 0 °C. The mixture was then heated to room temperature, stirred at room temperature for 14 hours, and quenched with water, followed by extraction with ethyl acetate (5 mL) three times. The combined organic layers were washed with brine and then dried over Na₂SO₄. After filtration, the solvent was removed under reduced pressure, thereby obtaining a crude product. The obtained crude product was purified by chromatography on silica gel (eluent: hexane), thereby obtaining (11,11-dimethyl-9-octyl-11H-benzo[b]naphtho[2,1-d]silole (compound M3) as colorless crystals (64 mg, 34%).

¹H-NMR (400 MHz, CDCl₃) δ 7.96 (d, J = 7.9 Hz, 1H), 7.91 (d, J = 7.9 Hz, 1H), 7.84 (t, J = 7.9 Hz, 2H), 7.80 (d, J = 7.9 Hz, 1H), 7.56-7.49 (m, 2H), 7.43 (t, J = 7.9 Hz, 1H), 7.32-7.27 (m, 1H), 2.66 (t, J = 7.9 Hz, 2H), 1.66 (quin, J = 7.9 Hz, 2H), 1.46-1.24 (t, J = 6.8 Hz, 3H), 0.58 (s, 6H).

¹³C-NMR (100 MHz, CDCl₃) δ 146.9, 145.7, 142.2, 139.2, 136.8, 136.6, 132.85, 132.81, 130.8, 130.3, 128.9, 128.3, 126.5, 125.1, 120.8, 119.7, 36.0, 31.9, 31.7, 29.5(2C), 29.3, 22.7, 14.1, - 2.7(2C).

HRMS (FAB+) m/z calcd for C₂₆H₃₂Si [M+]⁺: 372.2273, found 372.2285.

### Synthesis Example 7: Synthesis of APEX Monomer M4

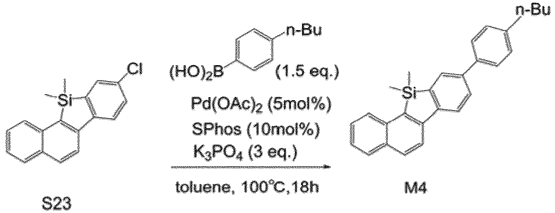

In the formula, n-Bu represents an n-butyl group, Ac represents an acetyl group, and SPhos represents a compound represented by the following formula (2-dicyclohexylphosphino-2',6'-dimethoxybiphenyl).

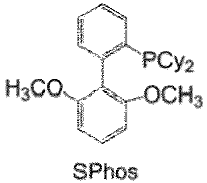

In formula, Cy represents a cyclohexyl group.

In a nitrogen atmosphere, compound S23 (147 mg, 0.5 mmol), n-butylphenylboronic acid (133 mg, 0.75 mmol), palladium acetate (Pd(OAc)₂, 6 mg, 0.025 mmol), 2-dicyclohexylphosphino-2',6'-dimethoxybiphenyl (SPhos, 21 mg, 0.05 mmol), K₃PO₄ (318 mg, 1.5 mmol), and toluene (1 mL) were added to a 20-mL round-bottom flask containing a magnetic stirrer. The reaction mixture was heated to 100 °C, stirred at the same temperature for 18 hours, and quenched with water, followed by extraction with ethyl acetate (5 mL) three times. The combined organic layers were washed with brine and then dried over Na₂SO₄. After filtration, the solvent was removed under reduced pressure, thereby obtaining a crude product. The obtained crude product was purified by chromatography on silica gel (eluent: hexane), thereby obtaining 9-(4-butylphenyl)-11,11-dimethyl-11H-benzo[b]naphtho[2,1-d]silole (compound M4) as colorless crystals (128 mg, 65%).

¹H-NMR (400 MHz, CDCl₃) δ 8.03-7.91 (m, 3H), 7.91-7.83 (m, 3H), 7.69 (dd, J = 7.9, 1.8 Hz, 1H), 7.59 (d, J = 8.2 Hz, 2H), 7.59 (d, J = 8.2 Hz, 2H), 7.55-7.49 (m, 1H), 7.48-7.42 (m, 1H), 7.28 (d, J = 8.2 Hz, 2H), 2.66 (t, J = 7.5, 2H), 1.66 (quin, J = 7.5 Hz, 2H), 1.41 (sex, J = 7.5 Hz, 2H), 0.96 (t, J = 7.5 Hz, 3H), 0.62 (s, 6H)

¹³C-NMR (100 MHz, CDCl₃) δ 146.9, 146.5, 142.1, 140.2, 139.8, 138.5, 137.1, 136.8, 133.0, 131.3, 131.0, 128.95, 128.91, 128.86 (2C), 128.4, 126.9, 126.7, 125.4, 121.3, 119.8, 35.3, 33.7, 22.4, 14.0, -2.75.

HRMS (FAB+) m/z calcd for C₂₈H₂₈Si [M+]⁺: 392.1960, found 392.1960.

In the following Examples 1 to 4, 6, 8, 10, and 11, the yield was calculated from the theoretical molecular weight of each product based on the assumption that the initiator and the monomer are reacted without excess or deficiency. In Examples 5, 7 and 9, the number of hydrogen atoms that could be eliminated by the Scholl reaction was determined from the number average molecular weight of the raw materials, and the yield was calculated from the theoretical molecular weight of the product and the theoretical yield.

### Example 1: APEX Polymerization by Initiator I - Part 1

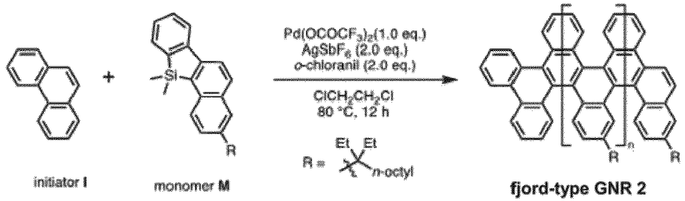

In the formula, Et represents an ethyl group, and n-octyl represents an n-octyl group.

In a nitrogen atmosphere, initiator I (0.40 mg, 2.25 µmol, 0.01 equivalents), monomer M (100 mg, 225 µmol, 1.00 equivalent), Pd(OCOCF₃)₂ (75.1 mg, 225 µmol, 1.00 equivalent), AgSbF₆ (77.6 mg, 450 µmol, 2.00 equivalents), o-chloranil (110 mg, 450 µmol, 2.00 equivalents), and 1,2-dichloroethane (2.3 mL) were added to a 5-mL Schlenk tube containing a magnetic stirrer. After the mixture was stirred at 80 °C for 12 hours, the reaction mixture was cooled to room temperature and passed through a short pad of silica gel. The reaction mixture was then passed through a metal scavenger while being washed with CH₂Cl₂. The solvent was removed under reduced pressure, thereby obtaining a crude product. The crude polymer was analyzed by size exclusion chromatography (SEC) by using a 0.1 mass% solution of tetra-n-butylammonium bromide (TBAB) in tetrahydrofuran as an eluent, and calculation resulted in Mn = 3.2 × 10⁴ with Mw/Mn (PDI) = 1.25. Purification was performed by gel permeation chromatography (GPC) by using chloroform as an eluent, thereby obtaining GNR2, which is a fjord graphene nanoribbon, as black powder (88.0 mg, 85%). Living APEX polymerization reaction performed under the same reaction conditions with an I/M ratio of 1:10, 1:50, 1:300, and 1:500, instead of 1:100, respectively resulted in Mn (Mw/Mn) of 2.9×10³ (1.25), 1.3×10⁴ (1.23), 9.7×10⁴ (1.22), and 1.5×10⁵ (1.22). Fjord graphene nanoribbon GNR2 (Mn = 2.9×10³, Mw/Mn = 1.25, degree of polymerization (DP) = 7, length: 3 nm, yield: 75%):
¹H NMR (600 MHz, Cl₂CDCDCl₂, 120 °C) δ 11.00-8.40(br), 8.40-6.30(br), 2.40-0.00(br) .

Fjord graphene nanoribbon GNR2 (Mn = 1.3×10⁴, Mw/Mn = 1.23, degree of polymerization (DP) = 34, length: 15 nm, yield: 72%):
¹H NMR (600 MHz, Cl₂CDCDCl₂, 120 °C) δ 11.00-8.40(br), 8.40-6.20(br), 3.00-0.00(br).

Fjord graphene nanoribbon GNR2 (Mn = 3.2×10⁴, Mw/Mn = 1.25, degree of polymerization (DP) = 83, length: 36 nm, yield: 85%):
¹H NMR (600 MHz, Cl₂CDCDCl₂, 120 °C) δ 11.00-8.40(br), 8.40-6.10(br), 2.40-0.00(br).

Fjord graphene nanoribbon GNR2 (Mn = 9.7×10⁴, Mw/Mn = 1.22, degree of polymerization (DP) = 253, length: 109 nm, yield: 86%):
¹H NMR (600 MHz, Cl₂CDCDCl₂, 120 °C) δ 11.00-8.40(br), 8.40-6.10(br), 2.30-0.00(br).

Fjord graphene nanoribbon GNR2 (Mn = 1.5×10⁵, Mw/Mn = 1.22, degree of polymerization (DP) = 391, length: 169 nm, yield: 82%):
¹H NMR (600 MHz, Cl₂CDCDCl₂, 120 °C) δ 11.00-8.50(br), 8.50-6.20(br), 2.80-0.00(br).

From the above results, it can be understood that GNR2 has a narrow polydispersity in various I/M ratios. It is also understood that the length-controlled synthesis of fjord graphene nanoribbons is possible by simply changing the I/M ratio. However, Mw/Mn was almost constant irrespective of the I/M ratio.

### Example 2: Synthesis of Block Fjord Graphene Nanoribbon GNR5

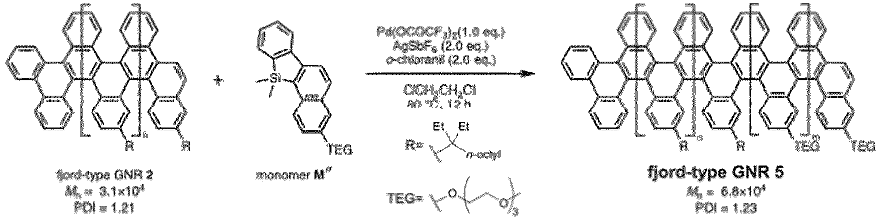

In the formula, Et represents an ethyl group, and n-octyl represents an n-octyl group.

In a nitrogen atmosphere, fjord graphene nanoribbon GNR2 (0.70 mg, 1.78 µmol, 0.01 equivalents), monomer M" (70 mg, 178 µmol, 1.00 equivalent), Pd(OCOCF₃)₂ (59.3 mg, 178 µmol, 1.00 equivalent), AgSbF₆ (122 mg, 356 µmol, 2.00 equivalents), o-chloranil (87.7 mg, 356 µmol, 2.00 equivalents), and 1,2-dichloroethane (1.8 mL) were added to a 5-mL Schlenk tube containing a magnetic stirrer. After the mixture was stirred at 80 °C for 12 hours, the reaction mixture was cooled to room temperature and passed through a short pad of silica gel. The reaction mixture was then passed through a metal scavenger while being washed with CH₂Cl₂. The solvent was removed under reduced pressure, thereby obtaining a crude product. The crude polymer was analyzed by size exclusion chromatography (SEC) by using a 0.1 mass% solution of tetra-n-butylammonium bromide (TBAB) in tetrahydrofuran as an eluent, and calculation resulted in Mn = 6.8 × 10⁴ with Mw/Mn (PDI) of 1.23. Purification was performed by gel permeation chromatography (GPC), thereby obtaining GNR5, which was a fjord graphene nanoribbon, as black powder (65.0 mg, 63%) .

¹H NMR (600 MHz, Cl₂CDCDCl₂, 120 °C) δ 9.50-8.40(br), 8.40-6.30(br), 5.00-3.00(br), 2.40-0.00(br).

### Example 3: One-step Synthesis of Block Fjord Graphene Nanoribbon GNR5

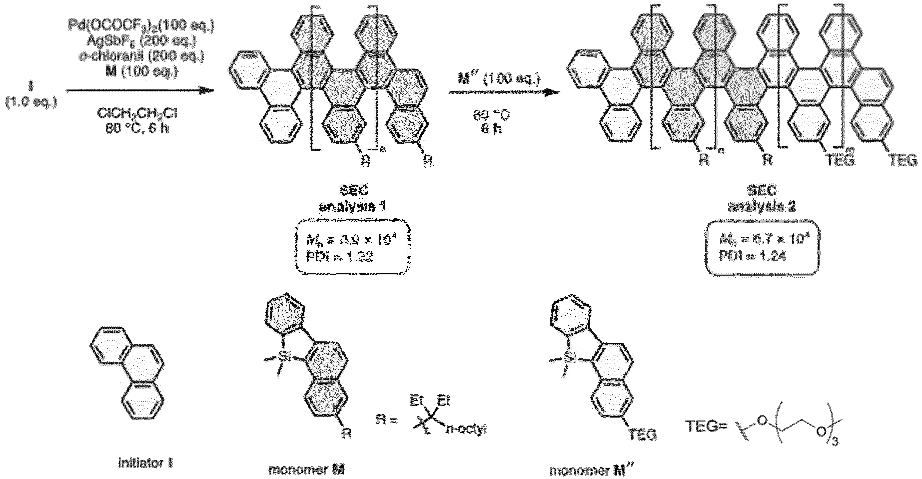

In the formula, Et represents an ethyl group, n-octyl represents an n-octyl group, SEC analysis 1 indicates GNR2, and SEC analysis 2 indicates GNR5.

In a nitrogen atmosphere, initiator I (0.20 mg, 1.13 µmol, 1.00 equivalent), monomer M (50 mg, 113 µmol, 100 equivalents), Pd(OCOCF₃)₂ (75.1 mg, 225 µmol, 200 equivalents), AgSbF₆ (155 mg, 452 µmol, 400 equivalents), o-chloranil (201 mg, 450 µmol, 400 equivalents), and 1,2-dichloroethane (2.3 mL) were added to a 5-mL Schlenk tube containing a magnetic stirrer. After the mixture was stirred at 80 °C for 6 hours, a small amount of the reaction mixture was subjected to the first size exclusion chromatography (SEC) analysis to confirm the formation of fjord graphene nanoribbon GNR2 (Mn = 3.0×10⁴, Mw/Mn = 1.22). Subsequently, a solution of monomer M" (48 mg, 113 µmol, 100 equivalents) in 1,2-dichloroethane (0.5 mL) was added to the reaction mixture, and the reaction mixture was further stirred at 80 °C for 6 hours. The reaction mixture was cooled to room temperature, and the crude product was subjected to the second size exclusion chromatography (SEC) analysis to confirm the formation of block fjord graphene nanoribbon GNR5 (Mn = 6.7×10⁴, Mw/Mn = 1.24).

### Example 4: APEX Polymerization by Using Initiator I' - Part 1

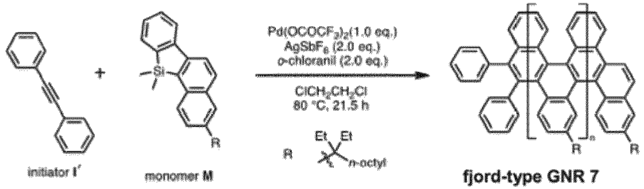

In the formula, Et represents an ethyl group, and n-octyl represents an n-octyl group.

In a nitrogen atmosphere, monomer M (30.0 mg, 67.8 µmol, 1.00 equivalent), Pd(OCOCF₃)₂ (22.5 mg, 67.8 µmol, 1.00 equivalent), AgSbF₆ (46.6 mg, 135 µmol, 2.00 equivalents), and o-chloranil (33.3 mg, 135 µmol, 2.00 equivalents) were added to a 5-mL Schlenk tube containing a magnetic stirrer. A solution of initiator I' (0.12 mg, 6.78 µmol, 0.01 equivalents) in 1,2-dichloroethane (0.1 mL) was added to the reaction mixture, and then 1,2-dichloroethane (0.57 mL) was added. After the mixture was stirred at 80 °C for 21.5 hours, the reaction mixture was cooled to room temperature and passed through a short pad of silica gel, followed by passing the reaction mixture through a metal scavenger while washing it with CH₂Cl₂. The solvent was removed under reduced pressure, thereby obtaining a crude product. The crude polymer was analyzed by size exclusion chromatography (SEC) by using a 0.1 mass% solution of tetra-n-butylammonium bromide (TBAB) in tetrahydrofuran as an eluent, and calculation resulted in Mn = 3.0 × 10⁴ with Mw/Mn (PDI) = 1.04. Purification was performed by gel permeation chromatography (GPC), thereby obtaining GNR7, which is a fjord graphene nanoribbon, as black powder (21.3 mg, 83%). Living APEX polymerization reaction performed under the same reaction conditions with an I'/M ratio of 1:50, 1:300, and 1:500, instead of 1:100, respectively resulted in Mn (Mw/Mn) of 1.2×10⁴ (1.04), 9.6×10⁴ (1.03), and 1.5×10⁵ (1.04). Fjord graphene nanoribbon GNR7 (Mn = 1.2×10⁴, Mw/Mn = 1.04, degree of polymerization (DP) = 34, length: 14 nm, yield: 76%):
¹H NMR (600 MHz, Cl₂CDCDCl₂, 120 °C) δ 10.50-8.40(br), 8.40-6.30(br), 2.40-0.00(br).

Fjord graphene nanoribbon GNR7 (Mn = 3.0×10⁴, Mw/Mn = 1.04, degree of polymerization (DP) = 80, length: 35 nm, yield: 83%):
¹H NMR (600 MHz, Cl₂CDCDCl₂, 120 °C) δ 10.50-8.40(br), 8.40-6.30(br), 2.40-0.00(br).

Fjord graphene nanoribbon GNR7 (Mn = 9.6×10⁴, Mw/Mn = 1.03, degree of polymerization (DP) = 254, length: 108 nm, yield: 70%):
¹H NMR (600 MHz, Cl₂CDCDCl₂, 120 °C) δ 10.50-8.40(br), 8.40-6.50(br), 2.40-0.00(br).

Fjord graphene nanoribbon GNR7 (Mn = 1.5×10⁵, Mw/Mn = 1.04, degree of polymerization (DP) = 391, length: 169 nm, yield: 72%):
¹H NMR (600 MHz, Cl₂CDCDCl₂, 120 °C) δ 10.50-8.40(br), 8.40-6.30(br), 3.00-0.00(br).

From the above results, it can be understood that GNR7 has a narrow polydispersity in various I'/M ratios. It is also understood that the length-controlled synthesis of fjord graphene nanoribbons is possible by simply changing the I/M ratio. However, Mw/Mn was constant irrespective of the ratio. Additionally, very small Mw/Mn ratios were obtained in various I'/M ratios.

The MALDI-TOF mass spectrum of the obtained GNR7 (Mn = 1.2×10⁴, Mw/Mn = 1.04) was measured by using trans-2-[3-(4-tert-butylphenyl)-2-methyl-2-propenylidene]malononitrile (DCTB) as a matrix. Fig. 1 shows the results. The results indicate that the degree of polymerization n was distributed in the range of 23 to 30, with n = 26 being the most dominant distribution.

### Example 5: Synthesis of Armchair Graphene Nanoribbon GNR8

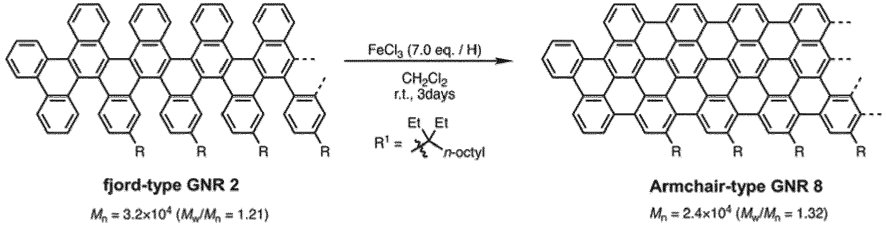

In the formula, Et represents an ethyl group, and n-octyl represents an n-octyl group.

In a nitrogen atmosphere, fjord graphene nanoribbon GNR2 (30 mg, 30 µmol, Mn = 3.2×10⁴ and Mw/Mn = 1.21) and CH₂Cl₂ (120 mL) were added to a 200-mL two-necked round-bottom flask containing a magnetic stirrer. A suspension of iron(III) chloride (1.75 g, 10.8 mmol, 7 equivalents based on the estimated hydrogen atoms over the fjord region by Mn) and nitromethane (15 mL) were added to this solution. After the mixture was stirred at room temperature for 72 hours, methanol was added to quench the reaction, thereby obtaining dark red precipitates. After suction filtration, the precipitates were washed with methanol, thereby obtaining armchair graphene nanoribbon GNR8 as dark brown powder (28.5 mg, 98%). Analysis by size exclusion chromatography (SEC) confirmed the formation of GNR8 with Mn = 2.4×10⁴ and Mw/Mn = 1.32. The conversion of the other fjord graphene nanoribbons to armchair graphene nanoribbons was performed under the same reaction conditions, thereby obtaining individual GNR8 with Mn (Mw/Mn) = 1.4×10³ (1.31), 8.3×10³ (1.31), 6.8×10⁴ (1.35), and 1.2× 10⁵ (1.34).

GNR2 (Mn = 2.9×10³, Mw/Mn = 1.25) → armchair graphene nanoribbon GNR8 (Mn = 1.4×10³, Mw/Mn = 1.31, yield: 95%):
¹H NMR (600 MHz, Cl₂CDCDCl₂, 120 °C) δ 11.00-6.00(br), 3.00-0.74(br) .

GNR2 (Mn = 1.3×10⁴, Mw/Mn = 1.23) → armchair graphene nanoribbon GNR8 (Mn = 8.3×10³, Mw/Mn = 1.31, yield: 96%):
¹H NMR (600 MHz, Cl₂CDCDCl₂, 120 °C) δ 11.00-6.00(br), 2.60-0.00(br).

GNR2 (Mn = 3.2×10⁴, Mw/Mn = 1.25) → armchair graphene nanoribbon GNR8 (Mn = 2.4×10⁴, Mw/Mn = 1.32, yield: 98%):
¹H NMR (600 MHz, Cl₂CDCDCl₂, 120 °C) δ 11.00-6.00(br), 3.00-0.00(br).

GNR2 (Mn = 9.7×10⁴, Mw/Mn = 1.23) → armchair graphene nanoribbon GNR8 (Mn = 6.8×10⁴, Mw/Mn = 1.35, yield: 95%):
¹H NMR (600 MHz, Cl₂CDCDCl₂, 120 °C) δ 11.00-6.00(br), 2.90-0.00(br).

GNR2 (Mn = 1.5×10⁵, Mw/Mn = 1.22) → armchair graphene nanoribbon GNR8 (Mn = 1.2×10⁵, Mw/Mn = 1.34, yield: 96%):
¹H NMR (600 MHz, Cl₂CDCDCl₂, 120 °C) δ 11.00-6.00(br), 2.10-0.00(br).

The MALDI-TOF mass spectrum of the obtained GNR8 (Mn = 8.3×10³, Mw/Mn = 1.31) was measured by using 7,7,8,8-tetracyanoquinodimethane (TCNQ) as a matrix and AgOCOCF₃ as an additive. Fig. 2 shows the results. The results indicate that the degree of polymerization n was distributed in the range of 20 to 30, with n = 25 being the most dominant distribution. Additionally, no peaks corresponding to shorter oligomers or fragments were observed in the MALDI-TOF mass spectrum (Fig. 2), suggesting that no unexpected impurities were formed.

### Identification of GNR2 and GNR8 with Scanning Tunneling Microscope

The morphology of a graphene nanoribbon prepared on highly oriented pyrolytic graphite (HOPG) was characterized by using a low-temperature STM (Unisoku, USS-10092LSC). The sample substrate was prepared by drop-casting a solution of about 0.01 mg/mL GNR2 (Mn = 1.5×10⁵, Mw/Mn = 1.22) or about 0.0015 mg/mL GNR8 (Mn = 2.4×10⁴, Mw/Mn = 1.32) in 1,2,4-trichlorobenzene onto highly oriented pyrolytic graphite (HOPG), heating the solution at 363 K, and then evaporating 1,2,4-trichlorobenzene at 363 K in air. STM images were captured in constant current mode at 78 K (liquid nitrogen cooling) in ultra-high vacuum. Fig. 3 shows the results.

Due to the high solubility of GNR2 and GNR8, individual molecules and self-assembled structures can be visualized by simply evaporating a solution of GNR in 1,2,4-trichlorobenzene on a solid surface such as highly oriented pyrolytic graphite (HOPG). After GNR2 was deposited on HOPG, and measurements were performed with a scanning tunneling microscope (STM), a pair of wavy wires were observed (Figs. 3a and 3b). Judging from the height (about 0.3 nm) and width (1.7 to 2.2 nm and 3.9 nm) of the single-wave wire and the double-wave wire, these wires seem to be two isolated fjord GNR2s (Fig. 3b), which appear to have flexibility arising from their helical and swaying conformation.

After the Scholl reaction of GNR2, self-assembled armchair GNR8 was also observed by measurement with an STM (Figs. 3c and 3d). The observed substance was formed of repeated peripheral stripes with a thickness of about 0.4 nm, a width of about 3 nm, and a spacing of 0.4 to 0.5 nm (Figs. 3d(i) and 3d (ii)). The presence of this substance seems reasonable as an aggregate of two molecules of GNR8, as shown in Fig. 3e, and the observed periodicity of 0.4 to 0.5 nm is consistent with the longitudinal length between alkyl side chains (Fig. 3c (ii)).

### Example 6: APEX Polymerization by Using Initiator I' - Part 2

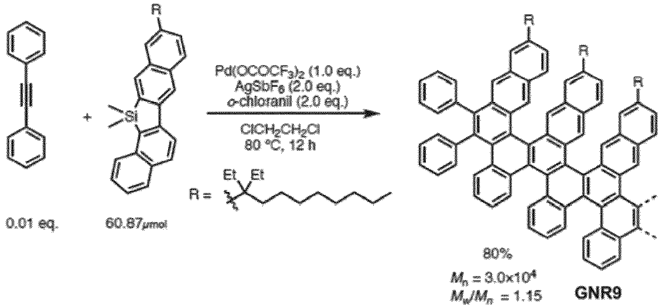

In the formula, Et represents an ethyl group.

A reaction was performed in the same manner as in Example 4, except that 60.87 µmol of monomer M‴ was used instead of monomer M, the I'/M‴ ratio was set to 1:100, and the reaction time was set to 12 hours, thereby obtaining fjord graphene nanoribbon GNR9 with Mn = 3.0×10⁴ and Mw/Mn (PDI) = 1.15 (80%).
¹H NMR (600 MHz, Cl₂CDCDCl₂, 120 °C) δ 11.00-6.00(br), 3.00-0.00(br).

### Example 7: Synthesis of Armchair Graphene Nanoribbon GNR10

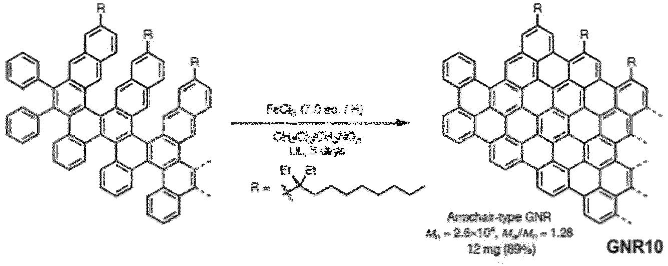

In the formula, Et represents an ethyl group.

A reaction was performed in the same manner as in Example 5, except that fjord graphene nanoribbon GNR9 was used instead of fjord graphene nanoribbon GNR2 and CH₂Cl₂(100 mL) and CH₃NO₂ (20 mL) were used as solvents instead of CH₂Cl₂(120 mL), thereby obtaining armchair graphene nanoribbon GNR10 with Mn = 2.6×10⁴ and Mw/Mn (PDI) = 1.28 (12 mg, 89%).
¹H NMR (600 MHz, Cl₂CDCDCl₂, 120 °C) δ 11.00-6.00(br), 3.00-0.00(br).

### Example 8: One-step Synthesis of Block Fjord Graphene Nanoribbon GNR11

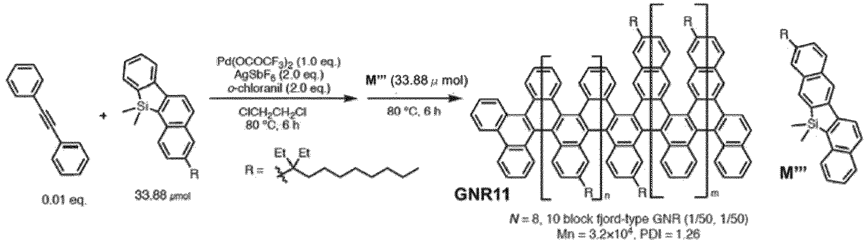

In the formula, Et represents an ethyl group.

A reaction was performed in the same manner as in Example 3, except that initiator I' was used instead of initiator I, 33.88 µmol of monomer M‴ was used instead of monomer M", the I'/M ratio was set to 1:50, and the I'/W‴ ratio was set to 1:50. Purification by gel permeation chromatography (GPC) gave fjord graphene nanoribbon GNR11 as black powder (35.0 mg, 65%). ¹H NMR (600 MHz, Cl₂CDCDCl₂, 120 °C) δ 9.50-8.40(br), 8.40-6 .30 (br), 3 .50-0.00(br) .

### Example 9: Synthesis of Block Armchair Graphene Nanoribbon GNR12

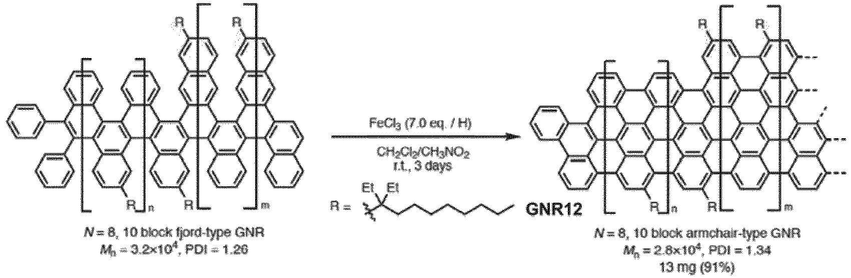

In the formula, Et represents an ethyl group.

A reaction was performed in the same manner as in Example 5, except that block fjord graphene nanoribbon GNR11 was used instead of fjord graphene nanoribbon GNR2, and CH₂Cl₂(100 mL) and CH₃NO₂ (20 mL) were used as solvents instead of CH₂Cl₂(120 mL), thereby obtaining block armchair graphene nanoribbon GNR12 with Mn = 2.8×10⁴ and Mw/Mn (PDI) = 1.34 (13 mg, 91%).
¹H NMR (600 MHz, Cl₂CDCDCl₂, 120 °C) δ 11.00-6.00(br), 3.00-0.00(br).

### Example 10: APEX Polymerization by Using Initiator I"

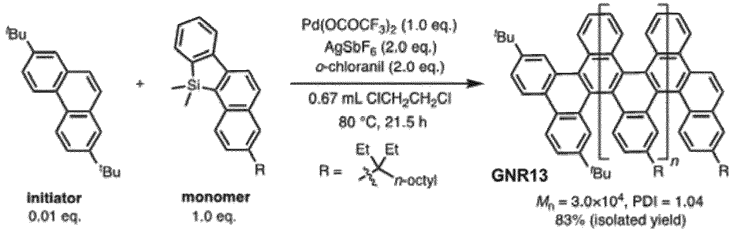

In the formula, Et represents an ethyl group, ^{t}Bu represents a tert-butyl group, and n-octyl represents an n-octyl group.

A reaction was performed in the same manner as in Example 4, except that the following initiator I"

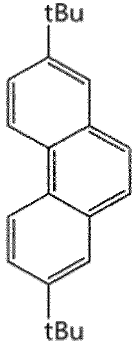

was used, instead of initiator I', and the I"/M ratio was set to 1:100, thereby obtaining fjord graphene nanoribbon GNR13 with Mn = 3.0×10⁴ and Mw/Mn (PDI) = 1.04 (20 mg, 83%).

¹H NMR (600 MHz, Cl₂CDCDCl₂, 120 °C) δ 10.50-8.40(br), 8.40-6.30(br), 2.40-0.00(br) .

### Example 11: APEX Polymerization by Using Initiator I' - Part 3

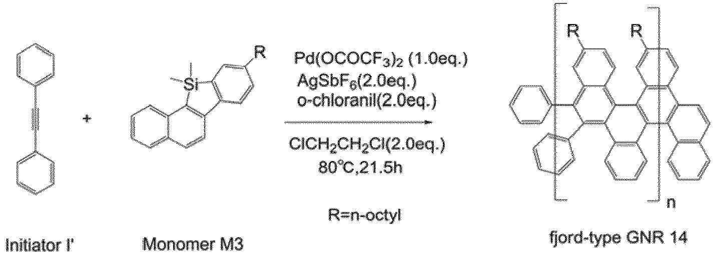

In the formula, n-octyl represents an n-octyl group.

A reaction was performed in the same manner as in Example 4, except that 0.067 mmol (25 mg) of monomer M3 was used instead of monomer M, thereby obtaining a crude product. The obtained crude product was analyzed by size exclusion chromatography (SEC) under the same conditions as those in Example 4, and fjord graphene nanoribbon GNR14 with Mn = 1.9×10⁴ and Mw/Mn (PDI) = 2.07 was confirmed to have been obtained.

### Example 12: APEX Polymerization by Using Initiator I' - Part 4

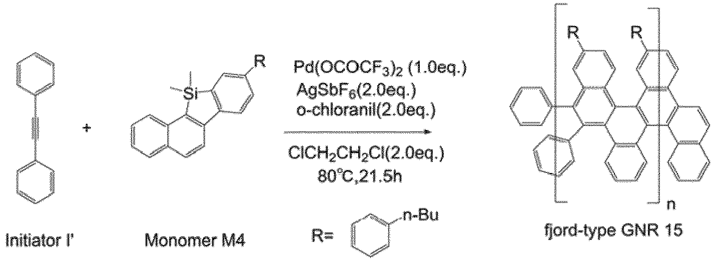

In the formula, n-Bu represents an n-butyl group.

A reaction was performed in the same manner as in Example 4, except that 0.067 mmol (26 mg) of monomer M4 was used instead of monomer M, thereby obtaining a crude product. The obtained crude product was analyzed by size exclusion chromatography (SEC) under the same conditions as those in Example 4, and fjord graphene nanoribbon GNR15 with Mn = 1.5×10⁴ and Mw/Mn (PDI) = 1.78 was confirmed to have been obtained.

### Examples 13 to 24: APEX Polymerization by Using Various Initiators

A reaction was performed in the same manner as in Example 4, except that 6.78 µmol (0.01 equivalents) of each initiator shown in Tables 1 and 2 was used instead of initiator I', thereby obtaining a crude product. The obtained crude products were analyzed by size exclusion chromatography (SEC) under the same conditions as those in Example 4, and Mn and Mw/Mn (PDI) of the obtained GNRs were confirmed. Tables 1 and 2 show Mn and Mw/Mn (PDI).

In Tables 1 and 2, R represents the following.

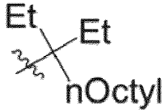

In the formula, Et represents an ethyl group, and nOctyl represents an n-octyl group.

In Table 1, OMe represents a methoxy group, CO₂Me represents a methoxy carbonyl group, and Bpin represents a pinacolatoboryl group. In Table 2, tBu represents a tert-butyl group.

**Table 1**

| | Initiator | Monomer | Mn | Mw/Mn (PDI) |
|---|---|---|---|---|
| Example 13 | 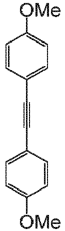 | 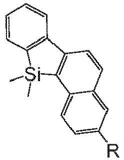 | 4.7×10⁴ | 1.01 |
| Example 14 | 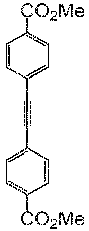 | 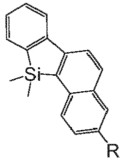 | 6.3×10⁴ | 1.01 |
| Example 15 | 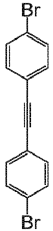 | 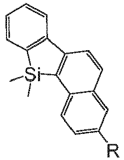 | 4.8×10⁴ | 1.02 |
| Example 16 | 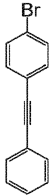 | 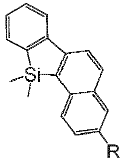 | 4.6×10⁴ | 1.01 |
| Example 17 | 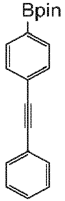 | 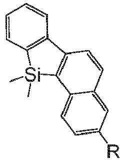 | 4.7×10⁴ | 1.02 |

**Table 2**

| | Initiator | Monomer | Mn | Mw/Mn (PDI) |
|---|---|---|---|---|
| Example 18 | 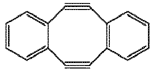 | 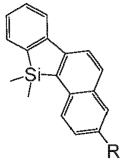 | 4.6×10⁴ | 1.01 |
| Example 19 | 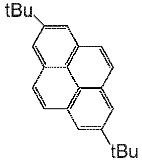 | 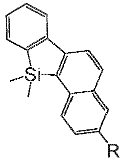 | 6.4×10⁴ | 1.01 |
| Example 20 | 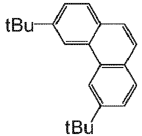 | 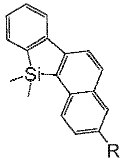 | 5.4×10⁴ | 1.01 |
| Example 21 | 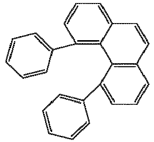 | 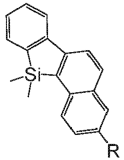 | 4.8×10⁴ | 1.01 |
| Example 22 | 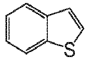 | 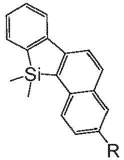 | 3.1×10⁴ | 1.01 |
| Example 23 | 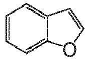 | 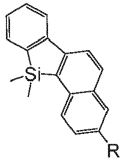 | 3.2×10⁴ | 1.03 |
| Example 24 | 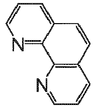 | 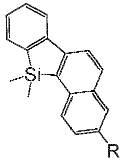 | 4.7×10⁴ | 1.01 |

### Example 25: APEX Polymerization by Using Initiator I‴

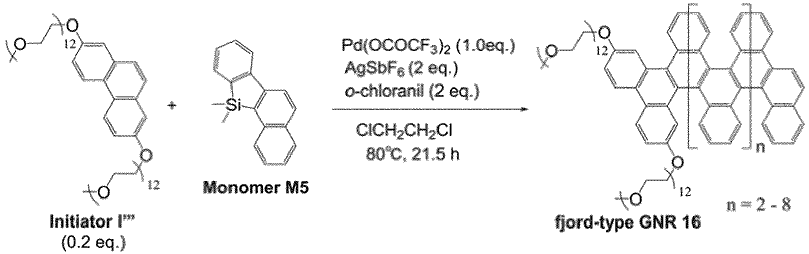

In a nitrogen atmosphere, 2,7-bis ((2,5,8,11,14,17,20,23,26,29,32,35-dodecaoxaheptatriacontan-37-yl)oxy)phenanthrene (initiator I‴, 34.3 mg, 26.5 µmol, 0.20 equivalents), benzonaphthosilole (monomer M5, 34.5 mg, 132 µmol, 1.00 equivalent), Pd(OCOCF₃)₂ (44. 0 mg, 132 µmol, 1.00 equivalent), AgSbF₆ (91.0 mg, 265 µmol, 2.00 equivalents), and o-chloranil (65.1 mg, 265 µmol, 2.00 equivalents) were added to a 5-mL test tube containing a magnetic stirrer. 1,2-Dichloroethane (1.3 mL) was then added to this reaction mixture. After the mixture was stirred at 80 °C for 21.5 hours, the reaction mixture was cooled to room temperature and passed through a short pad of silica gel, followed by passing the mixture through a metal scavenger while washing it with CH₂Cl₂. The solvent was removed under reduced pressure, thereby obtaining a crude product. Purification was performed by gel permeation chromatography (GPC), thereby obtaining GNR16, which is fjord graphene nanoribbon, as black powder. From the MALDI-TOF mass spectrum of the product, the degree of polymerization of the obtained GNR16 was confirmed to range from 3 to 9 (n = 2 to 8).

### Example 26: APEX Polymerization by Using Initiator I - Part 2

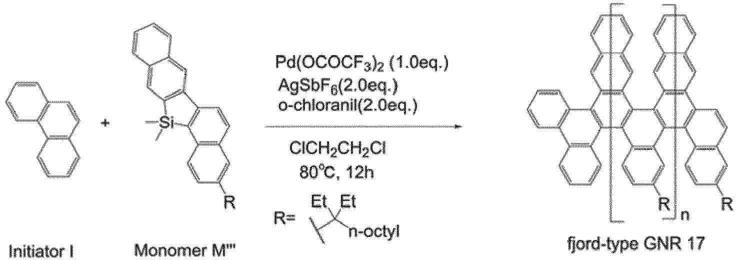

A reaction was performed in the same manner as in Example 1, except that instead of monomer M, 60 µmol of monomer M‴ (30.0 mg, 1.00 equivalent), 0.6 µmol of an initiator I (0.10 mg 0.01 equivalents), 60.8 µmol of Pd(OCOCF₃)₂ (20.2 mg, 1.00 equivalent), 120 µmol of AgSbF₆ (20.9 mg, 2.00 equivalents), 60.8 µmol of o-chloranil (14.9 mg, 2.00 equivalents), and 0.60 mL of 1,2-dichloroethane were used, thereby obtaining a crude product. The obtained crude product was analyzed by size exclusion chromatography (SEC) under the same conditions as those in Example 1, and it was confirmed that Mn = 3.8×10⁴ and Mw/Mn (PDI) = 1.28. Purification was performed by gel permeation chromatography (GPC) under the same conditions as those in Example 1, thereby obtaining GNR17, which is fjord graphene nanoribbon, as black powder (30.0 mg, 72%).
¹H NMR (600 MHz, Cl₂CDCDCl₂, 120 °C) δ 11.00-8.40(br), 8.40-6.20(br), 3.20-0.00(br).

### Example 27: Synthesis of Armchair Graphene Nanoribbon GNR18

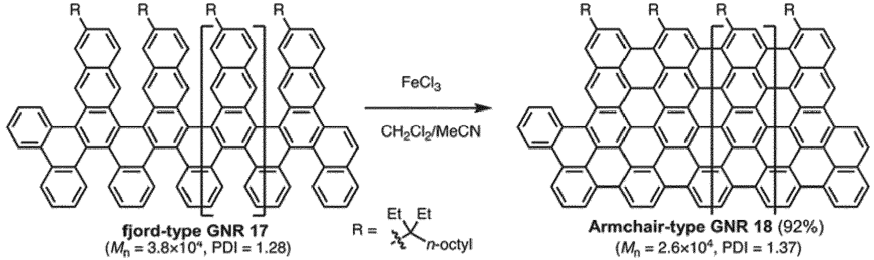

In the formula, Et represents an ethyl group, and noctyl represents an n-octyl group.

A reaction was performed in the same manner as in Example 5, except that fjord graphene nanoribbon GNR17 was used instead of fjord graphene nanoribbon GNR2, and 100 mL of CH₂Cl₂ was used as a solvent, thereby obtaining armchair graphene nanoribbon GNR18 with Mn = 2.6×10⁴ and Mw/Mn (PDI) = 1.37 as dark red powder (28.5 mg, 92%).
¹H NMR (600 MHz, Cl₂CDCDCl₂, 120 °C) δ 11.00-7.00(br), 3.00-0.00(br).

### Example 28: One-step Synthesis of Block Fjord Graphene Nanoribbon GNR19

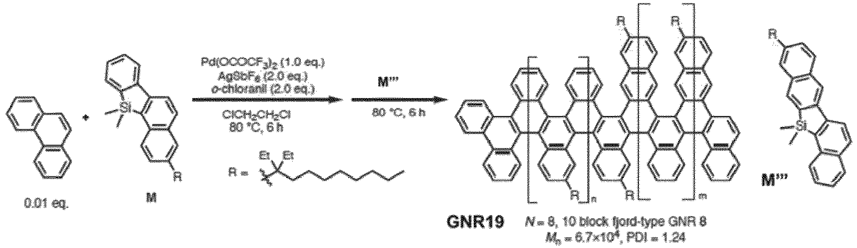

In the formula, Et represents an ethyl group.

In a nitrogen atmosphere, initiator I (0.12 mg, 0.67 µmol, 1.00 equivalent), monomer M (33.4 mg, 67.8 µmol, 100 equivalents), Pd(OCOCF₃)₂ (45.0 mg, 135 µmol, 200 equivalents),

AgSbF₆ (46.6 mg, 270 µmol, 400 equivalents), o-chloranil (33 mg, 270 µmol, 400 equivalents), and 1,2-dichloroethane (0.6 mL) were added to a 5-mL Schlenk tube containing a magnetic stirrer. The subsequent reaction was performed in the same manner as in Example 3, except that a solution of monomer M‴ (30 mg, 67.8 µmol, 100 equivalents) in 1,2-dichloroethane (0.2 mL) was used instead of the solution of monomer M" (48 mg, 113 µmol, 100 equivalents) in 1,2-dichloroethane (0.5 mL). Analysis by size exclusion chromatography (SEC) found that block fjord graphene nanoribbon GNR19 with Mn = 6.7×10⁴ and Mw/Mn (PDI) = 1.24 was obtained (46 mg, 70%).

¹H NMR (600 MHz, Cl₂CDCDCl₂, 120 °C) δ 9.50-8.40(br), 8.40-6.30(br), 5.00-3.00(br), 2.40-0.00(br).

### Example 29: Synthesis of Armchair Graphene Nanoribbon GNR20

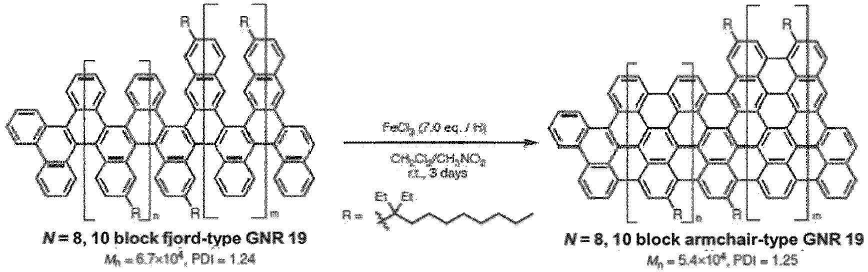

In the formula, Et represents an ethyl group.

In a nitrogen atmosphere, fjord graphene nanoribbon GNR19 (20 mg, 20 µmol, Mn = 6.7×10⁴, and Mw/Mn = 1.24) and CH₂Cl₂ (100 mL) were added to a 200-mL two-necked round-bottom flask containing a magnetic stirrer. A suspension of iron(III) chloride (1.55 g, 9.8 mmol, 7 equivalents based on the estimated hydrogen atoms over the fjord region by Mn) and nitromethane (10 mL) were added to this solution. After the mixture was stirred at room temperature for 72 hours, methanol was added to quench the reaction, thereby obtaining dark red precipitates. After suction filtration, the precipitates were washed with methanol, thereby obtaining armchair graphene nanoribbon GNR20 (9 mg, 70%) as dark red powder. From the analysis by size exclusion chromatography (SEC), the formation of GNR20 with Mn = 5.4×10⁴ and Mw/Mn = 1.24 was confirmed.
¹H NMR (600 MHz, Cl₂CDCDCl₂, 120 °C) δ 11.00-7.00(br), 8.40-6.20(br), 3.20-0.00(br).

## Claims

1. A graphene nanoribbon having at least one structural unit represented by formula (1): 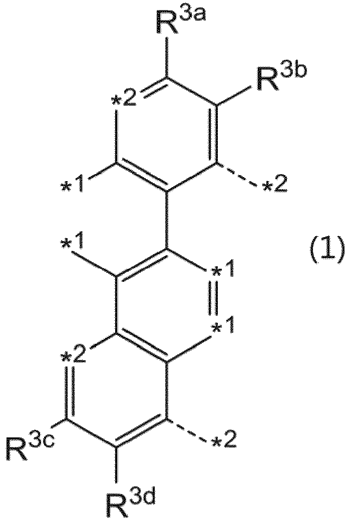 wherein the dotted lines are the same or different and each represents no bond or a single bond; *1 represents a bonding point; *2 represents a bonding point when the dotted line bonded to *2 is a single bond; R^{3a}, R^{3b}, R^{3c}, and R^{3d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{3a} and R^{3b} and/or R^{3c} and R^{3d} are optionally bonded together to form a ring.

2. The graphene nanoribbon according to claim 1, having at least one structural unit represented by formula (3): 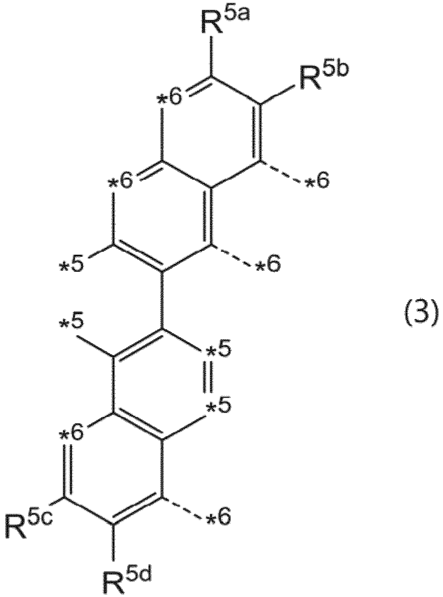 wherein the dotted lines are the same or different and each represents no bond or a single bond; *5 represents a bonding point; *6 represents a bonding point when the dotted line bonded to *6 is a single bond; R^{5a}, R^{5b}, R^{5c}, and R^{5d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{5a} and R^{5b} and/or R^{5c} and R^{5d} are optionally bonded together to form a ring.

3. The graphene nanoribbon according to claim 1 or 2, further having at least one structural unit represented by formula (2): 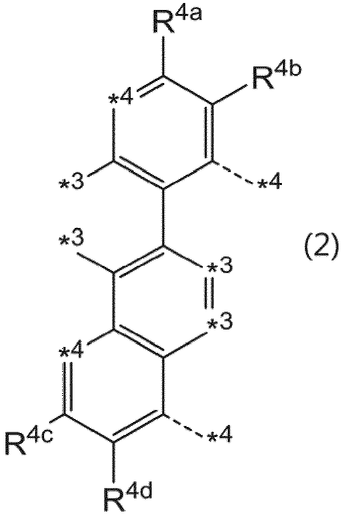 wherein the dotted lines are the same or different and each represents no bond or a single bond; *3 represents a bonding point; *4 represents a bonding point when the dotted line bonded to *4 is a single bond; R^{4a}, R^{4b}, R^{4c}, and R^{4d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{4a} and R^{4b} and/or R^{4c} and R^{4d} are optionally bonded together to form a ring; provided that R^{4a} and R^{3a} are not the same, R^{4b} and R^{3b} are not the same, R^{4c} and R^{3c} are not the same, and R^{4d} and R^{3d} are not the same.

4. The graphene nanoribbon according to any one of claims 1 to 3, further having at least one of the following structural units:
a structural unit represented by formula (11): 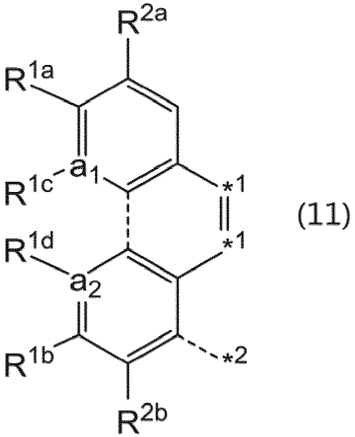 wherein the dotted lines are as defined above; *1 represents a bonding point; *2 represents a bonding point when the dotted line bonded to *2 is a single bond; R^{1a}, R^{1b}, R^{1c}, R^{1d}, R^{2a}, and R^{2b} are the same or different and each represents a hydrogen atom, a halogen atom, an alkyl group, a cycloalkyl group, a (poly)ether group, an ester group, a boronic acid or an ester group thereof, a monovalent aromatic hydrocarbon group, or a monovalent heterocyclic group; a₁ and a₂ are the same or different and each represents a carbon atom or a nitrogen atom; and R^{1c} and R^{1d} are optionally bonded together to form a ring;
a structural unit represented by formula (12): 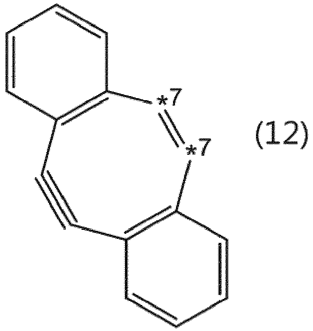 wherein *7 represents a bonding point; and
a structural unit represented by formula (13): 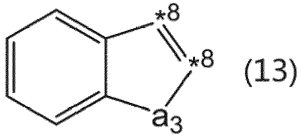 wherein *8 represents a bonding point, and a₃ represents an oxygen atom or a sulfur atom.

5. The graphene nanoribbon according to claim 4, which is represented by formula (4): 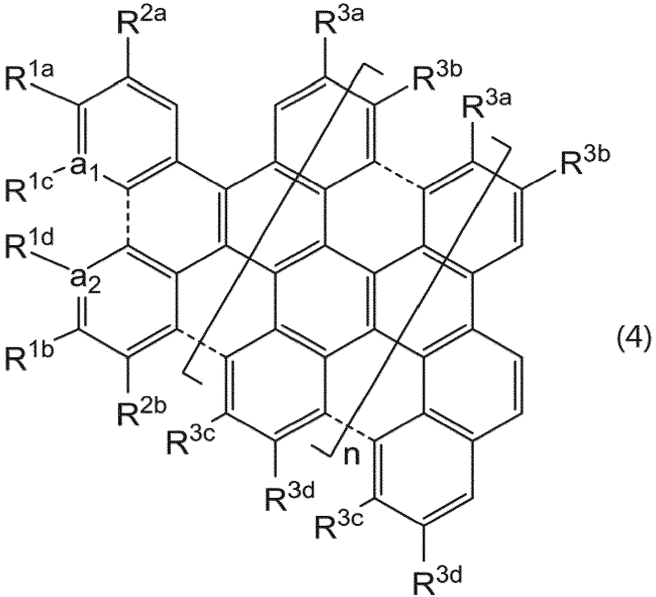 wherein the dotted lines, R^{1a}, R^{1b}, R^{1c}, R^{1d}, R^{2a}, R^{2b}, R^{3a}, R^{3b}, R^{3c}, R^{3d}, a₁, and a₂ are as defined above; R^{3a} and R^{3b} bonded to the same benzene ring are optionally bonded together to form a ring; R^{3c} and R^{3d} bonded to the same benzene ring are optionally bonded together to form a ring; and n represents an integer of 0 or more;
formula (14): 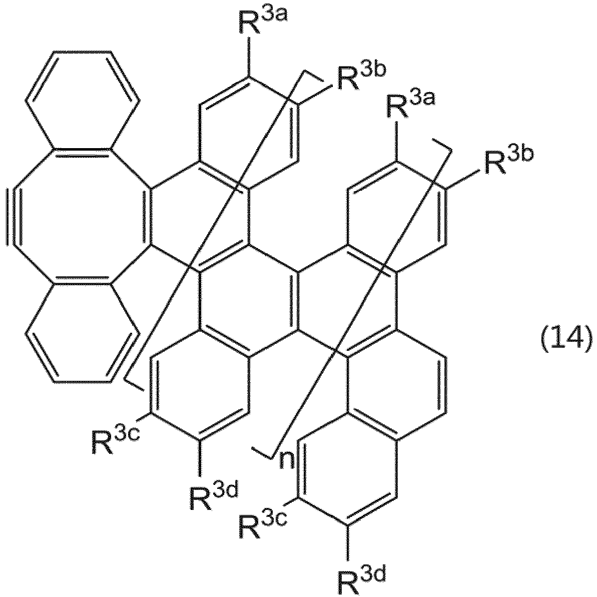 wherein R^{3a}, R^{3b}, R^{3c}, R^{3d}, and n are as defined above; R^{3a} and R^{3b} bonded to the same benzene ring are optionally bonded together to form a ring; and R^{3c} and R^{3d} bonded to the same benzene ring are optionally bonded together to form a ring; or
formula (15): 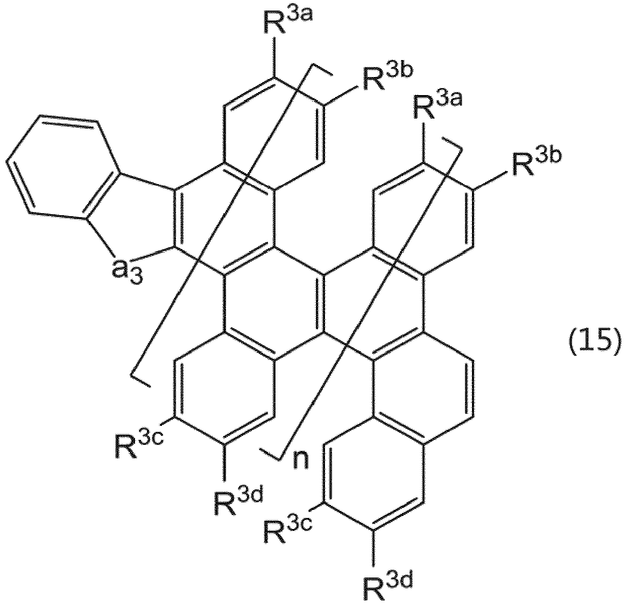 wherein R^{3a}, R^{3b}, R^{3c}, R^{3d}, n, and a₃ are as defined above; R^{3a} and R^{3b} bonded to the same benzene ring are optionally bonded together to form a ring; and R^{3c} and R^{3d} bonded to the same benzene ring are optionally bonded together to form a ring.

6. The graphene nanoribbon according to claim 4 or 5, which is represented by formula (4A): 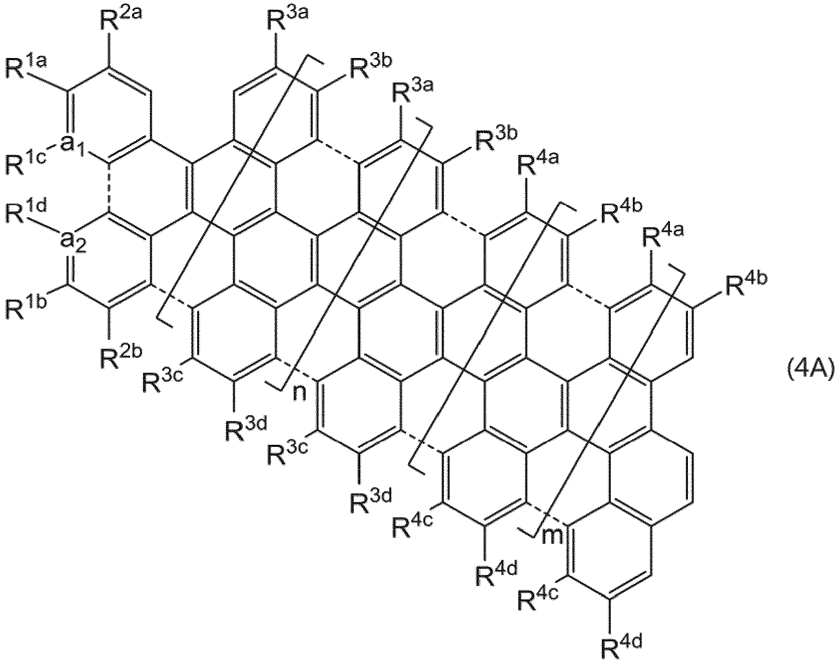 wherein the dotted lines, R^{1a}, R^{1b}, R^{1c}, R^{1d}, R^{2a}, R^{2b}, R^{3a}, R^{3b}, R^{3c}, R^{3d}, a₁, and a₂ are as defined above; R^{4a}, R^{4b,} R^{4c}, and R^{4d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; R^{3a} and R^{3b} bonded to the same benzene ring are optionally bonded together to form a ring; R^{3c} and R^{3d} bonded to the same benzene ring are optionally bonded together to form a ring; R^{4a} and R^{4b} bonded to the same benzene ring are optionally bonded together to form a ring; R^{4c} and R^{4d} bonded to the same benzene ring are optionally bonded together to form a ring; provided that R^{4a} and R^{3a} are not the same, R^{4b} and R^{3b} are not the same, R^{4c} and R^{3c} are not the same, and R^{4d} and R^{3d} are not the same; and n and m are the same or different and each represents an integer of 0 or more;
formula (14A): 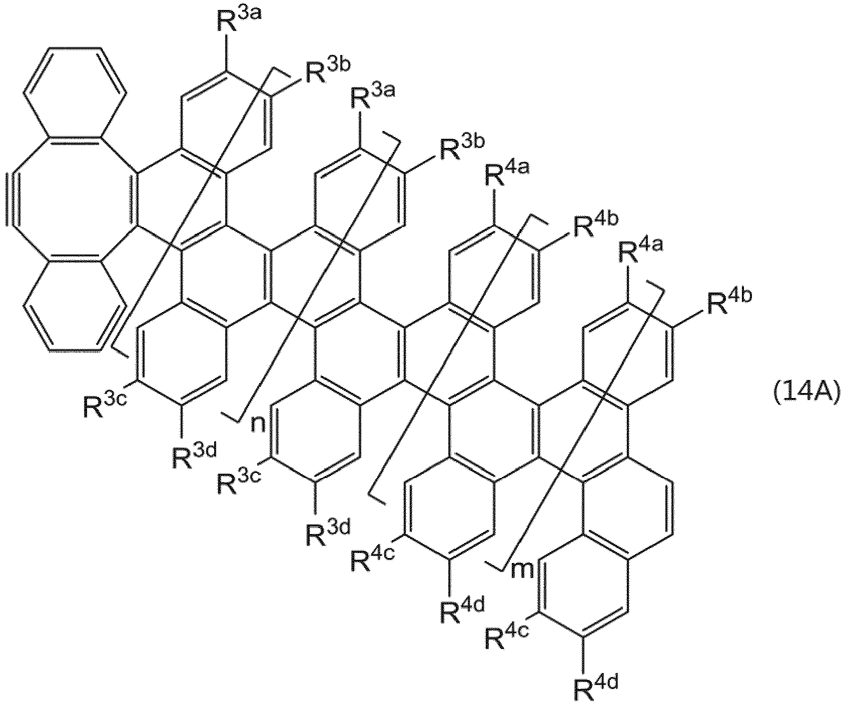 wherein R^{3a}, R^{3b}, R^{3c}, R^{3d}, R^{4a}, R^{4b}, R^{4c}, R^{4d}, n, and m are as defined above; R^{3a} and R^{3b} bonded to the same benzene ring are optionally bonded together to form a ring; R^{3c} and R^{3d} bonded to the same benzene ring are optionally bonded together to form a ring; R^{4a} and R^{4b} bonded to the same benzene ring are optionally bonded together to form a ring; and R^{4c} and R^{4d} bonded to the same benzene ring are optionally bonded together to form a ring; or
formula (15A): 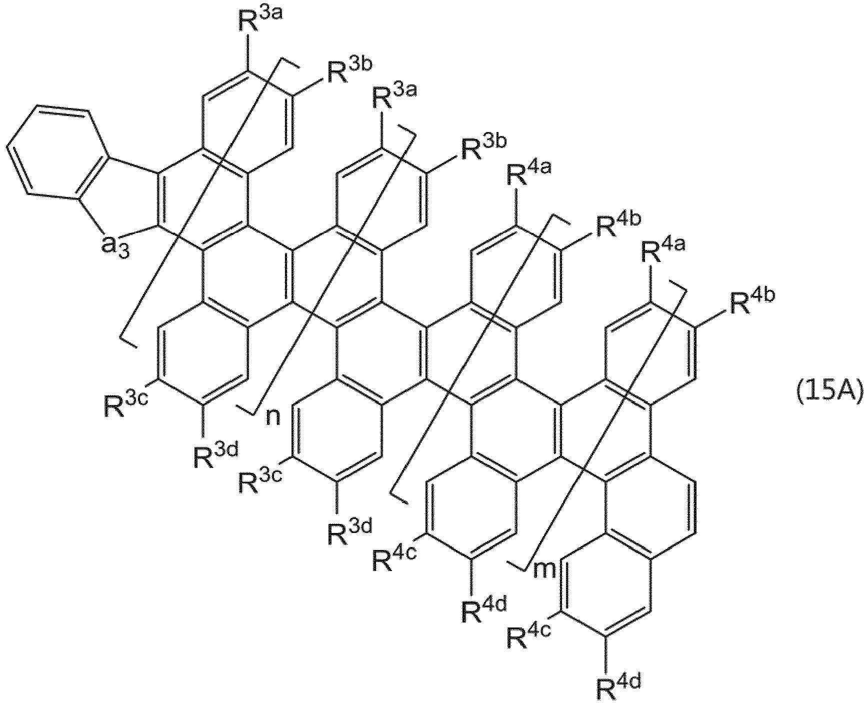 wherein R^{3a}, R^{3b}, R^{3c}, R^{3d}, R^{4a}, R^{4b}, R^{4c}, R^{4d}, n, m, and a₃ are as defined above; R^{3a} and R^{3b} bonded to the same benzene ring are optionally bonded together to form a ring; R^{3c} and R^{3d} bonded to the same benzene ring are optionally bonded together to form a ring; R^{4a} and R^{4b} bonded to the same benzene ring are optionally bonded together to form a ring; and R^{4c} and R^{4d} bonded to the same benzene ring are optionally bonded together to form a ring.

7. The graphene nanoribbon according to any one of claims 4 to 6, which is represented by formula (4A1): 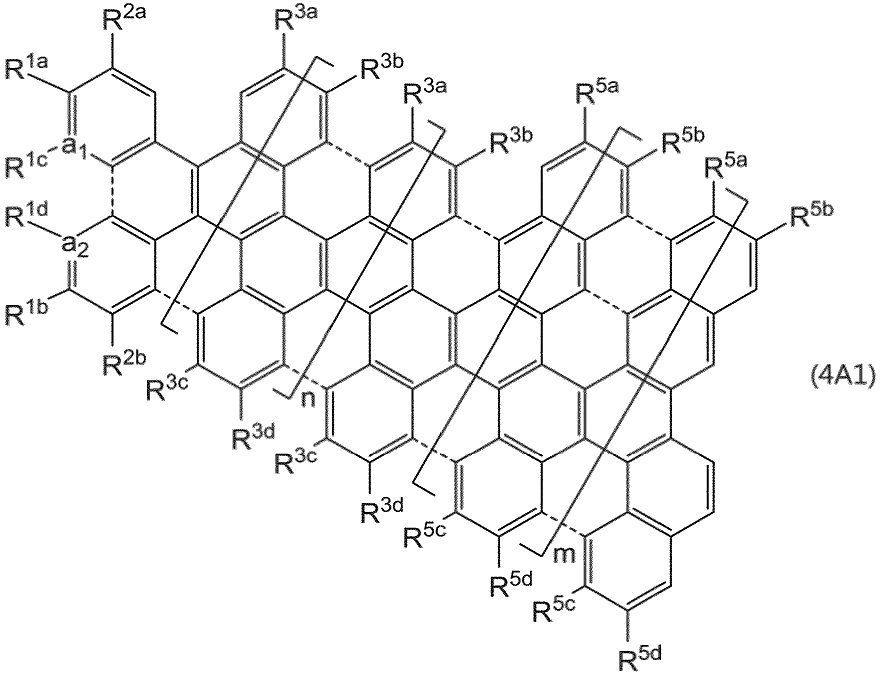 wherein the dotted lines, R^{1a}, R^{1b}, R^{1c}, R^{1d}, R^{2a}, R^{2b}, R^{3a}, R^{3b}, R^{3c}, R^{3d}, a_{1,} and a₂ are as defined above; R^{5a}, R^{5b}, R^{5c}, and R^{5d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; R^{3a} and R^{3b} bonded to the same benzene ring are optionally bonded together to form a ring; R^{3c} and R^{3d} bonded to the same benzene ring are optionally bonded together to form a ring; R^{5a} and R^{5b} bonded to the same benzene ring are optionally bonded together to form a ring; R^{5c} and R^{5d} bonded to the same benzene ring are optionally bonded together to form a ring; and n and m are the same or different and each represents an integer of 0 or more;
formula (14A1): 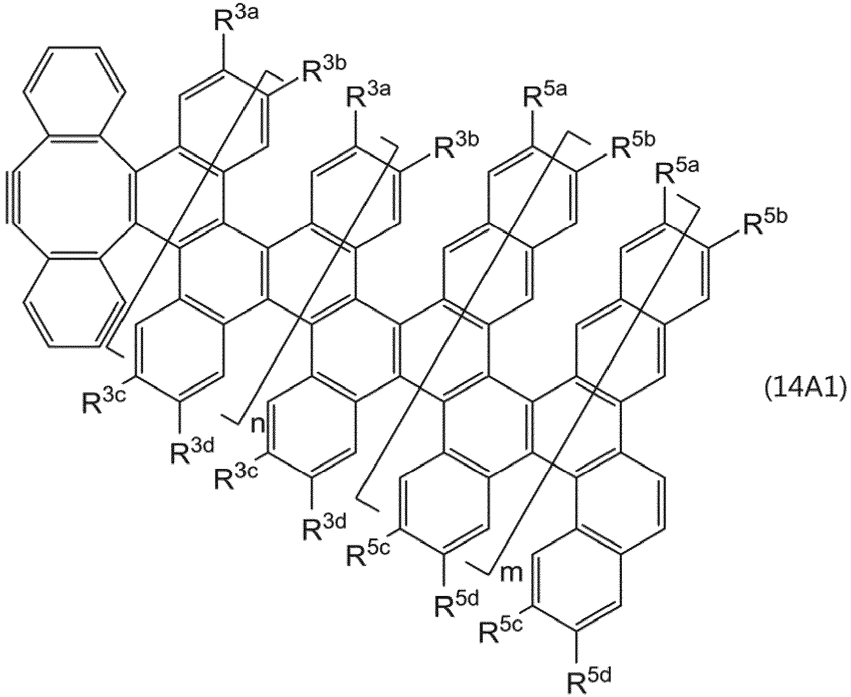 wherein R^{3a}, R^{3b}, R^{3c}, R^{3d}, R^{5a}, R^{5b}, R^{5c}, R^{5d}, n, and m are as defined above; R^{3a} and R^{3b} bonded to the same benzene ring are optionally bonded together to form a ring; R^{3c} and R^{3d} bonded to the same benzene ring are optionally bonded together to form a ring; R^{5a} and R^{5b} bonded to the same benzene ring are optionally bonded together to form a ring; and R^{5c} and R^{5d} bonded to the same benzene ring are optionally bonded together to form a ring; or
formula (15A1): 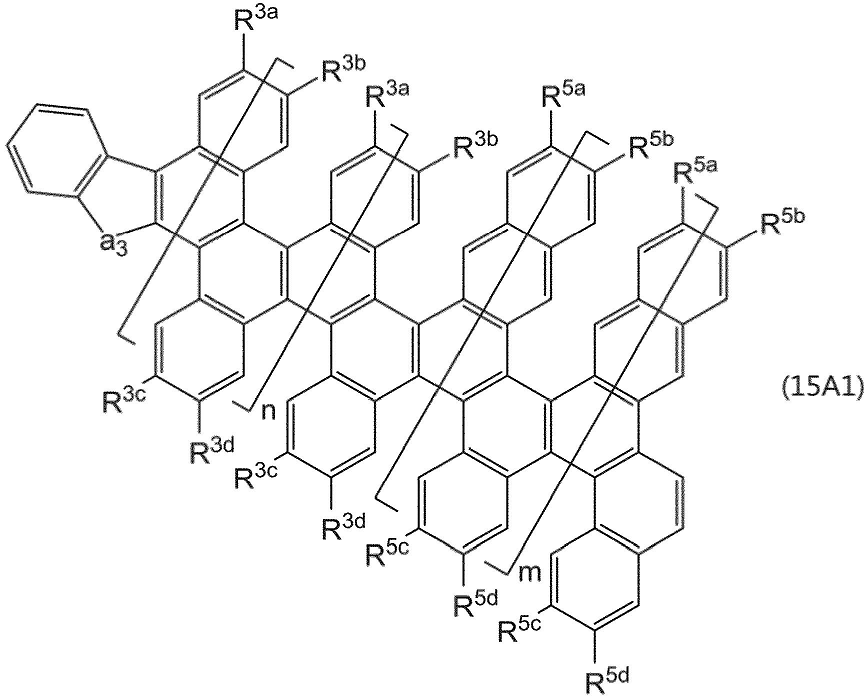 wherein R^{3a}, R^{3b}, R^{3c}, R^{3d}, R^{5a}, R^{5b}, R^{5c}, R^{5d}, n, m, and a₃ are as defined above; R^{3a} and R^{3b} bonded to the same benzene ring are optionally bonded together to form a ring; R^{3c} and R^{3d} bonded to the same benzene ring are optionally bonded together to form a ring; R^{5a} and R^{5b} bonded to the same benzene ring are optionally bonded together to form a ring; and R^{5c} and R^{5d} bonded to the same benzene ring are optionally bonded together to form a ring.

8. The graphene nanoribbon according to any one of claims 1 to 7, which has a number average molecular weight of 10000 or more.

9. The graphene nanoribbon according to any one of claims 1 to 8, which has a polydispersity PDI of 1.00 to 1.40.

10. The graphene nanoribbon according to any one of claims 1 to 9, which has a width of 0.1 to 2.0 nm and a length of 10 nm or more.

11. A method for producing the graphene nanoribbon according to any one of claims 1 to 10, the method comprising:
(1) a first polymerization step of reacting, in the presence of a palladium compound and o-chloranil, an alkyne compound represented by formula (5A): 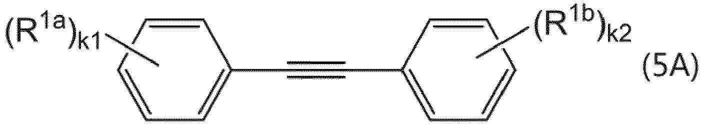
wherein R^{1a} and R^{1b} are the same or different and each represents a hydrogen atom, a halogen atom, an alkyl group, a cycloalkyl group, a (poly)ether group, an ester group, a boronic acid or an ester group thereof, a monovalent aromatic hydrocarbon group, or a monovalent heterocyclic group; k1 and k2 are the same or different and each represents an integer of 1 to 3; when k1 and k2 are an integer of 2 or more, each R^{1a} and/or R^{1b} is optionally the same or different;
a K region-containing aromatic compound represented by formula (5B) : 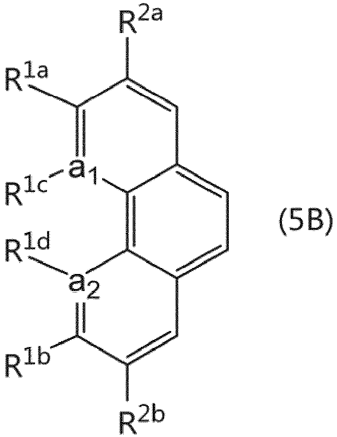
wherein R^{1a}, R^{1b}, R^{1c}, R^{1d}, R^{2a}, and R^{2b} are the same or different and each represents a hydrogen atom, a halogen atom, an alkyl group, a cycloalkyl group, a (poly)ether group, an ester group, a boronic acid or an ester group thereof, a monovalent aromatic hydrocarbon group, or a monovalent heterocyclic group; and a₁ and a₂ are the same or different and each represents a carbon atom or a nitrogen atom;
dibenzocyclooctadiyne, benzothiophene, or benzofuran, and a silole compound represented by formula (6): 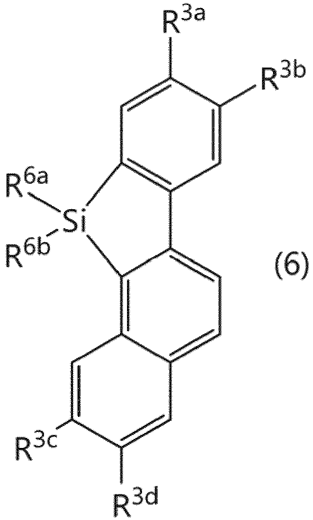
wherein R^{3a}, R^{3b}, R^{3c}, and R^{3d} are as defined above; and R^{6a} and R^{6b} are the same or different and each represents a hydrogen atom or an alkyl group.

12. The production method according to claim 11, further comprising, after the first polymerization step:
(2) a second polymerization step of reacting, in the presence of a palladium compound and o-chloranil, a K region-containing polymer obtained in step (1) and a silole compound represented by formula (7): 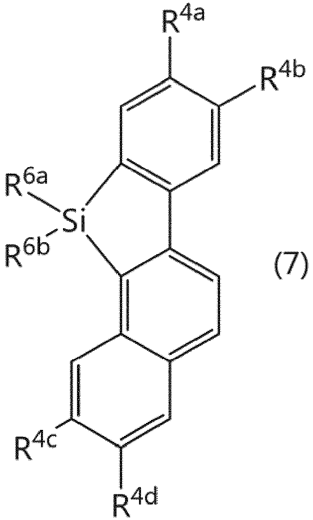 wherein R^{6a} and R^{6b} are as defined above; R^{4a}, R^{4b}, R^{4c}, and R^{4d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{4a} and R^{4b} and/or R^{4c} and R^{4d} are optionally bonded together to form a ring; provided that R^{4a} and R^{3a} are not the same, R^{4b} and R^{3b} are not the same, R^{4c} and R^{3c} are not the same, and R^{4d} and R^{3d} are not the same.

13. The production method according to claim 12, wherein the silole compound represented by formula (7) is a silole compound represented by formula (7A): 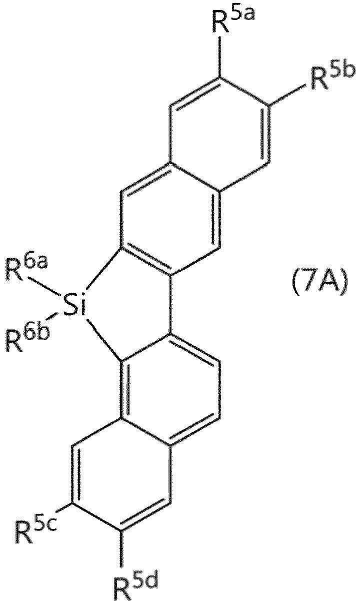 wherein R^{6a} and R^{6b} are as defined above; R^{5a}, R^{5b}, R^{5c}, and R^{5d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{5a} and R^{5b} and/or R^{5c} and R^{5d} are optionally bonded together to form a ring.

14. The production method according to any one of claims 11 to 13, wherein the compound to be reacted with the silole compound is used in an amount of 0.0005 to 0.5 mol per mol of the silole compound.

15. The production method according to any one of claims 11 to 14, wherein the first polymerization step or the second polymerization step is performed in the presence of a silver compound.

16. The production method according to claim 15, wherein the silver compound contains AgSbF₆ or AgBF₄.

17. The production method according to claim 15 or 16, wherein the silver compound is used in an amount of 0.5 to 5.0 mol per mol of the silole compound.

18. The production method according to any one of claims 11 to 17, wherein the palladium compound is used in an amount of 0.1 to 3.0 mol per mol of the silole compound.

19. A silole compound represented by formula (6): 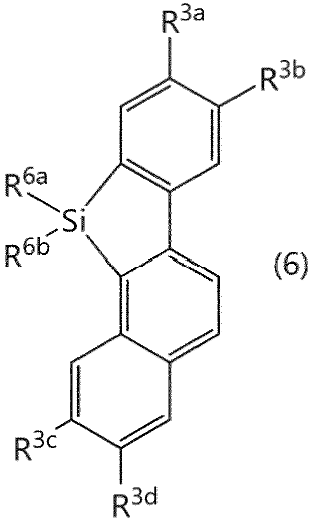 wherein R^{3a}, R^{3b}, R^{3c}, and R^{3d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; provided that not all of R^{3a}, R^{3b}, R^{3c}, and R^{3d} are hydrogen atoms; R^{3a} and R^{3b} and/or R^{3c} and R^{3d} are optionally bonded together to form a ring; and R^{6a} and R^{6b} are the same or different and each represents a hydrogen atom or an alkyl group.

20. A method for producing the silole compound according to claim 19, the method comprising reacting a halogen-containing silole compound represented by formula (8): 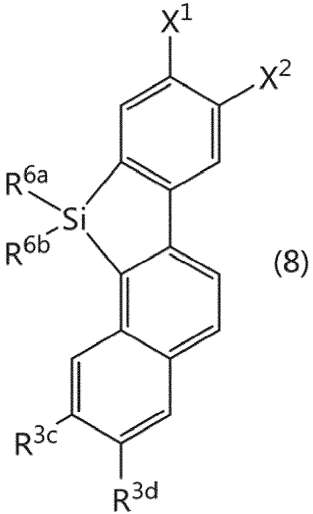 wherein R^{3c}, R^{3d}, R^{6a}, and R^{6b} are as defined above; X¹ and X² are the same or different and each represents a hydrogen atom or a halogen atom; and X¹ and X² are optionally bonded together to form a ring containing a halogen atom; provided that not both of X¹ and X² are hydrogen atoms; and
a Grignard reagent represented by formula (9):
R⁷MgX³ (9)
wherein R⁷ represents an alkyl group, and X³ represents a halogen atom; or
a boronic acid compound represented by formula (10): 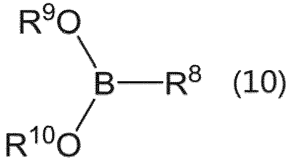 wherein R⁸ represents a monovalent aromatic hydrocarbon group; R⁹ and R¹⁰ are the same or different and each represents a hydrogen atom or an alkyl group; and R⁹ and R¹⁰ are optionally bonded together to form a ring together with the adjacent -O-B-O-.

21. A halogen-containing silole compound represented by formula (8): 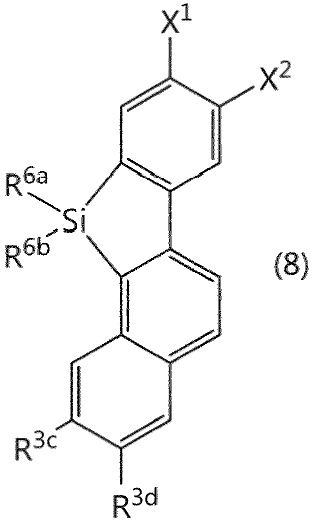 wherein R^{3c} and R^{3d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; R^{3c} and R^{3d} are optionally bonded together to form a ring; R^{6a} and R^{6b} are the same or different and each represents a hydrogen atom or an alkyl group; X¹ and X² are the same or different and each represents a hydrogen atom or a halogen atom; and X¹ and X² are optionally bonded to form a ring containing a halogen atom; provided that not both of X¹ and X² are hydrogen atoms.

22. A method for producing an armchair graphene nanoribbon having at least one structural unit represented by formula (1-1): 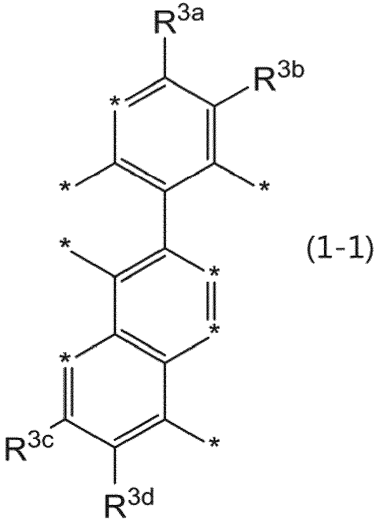 wherein * represents a bonding point; R^{3a}, R^{3b}, R^{3c}, and R^{3d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; and R^{3a} and R^{3b} and/or R^{3c} and R^{3d} are optionally bonded together to form a ring;
the method comprising performing a ring condensation reaction, in the presence of an iron compound, on a fjord graphene nanoribbon having at least one structural unit represented by formula (1-2): 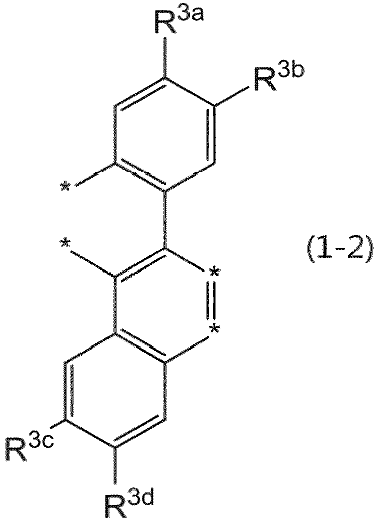 wherein * represents a bonding point, and R^{3a}, R^{3b}, R^{3c}, and R^{3d} are as defined above.

23. A method for producing an armchair graphene nanoribbon represented by formula (4-1): 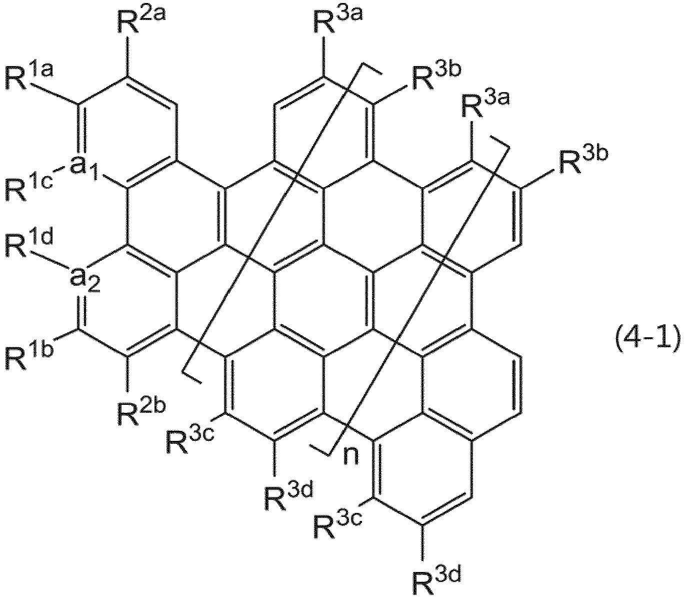 wherein R^{1a}, R^{1b}, R^{1c}, R^{1d}, R^{2a}, and R^{2b} are the same or different and each represents a hydrogen atom, a halogen atom, an alkyl group, a cycloalkyl group, a (poly)ether group, an ester group, a boronic acid or an ester group thereof, a monovalent aromatic hydrocarbon group, or a monovalent heterocyclic group; a₁ and a₂ are the same or different and each represents a carbon atom or a nitrogen atom; R^{1c} and R^{1d} are optionally bonded together to form a ring; R^{3a}, R^{3b}, R^{3c}, and R^{3d} are the same or different and each represents a hydrogen atom, a halogen atom, an alkyl group, a cycloalkyl group, a (poly)ether group, an ester group, a monovalent aromatic hydrocarbon group, or a monovalent heterocyclic group; R^{3a} and R^{3b} bonded to the same benzene ring are optionally bonded together to form a ring; R^{3c} and R^{3d} bonded to the same benzene ring are optionally bonded together to form a ring; and n represents an integer of 0 or more;
the method comprising performing a ring condensation reaction, in the presence of an iron compound, on a fjord graphene nanoribbon represented by formula (4-2): 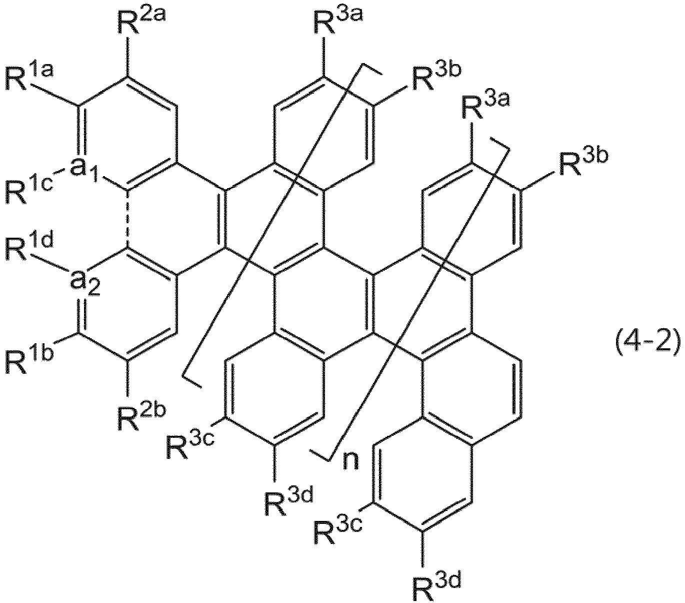 wherein the dotted lines are the same or different and each represents no bond or a single bond; R^{1a}, R^{1b}, R^{1c}, R^{1d}, R^{2a}, R^{2b}, R^{3a}, R^{3b}, R^{3c}, R^{3d}, a_{1,} a₂, and n are as defined above; R^{3a} and R^{3b} bonded to the same benzene ring are optionally bonded together to form a ring; and R^{3c} and R^{3d} bonded to the same benzene ring are optionally bonded together to form a ring.
